# EUROPEAN PATENT APPLICATION

(11) **EP 1 394 862 A2**
(43) Date of publication of application: **03.03.2004**
(21) Application number: 03025818.0
(22) Date of filing: 03.11.1995
(51) Int. Cl.: H01L 31/0224

(54) **Photovoltaic element and method for producing the same**

(30) Priority: 04.11.1994 JP 29588794; 27.12.1994 JP 32488094; 09.10.1995 JP 26115295
(62) Divisional of application: 95117326.9
(71) Applicant: CANON KABUSHIKI KAISHA, Tokyo (JP)
(72) Inventor: Ichinose, Hirofumi, Ohta-ku, Tokyo (JP); Hasebe, Akio, Ohta-ku, Tokyo (JP); Murakami, Tsutomu, Ohta-ku, Tokyo (JP); Shinkura, Satoshi, Ohta-ku, Tokyo (JP); Ueno, Yukie, Ohta-ku, Tokyo (JP)
(74) Representative: Leson, Thomas Johannes Alois, Dipl.-Ing.

(57) **Abstract**

A photovoltaic element having a high release voltage is provided by inhibiting the injection of carrier to p-type semiconductor located at the upmost surface of the generation layer from the upper electrode.

The photovoltaic element according to the present invention, in which an n-type semiconductor which is supposed to be represented by "n", an i-type semiconductor which is supposed to be represented by "i", and p-type semiconductor which is supposed to be represented by "p", are laminated in this order on to a substrate to form a structure comprising a nip junction, and a generation layer containing at least one of the structure is provided; that the upper electrode is placed on the p-layer located at the upmost surface of the generation layer to form the photovoltaic element, is characteristic in that the p-layer positioned at the upmost surface of the generation layer is composed of a first p-layer containing crystal that is connected with the i-layer and a second p-layer comprising amorphous that is connected with the upper electrode.

## Description

### BACKGROUND OF THE INVENTION

### Field of the Invention

The present invention relates to a photovoltaic element for a solar cell, a photo sensor and others, and a method for producing the same.

### Related Background Art

Solar cells applying photovoltaic elements are expected as an alternative energy source for existing power generation of fired power generation and hydroelectric power generation solving the problems of these conventional power generation. In particular, various studies have been made on amorphous silicone solar cells, because the cells can be made relatively at low cost and can be produced as the elements that have larger area than solar cells using crystalline solar cell elements. Improvement of the photoelectric conversion efficiency of amorphous silicone solar cells is one of important problems for commercializing the amorphous silicone solar cells. Studies have been made ardently for solving the problems as shown hereunder.

The structure of amorphous silicone solar cell elements is known in which back electrode, semiconductor layer and incident surface electrode are laminated in this order on a conductive substrate such as stainless plate. The incident surface electrode is made, for example, by transparent conductive oxides.

Furthermore, a collector electrode comprising fine metallic wire is placed on the incident surface electrode mentioned above for collecting the generated electricity. The collector electrode mentioned above is provided on the incident surface; consequently it reduces effective generating area of the solar cell. The area loss is called shadow loss. For this reason, the collector electrode mentioned above is usually made in a fine comb shape. Thus, the shape of the collector electrode normally tends to be fine and long shape, and the selection of material and the design of cross sectional shape are required so as to make the electric resistance small.

An electrode called bus bar electrode is formed on the surface of the collector electrode mentioned above, for collecting the electric current that is collected by the collector electrode. The bus bar electrode is made from metallic wire that is thicker than the wire of the collector electrode.

Now, the present situation of the research is explained for minimizing shadow loss and loss by electric resistance and for improving the conversion efficiency of solar cell that is constructed as described above.

Materials that have small resistivity such as silver (1.62 × 10⁻⁶ Ωcm) or copper (1.72 × 10⁻⁶ Ωcm) are used for the above mentioned collector electrode to reduce the shadow loss and electric resistance loss.

Vacuum evaporation, plating and screen printing are used as the method to form the collector electrode.

The vacuums evaporation method has problems such as slow sedimentation, low through put, caused by the use of vacuum process, and necessity of masking to form the linear pattern, and also the masking results in the loss of metal, sediment on the masked portion. The problem in the screen printing is the difficulty forming low resistance electrode.

For example, the resistivity of the lowest resistance of conductive paste is about 4.0 × 10⁻⁵ Ωcm, this is the value one order higher than that of bulky pure silver, this means resistance of the paste is larger than that of the silver in one order. The following three methods are used to reduce the resistance without area reduction of the collector electrode using such a material.
(a) Increasing the thickness of the electrode. In this case, practically usable upper limit of the thickness is 10 µm to 20 µm. When this thickness of electrode is used to form a long, for example more than 10 cm, collector electrode, it is necessary to make the width of the electrode more than 200 µm in order to keep the electric resistance loss small, and the Aspect ratio (ratio of thickness and width) becomes small value such as 1:10, and the shadow loss becomes larger.
(b) Collector electrode that is made by coating a metallic wire with a conductive particle containing polymer is proposed in USP 4,260,429 and USP 4,283,591. The cross section of the collector electrode proposed in the USP 4,260,429 is shown in Fig. 1A. In this figure, reference numeral 101 is a metallic wire, and reference numeral 102 is a coated layer made of the conductive polymer. This invention has a merit that even the long electrode that is made using the copper wire has small electric resistance loss, and the shadow loss is also small because the Aspect ratio can be made small value such as 1:1. The security of the collector electrode proposed in the USP 4,260,429 is that the wire can be fixed by a simple method using conductive adhesive. A method to prevent physical contact between the metallic electrode and Cu₂S layer is proposed in USP 4,283,591, this method provides prevention of the metallic copper deposition.

However, these proposals have following problems.
(1) In the case of USP 4,260,429.
   A) Following problems were found by a long term exposure test or by temperature-humidity tests that short circuit between upper electrode and lower electrode is formed in a defective part such as pin hole or short circuit; lower conversion efficiency results from the small shunt resistance, tends to get worse yield. Experiments by the present inventors showed that the problem comes from electro-chemical reaction in which the ion component of the above mentioned metallic wire diffuses through the conductive polymer and reach the above mentioned semiconductor element.
   B) The electrode disclosed by USP 4,260,429 proposes to get good electro-conductivity between the metallic wire and the semiconductor element, and the solution of the problem that the occurrence of the trouble by the electro-chemical reaction between the metallic wire and the semiconductor element is not included.
   C) The electrode disclosed by USP 4,260,429 has a problem that some portion of the electrode may have not enough bonding force. In some occasion, tub of some metallic material almost did not have enough bonding force when the adhesive connection between the solar cell substrate and metallic tub of the collector electrode was required.
   D) Not only initial bonding force but constant bonding force between the electrode and the solar cell is required for the solar cell used in open atmosphere in severe condition. The solar cell that used electrode described above had a problem that the series resistance increase and the conversion efficiency decrease caused by the deterioration of the bonding force occurred during the temperature-humidity test and the heat resistance test as the acceleration test.
   E) Some problems of peeling off were observed on the solar cell caused by the lack of initial bonding force between the solar cell substrate and metallic tub, and also by degradation of the bonding force between the cell element, metallic wire and the coating layer, affected by the humidity and temperature.
   F) The solar cell was affected easily by the humidity because tight covering layer was not formed as the covering film.
   G) It is desirable that the covered wire electrode can be manufactured in off line and be used from the storage, however, in the case where thermosetting resin was used the above mentioned electrode had a problem that it was difficult to obtain the enough bonding force when it was formed on the solar cell because the cure acceleration of the polymer after the drying up was difficult to control. Furthermore there was no means on the selection of the curing agent to cure the thermosetting resin and relatively long curing time was required.
   H) When only thermoplastic resin was used, deformation of the electrode occurred caused by the thermo-hysteresis during the lamination process after the formation of the electrode, and the following problems were observed, line width change, partial peeling and position shift of the electrode.
   I) For the solar cell that is used in open atmosphere, it is required that there is no change in the bonding force between the electrode and the solar cell element even if it is used for long term in severe condition. The solar cell that used above mentioned electrode had a problem that series resistance increase and conversion efficiency decrease caused by the deterioration of the bonding force during long time open air exposure test or temperature-humidity test as the acceleration test.
(2) In the case of USP 4,283,591.
   A) Although the idea to prevent physical contact between metallic electrode and semiconductor layer was disclosed, but the solution of the problem, in which the metallic ion diffuses slowly through the conductive polymer and induces trouble, was not proposed.
   B) The electrode proposed by this invention has the possibility that the metallic wire may contacts with the solar cell substrate as the result of breakage of the above mentioned covering layer during the thermal crimp process. The concrete counter measure of this problem is not proposed.
   C) The proposal has some limit in the electrode formation because the procedure do not contain drying process and the covered wire can not be stored.
(3) In the cases of USP 4,260,429 and USP 4,283,591.
   A) Either proposal has the problem that it is difficult to get covering layer of uniform thickness and stable good electric conductivity.
   B) Short circuit between upper electrode and lower electrode is formed when the covering layer has pin hole that induces large enough leak current. As the result the shunt resistance decreased, lower conversion efficiency is resulted and the yield was decreased.
   C) The electrode proposed by the invention has the possibility that the metallic wire may contacts with the solar cell substrate, and when it is used outdoors enough effect of migration and shunt closure was not obtained.
(4) In the case of USP 5,084,104.
   A) Short circuit between upper electrode and lower electrode is formed when an amorphous silicone solar cell that has defective part such as pin hole or short circuit was used, and lower conversion efficiency is resulted from the small shunt resistance, tends to get worse yield.
   B) Series resistance of the electrode that is covered by conductive adhesive increases by thermo-hysteresis because of the solution or the softening of the electrode caused by the penetration of the paint solvent.
   C) The series resistance of the photovoltaic element increases and the conversion efficiency decreases when it is tested by open air exposure test or temperature-humidity test as the acceleration test.

### SUMMARY OF THE INVENTION

An object of the present invention is to provide a collector electrode that has excellent storability, adhesiveness, and resistance to leak due to humidity.

Another object of the present invention is to provide a photovoltaic element that has high initial characteristic and long term reliability, using the above mentioned collector electrode, can avoid short circuit between the upper electrode and lower electrode, can avoid penetration of the paint solvent to the electrode covered by the conductive adhesive, and can prevent the increase of resistance in series.

Still another object of this invention is to provide a manufacturing process that can make the photovoltaic element in a high yield and in stable operation.

According to the first example of the present invention, a photovoltaic element is provided of a structure in which an electrode coated with a conductive adhesive is placed on a photoactive semiconductor layer through the conductive adhesive, wherein the conductive adhesive is composed of at least two layers; and the softening point of the conductive adhesive composing the layer nearer to the electrode is higher than the highest temperature in the heat history of the photovoltaic element.

According to the second example of the present invention, a collector electrode is provided in which a metal wire does not contact photovoltaic elements directly because a coating layer comprising a conductive resin is provided on to the metal wire, wherein the metal ion of the metal does not diffuse into the semiconductor layer of the photovoltaic element.

According to the third example of the present invention, a collector electrode in which a metal wire comprising a coating layer consisting of a conductive adhesive is formed with adhesion on photovoltaic elements through said coating layer, wherein that the metal ion of said metal wire does not diffuse into the semiconductor layer of said photovoltaic elements.

According to the fourth example of the present invention, a photovoltaic element which comprises a semiconductor layer consisting of at least one pin junction or pn junction and a collector electrode provided in the incident side of the semiconductor layer, wherein the collector electrode comprises the collector electrode obtained in the second or third example.

According to the fifth example of the present invention, a method for manufacturing a photovoltaic element of a structure having a collector electrode in the incident side, wherein the collector electrode obtained in the second, third or fourth example is adhered to the incident face of the photovoltaic element by means of heat, pressure, or heat and pressure.

### BRIEF DESCRIPTION OF THE DRAWINGS

Figs. 1A and 1B are schematic cross-sectional views illustrating composition of a collector electrode that is provided with a coating layer on the metal wire, according to the present invention.
Figs. 2A, 2B and 2C are schematic cross-sectional views illustrating composition of a collector electrode having a plurality of coating layers and the fixation condition of the collector electrode on to a substrate.
Fig. 3 is a schematic cross-sectional view illustrating for a wire coat device used for manufacturing a collector electrode of the present invention.
Figs. 4A, 4B and 4C are schematic cross-sectional views illustrating composition of a solar cell of amorphous silicon type, according to the present invention.
Fig. 5is a schematic cross-sectional view illustrating composition of a solar cell of single crystal silicon type, according to the present invention.
Fig. 6 is a schematic cross-sectional view illustrating composition of a solar cell of polycrystal silicon type, according to the present invention.
Fig. 7 is a schematic cross-sectional view illustrating composition of a thin film solar cell of polycrystal silicon type according to the present invention.
Figs. 8A and 8B are schematic plan views illustrating composition of a solar cell that is an example of the photovoltaic element according to the present invention.
Fig. 9 is a schematic cross-sectional view illustrating composition of a photovoltaic elements module using a collector electrode having two layers coating, according to the present invention.
Fig. 10 is a schematic cross-sectional view illustrating composition of a photovoltaic elements module using a collector electrode having two or three layers coating, according to the present invention.
Fig. 11 is a schematic cross-sectional view illustrating composition of a photovoltaic elements module using a collector electrode having three layers coating, according to the present invention.
Fig. 12 is a graph showing the relationship between volume resistivity and conversion efficiency in a module of photovoltaic elements according to the present invention.
Fig. 13 is a schematic plan view illustrating composition of another module of photovoltaic elements using a collector electrode having the coating layer, according to the present invention.
Fig. 14 is a graph showing the relationship between steaming cycles and series resistance for a module of photovoltaic elements according to the present invention.

### DETAILED DESCRIPTION OF THE PREFERRED EMBODIMENTS

According to experiments conducted by the inventors, the problem arising in the formation of the existing collecting electrode, during the process following the coating and drying of the wire; in environments where light and moisture are present; was found to be caused by electromotive force being applied to the collecting electrode, thereby diffusing ions from the metal wire to the conductive resin layer. Also, the problem of shunt with the existing collecting electrode formation was found to be caused by the possibility that the metalwire could contact the semiconductor layer or the transparentconductive film, because the conductive resin coating consisted of only one layer. In other words, it is not possible, with the existing collecting electrode, to prevent the metal wire from directly contacting the semiconductor layer without the inclusion of conductive resin during the thermocompression bonding process and therefore, it was found that contact of the faulty area and the wire was the cause of the initial decrease in yield. In addition, we have discovered that, even if such contact was prevented, metal ion diffusion occurred during actual usage, because of minute pores in the conductive resin, as well as the moisture and ion permeability of the resin itself. We have also discovered that the problem of long-term dependability was attributed to the deterioration of conductivity with the conductive resin, caused by oxidation of the metal wire surface (consisting of copper, etc.), which is caused by moisture penetrating during outdoor use, because the polymer used in solar batteries laminated with polymer is not perfectly water tight.

We have also found out that it is problematic that the bridging density of the conductive resin layer could not be controlled regarding the shelf life and adhesive strength of the collecting electrode. In other words, the problem was that, when curing resin is used in polymers that form the conductive resins of the existing collecting electrode, the resin would harden after drying, for example during storage, while the use of thermoplastic resin was also a problem because the fluidity would become too large from the heat history of later processes, because the resin will not bridge.

Furthermore, low resistance copper and aluminum wires used in wiring for electric appliances are inexpensive and good conductors. Enamel wires, etc. are made by coating these metal wires with insulating varnish, but generally, it is not easy to coat metal, which are inorganic, with material that contains organic material. In addition, sufficient adhesive strength may not be obtained when adhering the wire, through the coating layer, to semiconductors and metals. This is because a special bond does no exist between the organic material in the coating layer and the semiconductor or metal material. This problem becomes even more pronounced depending on the metal material and its surface conditions, and we have discovered that almost no adhesive strength can be obtained when they are affected by moisture.

As a result of studies by the inventors of this invention aimed at tackling these problems, we have discovered that good adhesion, offering good storage characteristics with no progressive curing after the heat/drying process, can be achieved without altering the shape of the electrode by using a curing agent, such as block isocyanate, etc. to control the bridging density of the conductive resin layer before and after the process of forming the electrode on the surface of the solar cell.

We were able to create solar batteries of good characteristics by dividing the coating layer into multiple layers, where each layer will be assigned different jobs, such as preventing moisture and ion permeation, and the adhesion of the metal wire to the semiconductor layer or the transparent electrode.

Also, by creating a coating layer consisting of polymer containing a coupling agent and conductive filler, the surface of the metal was altered in such a way that it will readily adhere to organic material, whereby a good adhesion between the metal and the conductive resin layer containing organic material was achieved based on the knowledge of this invention.

Next, we will describe the constitutive characteristics of the embodiment of this invention, as well as the interactive effects based thereon.
(1) With regard to the collecting electrode on which a metal wire; coated with a layer consisting of conductive adhesive; is adhesion-formed on the photovoltaic element through the layer of coating, we have prevented the metal ions in the metal wire to diffuse into the semiconductor layer of the photovoltaic element. As a result, we were able to prevent the short circuiting of the metal wire and the semiconductor layer of the photovoltaic element, which causes deterioration of the photovoltaic element's exchange efficiency.
(2) Because the coating layer possesses the property of preventing the diffusion of the metal ions, it becomes possible to prevent the deterioration of the photovoltaic element's exchange efficiency caused by the short circuiting of the metal wire and the semiconductor layer of the photovoltaic element, even if the metal wire is applied with a voltage that is greater than the photovoltaic element's electromotive force, regardless of the voltage which is applied on the metal wire.
(3) Because the conductive adhesive consists of conductive particles and polymer, the resistivity of the conductive adhesive can be variably adjusted between 0.1 Ωcm and 100 Ωcm.
(4) The surface of the metal, for example, a metal wire, is altered in such a way that it is readily bonded to organic material and therefore providing a good adhesion between metals and conductive resin containing organic material, because the conductive adhesive consists of a coupling agent, conductive particles and polymer.
(5) Since one of the following; silane based, titanate based and aluminum based coupling agents; will be chosen as the coupling agent, it is possible to control the interface between dissimilar material. In other words, it will act as a medium between the inorganic material (metal) and the organic material (binder resin included in the conductive resin), to form a strong bond between the two.
(6) Because we have determined the space ratio of the conductive adhesive to be 0.04ml/g or less, at a space radius of 1 µm or less, we are able to avoid short circuits caused by the ionization and migration of silver in the conductive adhesive.
(7) Because the numeric mean molecular weight of the polymer ranges from 500 to 50,000, it is possible to prevent diffusion of the metal ions.
(8) Because the gel rate of the polymer ranges from 20% to 100%, it is possible to control deformation and dislocation of the electrode even when heat history is applied after the electrode is formed. As a result, it becomes possible to prevent diffusion of the metal ions.
(9) Because the layer of coating consists of two or more layers and the conductive adhesive which makes up all inner coating layers, other than the outermost layer, consist of the polymer, it is possible to assign different tasks; such as prevention of moisture and metal ion permeation, and the adhesion between the metal wire and the semiconductor layer or the transparent electrode; to different layers.
(10) Because the layer of coating consists of two or more layers and conductive adhesive which makes up the outermost layer consists of an uncured thermoplastic polymer, the collecting electrode can be stored, providing sufficient adhesive strength when curing is completed during the formation of the electrode on the photovoltaic element. As a result, we were able to prevent deformation of the electrode that cause changes in line width, partial peeling or positional dislocation of the electrode, caused by heat history during processes, such as lamination following the formation of the collecting electrode.
(11) Because the conducive adhesive consists of two or more layers and because the softening point of the conductive adhesive making up the layer closest to the electrode is set higher than the maximum temperature of the heat history applied to the photovoltaic element during the manufacturing process, we are able to prevent melting or peeling during the formation of the moisture protection layer, or deformation or peeling during lamination.
(12) Because we have limited the resistivity range of the conductive adhesive to 0.1 Ωcm to 100 Ωcm, it possesses a preventive function against shunt and we were able to reduce the electric resistance loss to negligible levels.
(13) Because at least one of the following: urethane, phenoxy, epoxy, butyral, phenol and polyimide, will be chosen as the polymer, we are able to choose the desired hardness of the resin from a wide range. As a result, the metal wire can be coated readily, workability is good, good flexibility is provided and it can be heat cured. As a result, durability is improved.
(14) Because we have selected block isocyanate as the curing agent to be contained in the conductive adhesive, we are able to control the bridging density of the conductive adhesive, before and after the formation of the electrode on the photovoltaic element. As a result, the collecting electrode is easy to handle and guarantees stability during storage. Furthermore, the process of applying the conductive adhesive to the collecting electrode can be operated at low costs.
(15) Because the glass transition point of the conductive adhesive was specified to be 100 degrees centigrade or higher, the permeation of paint solvents into the electrode coated with conductive adhesive, when compression bonding the electrode coated with conductive adhesive to the cell surface of the photovoltaic element, can be prevented.
(16) Because the average diameter of the primary particles of the conductive particles was limited to a range of 0.02 µm to 15 µm, they are smaller than the thickness of the coating and the increase in resistivity caused by the contact between particles can be controlled.
(17) Because we have specified the conductive particles to be at least one of the following: graphite, carbon black, In₂O₃, TiO₂, SnO₂, ITO, ZnO or a substance that is created by adding to these a dopant consisting of trivalent metal elements, it was possible to make particles with diameters of 0.02 µm to 15 µm.
(18) The transparent electrode installed on the semiconductor layer of the photovoltaic element and the conductive adhesive were installed in contact with each other. As a result, the efficiency of semiconductors; in particular the non-monocrystal semiconductors that offer large resistance in the planar direction; was improved by installing on the semiconductor layer, a transparent electrode for the light that the semiconductors absorb.
(19) In the case of a photovoltaic element which consists of a semiconductor layer (consisting of at least one pin junction or pn junction) and a collecting electrode installed on the light entry side of the semiconductor layer, we were able to obtain a photovoltaic element of good initial characteristics and long term dependability, because the collecting electrode consists of the above mentioned collecting electrode.
(20) We were able to obtain a photovoltaic element with good conductivity and sufficiently low series resistance, because the semiconductor layer had a transparent electrode on the light entry side and the collecting electrode was installed on the transparent electrode.
(21) We were able to obtain a photovoltaic element of good initial characteristics and long term dependability, because we have specified at least one of the following to be used for the semiconductor layer: monocrystal silicone, polycrystalline silicone, thin film polycrystalline silicone, amorphous silicone, amorphous silicone germanium or amorphous silicone carbon.
(22) Because the semiconductor layer was made into a triple cell, consisting of three layers of cells consisting of pin junction or pn junction, a photovoltaic element of better initial characteristics was obtained.
(23) As for the production method of photovoltaic elements with a collecting electrode on the light entry side, we were able to realize a production method of photovoltaic elements that offered good production yield, because the collecting electrode is adhered to the light entry side of the photovoltaic element with heat and/or pressure.
(24) We were able to obtain a method of producing photovoltaic elements of good initial characteristics and long term dependability, because the heat applied to the collecting electrode is higher than the dissociation temperature of the block isocyanate, therefore allowing the adhesion and curing of the formed collecting electrode to be completed in a short period of time.
(25) We were able to obtain a method of producing photovoltaic elements of long term dependability, which were not affected readily by moisture after the adhesive formation of the photovoltaic elements, because the collecting electrode is heated until the gel rate of the uncured said heat curing polymer which forms the coating layer is between 20% to 100%.

The following sections describe the embodiment of this invention.

### (Collecting electrode)

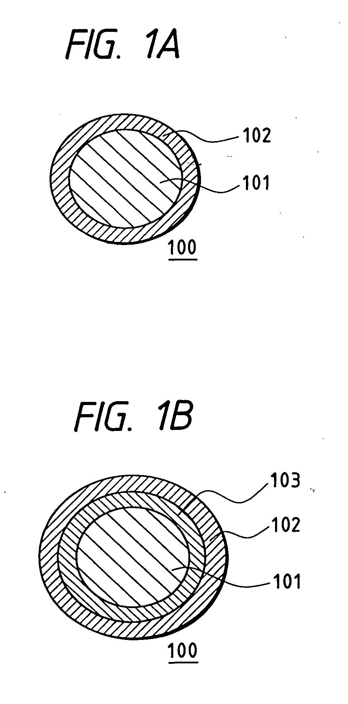

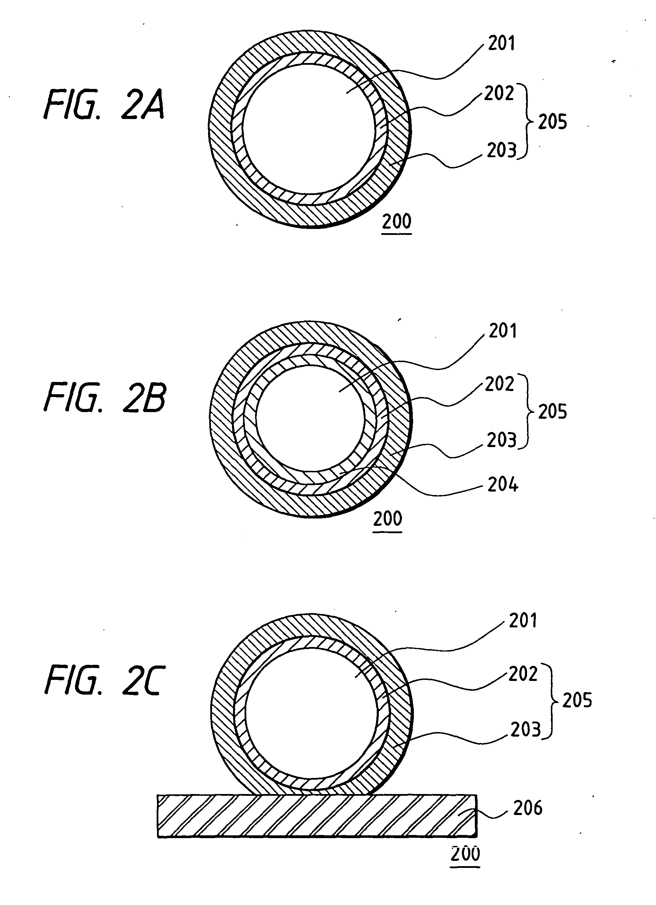

Collecting electrodes, according to this invention, are described in Figs. 1A and 1B, and 2A to 2C. The collecting electrode 100 shown in Fig. 1A is one in which the metal wire 101 is coated with one type of coating layer 102. The collecting electrode 200 shown in Fig. 2A is one in which the metal wire 201 is coated with two types of coating layers, namely, first coating layer 202 and second coating layer 203.

It is desirable for the metal wires 101 and 202 composing the collecting electrode 100 and 200 to be wire material, for which an industrially stable supply is available. It is also desirable that the material of the metal composing the metal wires 101 and 201, possess a resistivity of 10⁻⁴ Ωcm or less. For example, copper, silver, gold, platinum, aluminum, molybdenum and tungsten are suitable for use because of their low electric resistance. Of these, copper, silver and gold are the most desirable for their low electric resistance. The metal wire can also be an alloy of these metals.

If so desired, it is also proper to form thin metal layers 103 and 204, such as those shown in Figs. 1B and 2B, on the surface of the metal wire; for purposes such as corrosion prevention, oxidation prevention, improvement of adhesion with the conductive resin and the improvement of electric conductivity. Candidates for metal layers to be applied to the metal wire surface are precious metals that offer resistance to corrosion, such as silver, palladium, silver and palladium alloy and gold, as well as metals with good corrosion resistance, such as nickel and tin. Of these, gold, silver and tin are not readily affected by moisture, therefore making them suitable for the metal layer. For example, plating and cladding are suitable methods of forming the metal layer on the metal wire surface. It is also possible to create a coating of conductive resin in which the metals are used as fillers and distributed throughout the resin. Though the thickness of the coating will depend on individual preferences, the ideal thickness for metal wires with a circular cross section would be 1% to 10% of its diameter. The ideal resistivity of the metal layer, considering the electric conductivity, effectiveness of corrosion resistance and the thickness of the metal layer, would be 10⁻⁶ Ωcm to 100 Ωcm.

The cross section of the metal wire can be circular or rectangular and can be chosen depending on preferences. The diameter of the metal wire was designed so that the sum of the electric resistance loss and shadow loss is minimal. In specific terms, a copper wire for enamel wire with a diameter of 25 µm to 1mm, as indicated in the JIS-C-3203 is suitable for use. It is even more desirable to use diameters of 25 µm to 200 µm to create photovoltaic elements with good photoelectric exchange efficiency. Wires with diameters smaller than 25 µm are prone to breakage, difficult to produce and their power loss is larger. Meanwhile, diameters of 200 µm or more possess larger shadow loss or the surface of the photovoltaic element becomes bumpy, making it necessary to make the filler used on the surface coating layer, such as EVA, thicker.

The metal wire is produced by using a well-known wire drawing machine to mold it into the desired diameter. The wire which has passed through the wire drawing machine is hard, but it will be annealed using a well-known method to meet desired characteristics in stretchability and bendability, and it can be also used as a soft wire.

### (A collecting electrode coated with a conductive adhesive consisting of one layer)

An example of "a collecting electrode coated with a conductive adhesive consisting of one layer" according to this invention is shown in Fig. 1A.

In Fig. 1A, 101 is a metal wire for the electrode and 102 is the coating layer. The metal wire 101 is the core wire of the collecting electrode, and uses a wire that possesses good conductivity, such as copper wire, silver plated copper wire or silver copper clad wire, in order to reduce power loss. The coating layer 102 is formed from heat curing conductive adhesive or thermoplastic conductive adhesive, and its function is to mechanically and electrically connect the main part of the collecting electrode to the photovoltaic element substrate, through the thermocompression bonding process.

### (A collecting electrode coated with a conductive adhesive consisting of two layers)

An example of "a collecting electrode coated with a conductive adhesive consisting of two layers" is shown in Fig. 2A.

In Fig. 2A, 201 is a metal wire for the electrode, 202 is the first coating layer and 203 is the second coating layer. The metal wire 201 is the core wire of the collecting electrode, and uses a wire that offers good conductivity, such as copper wire, silver plated copper wire or silver copper clad wire, in order to reduce power loss. The first layer 202 is formed with heat curing conductive adhesive, and protects the electrode metal, and provides mechanical and electrical connection. It also has the function of preventing migration by the electrode metal and controlling the flow of current into defective areas of the photovoltaic element from the collecting electrode. The second layer 203 is also formed of heat curing conductive adhesive, and its function is to mechanically and electrically connect the main part of the collecting electrode to the photovoltaic element substrate, through the thermocompression bonding process. And also because it heat cures, it is not readily damaged by paints used in the moisture prevention layer in later processes.

In other words, the first coating layer 202, which is in direct contact with the metal wire 201, is a barrier layer which prevents moisture from reaching the metal wire to prevent corrosion of the metal wire surface, as well as prevent metal ion migration from the metal wire. The second layer 203 is an adhesive layer, which has the functions of adhering the collecting electrode to the semiconductor layer or transparent electrode and of current collection.

As for polymers included in the conductive adhesive that make up the first layer 202, resins with relatively little permeability are suitable for use among the resins mentioned above. In other words, urethane, epoxy, phenol or heat curing resins created by denaturating these resins are ideal. Also, it is desirable to allow thorough curing after these resins are applied. In addition, it is desirable that the thickness of the first layer be 1 µm to 15 µm, in order to prevent excessive shadow loss. Thicknesses of under 1 µm will make it difficult to create a uniform coating and pin-holes will occur, rendering it insufficient as a barrier. On the other hand, thicknesses of over 15 µm are not desirable because they are difficult to peel and shadow loss becomes too great.

As for polymers included in the conductive adhesive that make up the second layer 203, resins with good adhesive properties and good flexibility, in particular are suitable. In other words, urethane, epoxy, phenol or heat curing resins made by denaturating these resins or thermoplastic resins, such as phenoxy, polyamide or polyamideimide would be suitable. In particular, urethane resin is suitable for use because its bridging density is readily adjusted. It is desirable to leave these resins uncured after coating and cured only after the adhesion process is complete. For this reason, block isocyanate is desirable as the polymeric curing agent. This block isocyanate has the mechanism of progressively curing when heated above the dissociation temperature. Therefore, by drying it at temperatures lower than the dissociation temperature, any solvent contained in it can be completely removed, therefore depriving it of its stickiness and tackiness, allowing it to be coiled on a reel for storage. In addition, because curing will not progress unless temperatures exceeding the dissociation temperature of the isocyanate are applied, it will uniformly provide sufficient adhesive strength during the formation of the collecting electrode.

The thickness of the second coating layer will depend on the diameter of the wire. For example, if the diameter of the metal wire is 100 µm, the ideal thickness of the second coating layer would be 5 µm to 30 µm; which is a thickness that would have no pin-holes, would provide sufficient properties as an adhesive layer and offer no extreme shadow loss.

### (A collecting electrode coated with a conductive adhesive consisting of three layers)

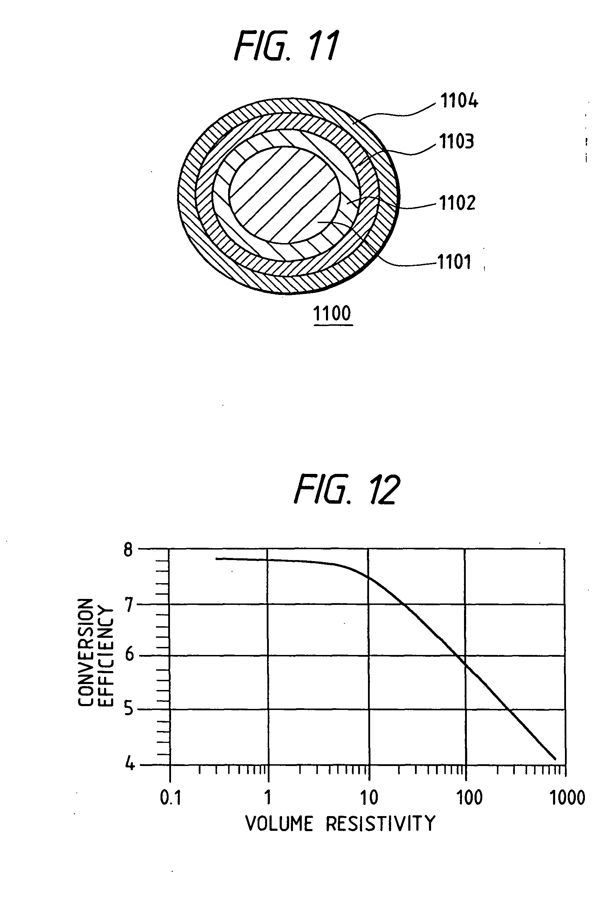

An example of "a collecting electrode coated with a conductive adhesive consisting of three layers" according to this invention is shown in Fig. 11.

In Fig. 11, 1101 is the metal wire for the electrode, 1102 is the first coating layer, 1103 is the second coating layer and 1104 is the third coating layer. The metal wire 1101 is the core wire of the collecting electrode, and uses a wire that offers good conductivity, such as copper wire, silver plated copper wire or silver copper clad wire, in order to reduce power loss. The first layer 1102 is formed of heat curing conductive adhesive, and provides electrical connection with the electrode metal. Metallic conductive adhesives would be suitable for the first coating layer 1102, to provide an electrical connection with the electrode metal. The second layer 1103 prevents migration caused by the metal fillers in the metallic conductive adhesive used in the electrode metal and the first coating layer. It also controls the flow of current to defective areas in the photovoltaic element from the collecting electrode. The third coating layer 1104 is also formed of heat curing conductive adhesive and its function is to mechanically and electrically connect the main part of the collecting electrode to the photovoltaic element substrate, through the thermocompression bonding process. And also because it heat cures, it is not readily damaged by paints used in the moisture prevention layer in later processes.

### (Conductive adhesives and their resistivity)

In this invention, the conductive adhesive used to coat the metal wire is made by distributing conductive particles and polymer. The resistivity of the conductive adhesive must be negligible in terms of collecting the electric current generated by the photovoltaic element and at the same time, provide adequate resistance to prevent shunt. In specific terms, 0.1 Ωcm to 100 Ωcm is desirable. When resistance is smaller than 0.1 Ωcm, the shunt retention function becomes insufficient and when it is greater than 100 Ωcm, loss from electric resistance becomes too great.

### (Conductive particles)

Conductive particles according to this invention are pigment which add conductivity. Materials suitable for this purpose are, for example, carbon black, graphite, In₂O₃, TiO₂, SnO₂, ITO, ZnO and oxide semiconductor material made by adding the appropriate dopant to the material. The diameter of the conductive particles should be smaller than the coating layer to be formed, but if particles are too small the resistance on the contact point of the particles to each other becomes great and making it impossible to obtain the desired resistivity. For these reasons, the suitable average diameter for the conductive particles is 0.02 µm to 15 µm. It is also acceptable to adjust the resistivity and the distribution in the conductive resin by mixing two or more types of conductive particles. It is also acceptable to add translucency by using materials, such as ITO, In₂O₃, TiO₂, SnO₂ and ZnO. The usage of ITO produces especially good translucency.

The conductive particles and the resin are mixed in suitable ratios to obtain the desired resistivity. Resistivity will decrease as the amount of conductive particles increase, but the coating layer will loose its stability as the proportion of resin decreases. And when the polymers are increased, the contact of the conductive particles to each other becomes faulty and will result in high resistance. Therefore, the optimum ratio should be determined depending on the polymer and conductive resin used, as well as its desired physical properties. In specific terms, good resistivity is obtained at volume percentages of the conductive particles ranging from 5% to 95%.

### (Polymer)

The suitable resin according to this invention will be one that facilitates coat formation on the metal wire, with good workability, flexibility and weather resistance. Polymers with such characteristics are heat curing resins and thermoplastic resins.

As for heat curing resins, urethane, epoxy, phenol, polyvinyl formal, alkyd resin and resins made by denaturing these materials are examples which are suitable for use. In particular, urethane, epoxy and phenol resins are used as coating material for enamel lines, and are good in terms of flexibility and productivity. They are also suitable as material for collecting electrodes of the photovoltaic element, in terms of weather resistance and adhesion.

As for thermoplastic resins, butyral, phenoxy, polyamide, polyamideimide, melamine, butyral, acryl, styrene, polyester and fluoride are examples of suitable materials. In particular, butyral, phenoxy, polyamide and polyamideimide resins are good materials in terms of flexibility, weather resistance and adhesion, making them suitable for use in collecting electrodes of photovoltaic elements.

### (Coupling agent)

In this invention, a conductive adhesive consisting of a polymer containing a coupling agent and conductive particles are suitable. The reason why good characteristics are obtained when a conductive adhesion added with a coupling agent is used is described below.

Generally, low resistance copper and aluminum wires used in wiring for electric appliances are inexpensive and good conductors. Enamel wires, etc. are made by coating these metal wires with insulating varnish, but generally, it is not easy to coat metal, which are inorganic, with material that contain organic material. In addition, sufficient adhesive strength may not be obtained when adhering (the wire), through the coating layer, to semiconductors and metals. This is because a special bond does not exist between the organic material in the coating layer and the semiconductor or metal material. This problem becomes even more pronounced depending on the metal material and its surface conditions, and we have discovered that almost no adhesive strength can be obtained when they are affected by moisture.

When the collecting electrode stated in this invention is used for solar batteries, its coupling agent acts to strengthen the bond between the organic material in the coating layer, with inorganic material, such as the surface of the solar cell substrate or metal tabs of the takeoff electrode. This makes it possible to prevent areas from loosing sufficient adhesive strength. In addition, because the coating layer consists of two or more layers, effectiveness can be improved by determining the type of coupling agents to be used in the inner most side, which is in direct contact with the metal wire, and the outer most layer, which is in direct contact with the solar cell substrate; depending on the material of the metal wire, material of the solar cell substrate, material of the metal tab and the polymer composing these coating layers. Also, the adhesive strength enhanced by the coupling agents is maintained in high temperatures, high humidity and high temperature/humidity environments, and therefore maintained even when the solar cell is used outdoors. This makes it possible to prevent deterioration of the exchange efficiency caused by the rise in series resistance from the deterioration of adhesive strength between the electrode and the solar cell substrate or metal tab, as well as from peeling.

As the coupling agents used in this invention, silane derivative coupling agent, titanate derivative coupling agent and aluminum derivative coupling agent are among those cited. Such a coupling agent consists of a hydrophilic portion which has a mutual function with inorganic material and an organic function group which has a mutual function with organic material. The surface control between foreign materials is the main purpose of the use, particularly its function is based on a covalent bond and in this respect it is different from conventional surface active agents. That is, the coupling agent acts as go-between between a combination of inorganic material (metal) and an organic material (polymer in conductive adhesive) and the two materials are firmly combined. A silane derivative coupling agent is covalently bonded to both the inorganic material and the organic one, however, titanate derivative coupling agent and aluminum derivative coupling sometimes do not form covalent bonds of organic material. By changing the polarity and surface energy of the surface of inorganic material, the strength of the bond can be increased. So, it is said that a silane coupling agent is the most effective.

As silane coupling agents suitable for this invention, the following products are among those cited: γ-mercaptoxy propyltrimethoxysilane, γ-glycixidpropyltrimethoxysilane, γ-(2-aminoethyl) aminopropyltrimethoxysilane, γ-(2-aminoethyl) aminopropylmethyldimethoxysilane, aminosilane, γ-anilinopropyltrimethoxysilane, vinyltriacetoxysilane, hexamethyldisilane, γ-chloropropyltrimethoxysilane.

As titanate coupling agents suitable for the invention, the following products are cited: isopropyltriisostearoyltitanate, tetra(2, 2-diallyloxymethyl-1-butyl) bis (di-tridecyl) phosphitetitanate, tetraisopyruvis (dioctylphosphite) titanate, isopropyltri (N-aminoethyl-aminoethyl) titanate, tetraoctyl bis (ditridecylphosphite) titanate, isopropyltris (dioctylpyrophosphanate) titanate, bis (octylpyrophosphate) oxyacetatetitanate.

As an aluminum derivative coupling agent suitable for the invention, acetoalkoxyaluminiumdiisopropylate is cited.

When the preceding coupling agent reacts with the surface of inorganic material, there is an optimum amount in order to obtain the optimum properties such as adhesive power. Usually, a coupling agent is mixed with a desirable solvent, adjusted and used. Such solvents are methanol, ethanol, isopropyl alcohol, toluene, benzene, acetone, methyl cellosolve, tetrahydrofuran and water. The solvent which is compatible with each coupling agent is selected and used. If solvent is used at high concentration, the activity of coupling agent would loose. Therefore, low concentration is used, 0.01% - 10.0% is usually optimum.

Also, the hydrophilic portion of the preceding coupling agent depends on silane, titanate, and aluminum derivatives; the suitability to the reaction of inorganic material must be considered. On the other hand, the organic function group of coupling agents are amino, epoxy, carboxy, phosphite radicals, etc. The suitability to reaction of organic material with these organic function groups must be considered.

### (Mean molecular weight of polymer)

In order to prevent diffusion of the preceding metal ion from the preceding metal wire, it is necessary to get good adhesion of the conductive particle with the polymer. For this reason, as said polymer, the polymer of more than 500 and less than 50,000 figure mean molecular mean weight is desirable.

In this invention, in order to form a dense coating film, it is necessary to improve the dispersibility between the used polymer and the conductive particles, and to decrease the hole volume of the formed coating layer. It becomes possible to control the effect of humidity by proper selection and combination of polymers having more than 500 and less than 50,000 mean molecular weight and various kinds and diameters of conductive particles. The favorable resins for use are urethane, phenoxy, epoxy, butyral, phenol, polyimide, melamine, alkyd, fluorine polyvinylformal, polyamide, polyamideimide, polyester, acrylic and styrene resins. Especially, urethane, phenoxy, epoxy and phenol resins are widely used industrially for insulation material for enamel wire. Good properties in respect to humidity resistance, control of flexibility and productivity can be obtained. Moreover, butyral resin has good dispersibility, polyimide resin has good heat resistance.

### (The gel ratio of the polymer)

One way to measure the degree of bridging of the polymer is to measure its gel ratio. In other words, when a specimen of the polymer is soaked in solvents, such as xylene, the gel parts that have bridged by gelation will not elute, but the sol parts which have not bridged will. In other words, when bridging is complete, there will be no elution of the sol parts. Next, when the specimen is removed and the xylene is evaporated, the undissolved gel part, from which the sol part has been removed, will remain. The gel ratio is obtained by measuring the amount of unbridged and eluted zol. The method of calculation is described below. Gel ratio = [(weight of undissolved part) / original weight of specimen] × 100 (%)

High gel ratios after the drying process will result in decreased adhesive strength during the formation of the collecting electrode. In addition, low sol ratios of the conductive resin layer of the collecting electrode formed by thermocompressibn, may result in decreased dependability when subjected to moisture.

Therefore by limiting the gel ratio of the polymer layer of the conductive resin layer to 0% to 20%, after the adhesive layer has been coated and dried onto the metal wire, its initial adhesion will not be affected during storage. In addition, by keeping the gel ratio of the adhesive layer to 20% to 100%, after the thermocompression formation of the collecting electrode, dependability during usage will also be improved.

### (The mixing of the conductive particles and the polymer)

"The mixing of the conductive particles and the polymer" according to this invention is conducted at a suitable ratio to obtain the desired resistivity. Resistivity will decrease as the amount of conductive particles increase, but the coating layer will loose its stability as the proportion of resin decreases. And when the polymers are increased, the contact of the conductive particles to each other becomes faulty and resulting in high resistance. Therefore, the optimum ratio should be determined depending on the polymer and conductive resin to be used, as well as its desired physical properties. In specific terms, good resistivity is obtained at volume percentages of the conductive particles ranging from 5% to 95%.

The distributing devices used in "the mixing of the conductive particles and the polymer" according to this invention are, for example, regular triple roll mills, ball mills, paint shakers and bead mills. It is acceptable to add distributing agents and coupling agents as desired to improve distribution. It is also acceptable to dilute it with a suitable solvent to adjust the viscosity of the conductive adhesive, during or after distribution.

### (Layer closer to the electrode)

"Layer closer to the electrode" according to this invention, are those layers which have either one or both of the following functions: to protect the metal wire used in the electrode from the surrounding environment or to establish an electrical connection with the metal wire. The resistivity of "layer closer to the electrode" must be such that it does not offer electric resistance when collecting the current generated by the photovoltaic element and a suitable range would be 0.1 Ωcm to 100 Ωcm. By using heat cured conductive adhesive for this "layer closer to the electrode", solvent resistance and heat resistance during production, as well as dependability during usage is improved.

If so desired, it is acceptable to form the contact layer, of which the main ingredient is metal, as the "layer closer to the electrode". The contact layer has the function of improving the electrical contact between the metal wire and the conductive adhesive. In particular, when copper is used for the electrode metal wire, its surface is subject to oxidation, resulting in high resistance, in which case the contact resistance will increase, should graphite and substances like metal oxides be used for the conductive particles. Use the contact layer to prevent such incidents. Candidates materials for the contact layer are precious metals that offer resistance to corrosion, such as silver, palladium, silver and palladium alloy and gold, as well as metals with good corrosion resistance, such as nickel and tin. When this consists of a conductive adhesive, it is desirable to produce an adhesive with the metal as its filler. It is also acceptable to form a layer of tin or silver on the metal wire by plating, without using conductive adhesives. Silver clad copper wires are also acceptable.

When metal based conductive adhesive is used in the "layer closer to the electrode", it is acceptable to form a barrier layer on top of it that will prevent metal ion migration.

The thickness of the barrier layer will vary depending on the wire diameter and preference. For example, for a wire with a diameter of 100 µm, a thickness of 1 µm to 15 µm would be desirable, to prevent pin-holes, to provide sufficient function as a barrier and to prevent excessive shadow loss. Thicknesses of under 1 µm make it difficult to create a uniform coating and pin-holes will occur, rendering it insufficient as a barrier. On the other hand, thicknesses of over 15 µm are not desirable because they are difficult to peel and shadow loss becomes too great.

### (The void ratio of the conductive adhesive)

In order to improve its barrier effect against metal ions, the void ratio of the conductive adhesive used in the barrier layer must be 0.04 ml/g or smaller, for a void radius of 1 µm or smaller.

Void radii of over 1 µm or more exist only very rarely for regular adhesives containing pigment. And when voids larger than this do exist, the mechanical strength of the conductive adhesive deteriorates after curing. Also, void ratios exceeding 0.04 ml/g will allow water to penetrate, which will degrade the bond between the conductive particles and the polymer in the conductive adhesive, resulting in greater resistance or metal ion migration.

### (The glass transition point of the conductive adhesive)

According to this invention, it is desirable that the glass transition point of the conductive adhesive after curing is 100 °C or higher. This will give it characteristics to sufficiently withstand the heat history during over-coating after the formation of the coating, as well as during the top coat agent and lamination processes.

### (The method of coating the conductive adhesive)

Regular coating methods used for enamel wires can be suitably used as "the method of coating the conductive adhesive" in this invention. In specific terms, the conductive adhesive will be diluted to an appropriate viscosity, after which it will be coated onto the metal wire using a roll coater etc., after which it will be passed through dies or felt to form the desired thickness and finally dried and cured using infrared heating, etc.

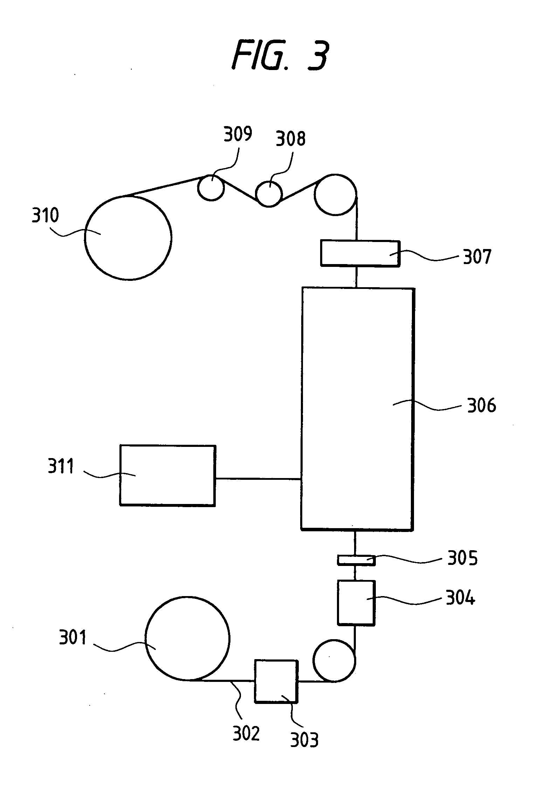

Fig. 3 is a type diagram describing a suitable coating device. In Fig. 3, 301 is the delivery reel, 302 is the metal wire, 303 is the cleaning tank, 304 is the coater, 305 is the die, 306 is the drying oven, 307 is the film thickness gauge, 308 is the tension controller, 309 is the aligned winding motor, 310 is the take-up reel and 311 is the temperature regulator.

The delivery reel 301 is the bobbin to which the metal wire before coat formation is wound. The cleaning tank 303 is used only when required. This tank is filled with solvents, such as acetone, MEK and IPA, and is used to clean the surface of the metal wire 302 of any dirt. The coater 304 is a device which is used to apply the conductive adhesive to metal wire 302. The coater 304 contains a certain amount of conductive adhesive to be applied and can be equipped with a solvent adding mechanism for adjusting viscosity, a conductive adhesive replenishing mechanism or a filter mechanism if desired. The die 305 is a device which controls the thickness of the applied conductive adhesive to the desired thickness. As for the die 305, commercially available die for enamel coats are suitable for use, but felt may be used if desired. The drying oven 306 is used to remove solvent from the applied conductive adhesive and to dry it. It is also used for curing and if desired, these can be hot air driers or infrared driers. The film thickness gauge 307 is used to measure and manage the thickness of the applied conductive adhesive, and a commercially available outer diameter gauge is suitable for this purpose. It is also acceptable to use the information obtained through the film thickness gauge to conduct feedback controls, such as for delivery speed and viscosity of the conductive adhesive. The tension controller 308 maintains a constant tension, to prevent sag or forces exceeding the yielding point to be applied to the metal wire 302. The aligned winding motor 309 is a device that controls the spacing of the wire while the wire is being wound to the take-up reel 310. The take-up reel 310 is rotated at the desired speed, by a motor which is not shown in the figure. The temperature regulator is a device which maintains the temperature in the drying oven 306 at the set value. Well-known methods, such as slidack, on/off control and PID can be used if desired.

Fig. 3 shows a vertically oriented device, but the direction of travel of the metal wire 302 can be either vertical or horizontal and can be determined based on preference.

When applying multiple coats of conductive adhesive, (the wire) may be taken up by the bobbin after each coating, but it may also be taken up by the bobbin after multiple coatings are complete. Fig. 3 shows the coating of one wire, but multiple wires may be coated simultaneously.

The metal wire, onto which conductive adhesive has been coated, is to be stored wound to the bobbin, to be unwound for use when forming the collecting electrode for the photovoltaic element.

### (Photovoltaic element)

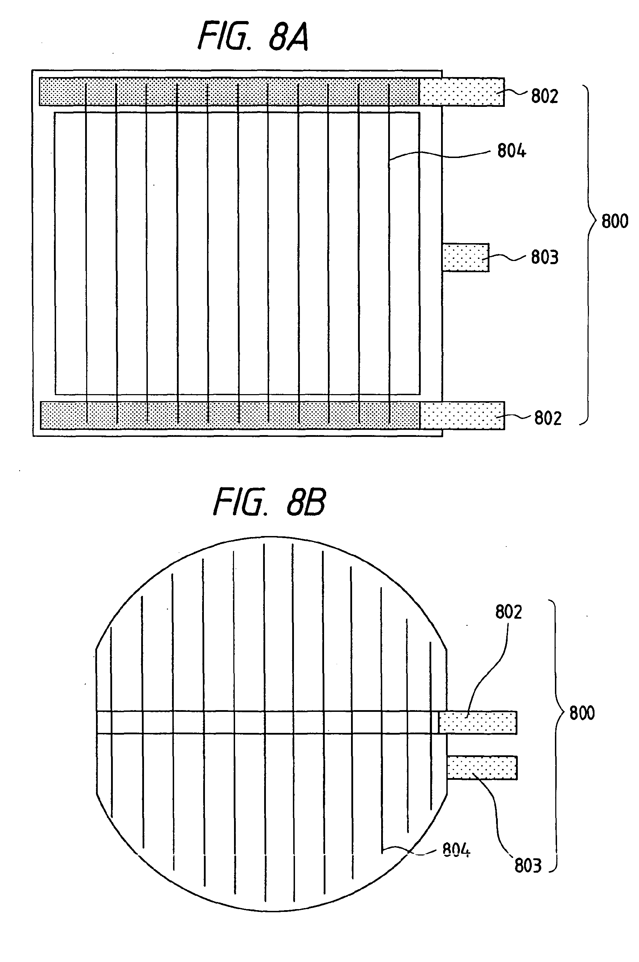

Solar batteries configured as shown in Figs. 4A to 4C through Figs. 8A and 8B are examples of photovoltaic elements according to this invention.

Shown in Figs. 4A to 4C is a typical cross section of an amorphous silicone based solar cell, which receives light from the surface opposite the substrate. In this figure, 401 is the substrate, 402 is the lower electrode, 403, 413 and 423 are the n-type semiconductor layers, 404, 414 and 424 are i-type semiconductor layers, 405, 415 and 425 are p-type semiconductor layers, 406 is the upper electrode consisting of a transparent conductive film and 407 is the grid electrode where a collector electrode is used.

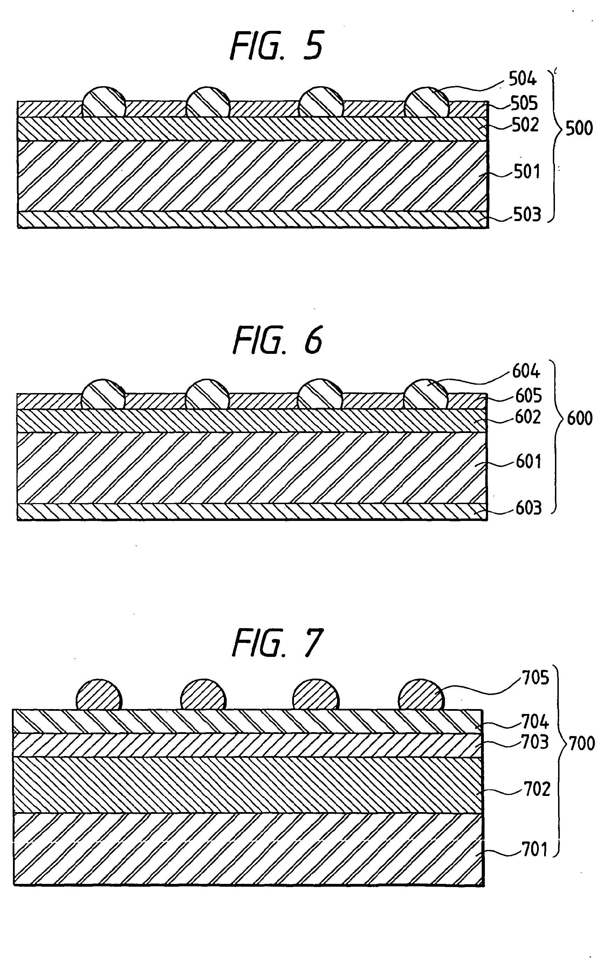

Fig. 5 shows a cross section of a monocrystal silicone solar cell. 501 is the semiconductor layer consisting of the silicone wafer substrate, 502 is the semiconductor layer which forms a pn junction with the semiconductor layer 501, 503 is the rear face electrode, 504 is the collecting electrode and 505 is the low reflection coating.

Fig. 6 shows the cross section of a polycrystalline silicone solar cell, 601 is a semiconductor layer consisting of a silicon wafer substrate, 602 is a semiconductor layer which forms a pn junction with semiconductor layer 601, 603 is the rear face electrode, 604 is the collecting electrode and 605 is the low reflection coating.

Fig. 7 shows the cross section of a thin film polycrystalline silicon solar cell, 701 is the substrate, 702 is the polycrystalized semiconductor layer, 703 is the semiconductor layer which forms a pn junction with semiconductor layer 702, 704 is the rear face electrode, 705 is the collecting electrode and 706 is the low reflection coating.

Figs. 8A and 8B show the solar cells shown in Figs. 4A to 4C through 7, from the light entry side. 801 is the substrate, 802 is the positive electrode, 803 is the negative electrode and 804 is the collecting electrode.

The structure of the "photovoltaic element" in this invention, is desirable to consist of, for example, a semiconductor layer which contributes to electricity generation, a transparent conductive layer installed on the light entry side of the semiconductor layer, a collecting electrode consisting of the metal wire and conductive adhesive on the transparent electrode and a rear face electrode installed on the side opposite of light entry of the semiconductor layer.

The semiconductor layer is required to have a structure which possesses semiconductor junctions, such as pn junction, pin junction or Schottky splicing, etc. Materials suitable for this purpose are, for example, semiconductors in the group IV, such as crystalline silicon, polycrystalline silicone and amorphous silicon, semiconductors in the group II-VI, such as Cds and CdTe, or semiconductors in the group III-V, such as GaAs.

In the photovoltaic element of this invention, the collecting electrode is positioned on the light entry side of the semiconductor layer, positioned in a parallel configuration, with appropriate spacing. The electrode in this invention is particularly suitable for the formation of photovoltaic elements with large areas. For example, when producing a 30 cm x 30 cm photovoltaic element, collecting electrodes can be formed by placing electrodes, consisting of metal wires 30 cm in length and conductive adhesive, on the semiconductor layer at specified intervals. Furthermore, for the purpose of sending electric currents from the collecting electrode to one terminal, a bus bar electrode of relatively large capacity is to be formed.

The rear face electrode of the photovoltaic element stated in this invention is one that is installed on the rear face of the semiconductor layer, the metal of which is formed, for example, by screen printing or deposition. The type of metal used, should be chosen from one that offers good ohmic contact with the semiconductor.

When the semiconductor layer is made of a thin film consisting of monocrystal semiconductors containing amorphous silicon, microcrystal silicon or polycrystalline silicon based substances, it will need a subsidiary substrate. Both insulative and conductive substrates may be used for the subsidiary substrate. Substrates of metals, such as stainless steel or aluminum are suitable for use and these also function as the rear face electrode. When insulative substrates, such as glass, polymer and ceramics, etc. are used, metals such as chrome, aluminum or silver are to be depositioned to create the rear face electrode. The lower electrode 402 is an electrode on one side to retrieve the power generated in the semiconductor layers 403, 404, 405, 413, 414, 415, 423, 424 and 425, and is required to possess a work function that will create an ohmic contact with semiconductor layer 403. Materials used are, for example, metals or alloys, and transparent conductive oxides (TCO), such as A1, Ag, Pt, Au, Ni, Ti, Mo, W, Fe, V, Cr, Cu, nichrome, SnO₂, In₂O₃, ZnO or ITO, etc. It is desirable that the surface of the lower electrode is smooth, but it may be textured if it is a cause of irregular reflection of light. Also, if substrate 401 is conductive, there is no need for a lower electrode 402. The lower electrode may be formed with well-known methods, such as plating, depositioning or spattering.

Not only are single structure with n-layer 403, i-layer 404 and p-layer 405 as one set suitable for the amorphous silicone semiconductor layer, but so are double or triple structure consisting of two or three sets of pin or pn junctions. Materials such as a-Si, a-SiGe and a-Sic, or the so called group IV and group IV alloy-type amorphous semiconductors, are suitable in particular, for the semiconductor material used for the i-layers 404, 414 and 424. Methods such as depositioning, spattering, high-frequency plasma CVD, microplasma CVC, ECR, heat CVD, and LPCVD methods, for example, can be used for the film formation of the amorphous semiconductor layer if desired. Transparent conductive film 406 is required when the sheet resistance is high, such as is the case with amorphous silicone. And because it is positioned on the light entry side, it is required to be transparent. Materials such as SnO₂, In₂O₃, ZnO, CdO, CdSNO₄ and ITO, for example are suitable for the transparent conductive film 406.

As for monocrystal silicone solar cell 500 and polycrystalline silicon solar cell 600, a subsidiary substrate is not installed and the monocrystal wafer 501 and polycrystalline wafer 601 act as the substrates. The monocrystal wafer 501 is made by cutting, etc. an Si ingot which is pulled up with the CZ method. The polycrystalline wafer 601 is formed by cutting an Si ingot obtained with the cast method or by obtaining a polycrystal in sheet form using the ribbon method. For example, the vapor phase diffusion method using POC 13, the coat diffusion method using TiO₂, SiO₂ or P₂O₅, or the ion placing method which dopes it directly in ions is used to make semiconductor layers 502 and 602. The rear face electrodes 503 and 603 are made by forming metal films with deposition or spattering, or by screen printing of silver paste. The low reflection coating 504 and 604 are formed to prevent the loss of efficiency, caused by light reflecting off of the solar cell surface. Suitable materials are, for example, SiO₂, Ta₂O₅ and Nb₂O₅.

The thin film polycrystal 700 is formed by growing Si polycrystal thin film 702 on substrate 701 made of alumina or graphite, etc. And in some cases, a particle diameter enlargement process is conducted, after which this is used as a substrate once again, onto which the base layer is formed, on top of which the surface layer 703 is formed using the epitaxial growth process. Low cost substrates, such as metal Si may be used for substrate 701.

The second electrode consisting of the collecting electrode of this invention is positioned on the light entry side of the semiconductor layer. It is desirable that they be positioned in appropriate intervals, so that the sum of the loss caused by the electric resistance of current collecting and shadow loss is minimam. For example, if sheet resistance is approximately 100 ohms/□, the desired intervals of the collecting electrodes would be about 5 mm. Also, optimization by narrowing pitch for thin diameter wires and widening pitch for thicker diameter wires will offer optimum efficiency.

The electrode in this invention is particularly suitable for the formation of solar cells with large areas. For example, when producing a 30 cm x 30 cm solar cell, collecting electrodes can be formed by placing electrodes of this invention, on the semiconductor layer at specified intervals. Furthermore, for the purpose of sending electric currents from the collecting electrode to one terminal, a tab may be positioned as the collector.

A solar cell produced in this manner is encapsulated using a well-known process, for better weather resistance and to maintain its mechanical strength, and is modularized for outdoor use. In specific terms, with regard to the materials used for encapsulation, EVA (ethylene vinyl acetate), etc. is suitable for the adhesive layer. It is also acceptable to impregnate EVA in clay glass, etc. to improve mechanical strength. In addition, a fluoride resin is laminated as a surface protectant to improve moisture and scratch resistance. Suitable materials are for example, a polymer of tetrafluoroethylene (TFE), a copolymer (ETFE) of tetrafluoroethylene and ethylene, polyvinyl fluoride and polychloro fluoroethylene (CTFE), etc.. It is also acceptable to improve their weather resistance by adding ultraviolet ray absorbers to the resin. As for the method of laminating these resins with the solar cell substrate, heating and compression in a vacuum, using a commercially available device, such as vacuum laminator, for example, can be used.

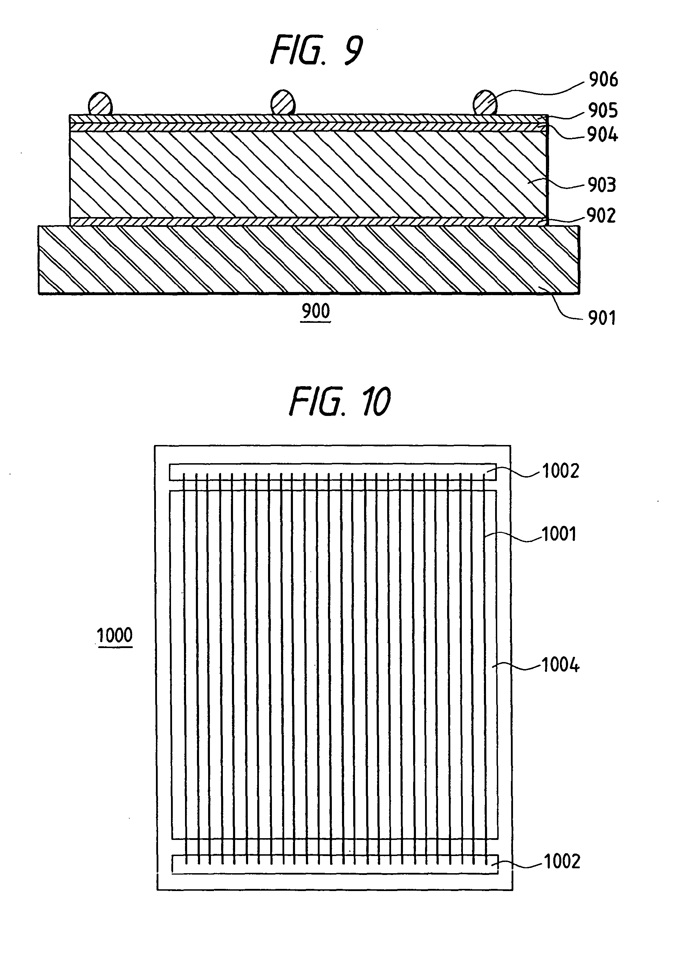

Fig. 9 is a typical cross section showing an example of the photovoltaic element. In Fig. 9, 901 is the subsidiary substrate, 902 is the rear face electrode, 903 is the p-type semiconductor layer, 904 is the i-type semiconductor layer, 905 is the n-type semiconductor layer, 906 is the light receiving plane electrode and 907 is the collecting electrode.

Fig. 10 is a type diagram of a photovoltaic element module 100, using a "collecting electrode coated with conductive adhesive consisting of two layers (hereinafter abbreviated as: two-layer coated collecting electrode)" of this invention. In Fig. 10, 1001 is the photovoltaic element substrate, 1002 is the positive electrode, 1003 is the negative electrode and 1004 is the two-layer coated collecting electrode of this invention. Photovoltaic element substrate 1001 is made by forming films of p, i and n semiconductor and transparent conductive layers on the stainless steel substrate, using the CVD or spattering process. The positive electrode 1002 is an electrode which is used to retrieve the current collected by the collecting electrode and materials suitable for this are, for example, copper or silver plated copper which offer good conductance. The negative electrode 1003 is an electrode which is used to retrieve current from the stainless steel substrate and the material suitable for this would also be copper. The two-layer coated collecting electrode 1004 has the function of collecting the current generated by the photovoltaic element substrate. The two-layer coated collecting electrode 1004 is mechanically and electrically connected to the photovoltaic element substrate and the positive electrode by means of the thermocompression process.

In terms of the method by which the metal wire is positioned as the collecting electrode on the photovoltaic element; for example, when more than one wires are to be positioned on the surface of the photovoltaic element surface; optimum efficiency can be obtained with optimization procedures, namely narrowing the pitch for thin wires and widening the pitch for thicker wires.

As for the method of adhesion, the outer most layer of the collecting electrode must not be cured during application on the wire and only be dried of the solvent. And heated when adhering to achieve adhesion and curing.

### (Production method)

One method of production of the photovoltaic element of this invention is, for example the production method of photovoltaic cells described below.

It is desirable to adhere the collecting electrode to the semiconductor or the transparent electrode of the light entry side with heat and/or pressure.

The desirable heating temperature would be the softening point of the adhesive layer and the conductive resin of the second layer, which will form the adhesive layer. It is desirable that only the adhesive layer and the second layer will be softened to make the collecting electrode adhere to the solar cell, without softening the first layer to maintain the initial film thickness. Also, if block isocyanate is used as the curing agent for the conductive resin, it is desirable to apply temperatures exceeding the dissociation temperature of isocyanate, so that curing will occur during the adhesion process.

The desirable pressure will be such that the adhesive layer and said second layer will undergo moderate deformation, but must also be lower than any pressure that will destroy the solar cell. In specific terms, 0.1kg to 1.0 kg/cm² would be suitable for solar cells with thin films, such as amorphous silicon.

If the adhesive layer and the second layer, which will form the adhesive layer, are of the hot-melt type, the desirable adhesive method would be to soften them and adhering them to the solar cell. Suitable pressure may be applied during adhering. If the second layer is thermoplastic, it will soften with heat. For heat curing resins, it is acceptable to dry the solvent, leaving the resins uncured during the application process to the wire for them to be heat cured during adhesion.

Also, the collecting electrode of this invention and the photovoltaic elements using the collecting electrode and their production method are entirely applicable to the photovoltaic elements other than the solar cell.

### (Curing agents to be included in the conductive adhesive)

One of the problems of production is that, in order to produce coated wire electrodes off-line and to facilitate storage until the formation of electrodes, it is difficult to control accelerated hardening of the resins, after the resin has been coated and dried on the metal wire. By using block isocyanate as the curing agent, only the solvent contained in the resin is dried during and after the coating drying process, and by heating it at a constant temperature, the block agent dissociates, allowing active isocyanate radicals to react with the resin to achieve hardening. In other words, whereas it has been very difficult to control accelerated hardening with other curing agents, such problems are solved by using block isocyanate as the curing agent.

### (The glass transition point of the conductive adhesives)

Another production related problem was, that it is convenient for handling if the metal wires are wound to a bobbin, etc. after the resin has been coated, however, the tackiness of the coated wires themselves made it difficult to unwind them from the bobbin and in some cases where tackiness was strong, the coating would peel off. This occurs when the glass transition point of the coating layer resin is low. By using resins with glass transition points of over 0 °C, the effects of tackiness reduction can be felt, but better results are obtained when the glass transition temperature is over 100 °C. Also, by mixing polymers with different glass transition points, it becomes possible to form coating layers with superior properties in terms of flexibility, adhesion and reduced tackiness. Preferable combinations are urethane resin and phenoxy resin, etc.

### (The average particle diameter of primary particle of conductive particles)

To obtain stably a coating layer with uniform film thickness and good conductivity, the dispersibility of conductive particles into resin becomes important as well as the selection of high polymer. Although the diameter of a conductive particle should be formed smaller than the thickness of conductive coating layer, too small diameter increases resistance at the surface of particles where they contact each other, making it impossible to obtain the desired resistivity. When the conductive particles are dispersed into the resin, agglomerated particles exist; such as primary particles which are systematically agglomerated crystallites, secondary particles which consist of primary particles agglomerating with particles' surface charge or van der Waals force or with other force. If the dispersibility is poor, agglomerated particles of a high order would exist to cause not only ununiform film thickness but also unstable conductivity. This invention has solved the problem by making the average diameter of primary particles of conductive particles in the coating layer bigger than 0.02 µm and smaller than 15 µm, the sizes which prevent formation of agglomerated particles of a higher order. As the method to measure particles' agglomerating state in dispersion and particles' diameter (generally called 'grading'), there are the laser diffraction method, the light-particle correlation method, the light scattering method etc.

The suitable conductive particles for the coating layer are graphite, In₂O₃, SnO₂, TiO₂, ITO, ZnO, and oxide semiconductor materials made from the materials by adding suitable dopants. The conductive particles and the polymer are mixed at a suitable ratio to obtain the desired resistivity. Although increased conductive particles reduce resistivity, they decrease the ratio of resin resulting in poor stability as coating film. Therefore, a suitable ratio should be properly selected considering what kind of high polymer and conductive particles will be used and what physical property value is desired for the film. Going into detail, around 5 volume percent to 95 volume percent of conductive particles give good resistivity. When the conductive particles and polymer are mixed, ordinary dispersing methods, such as a three-roll-mill or a paint shaker etc., can be used. During or after the dispersion, the conductive paint can be diluted with a suitable solvent to adjust viscosity.

### (The thickness of coating layer composed of conductive adhesive)

A problem during and after the formation of electrodes on a photovoltaic element is forming of pinholes which causes leakage current to defective parts reducing the characteristics of the photovoltaic element. However, this problem is solved by forming coated layers precisely and forming coating layers with sufficient thickness. The thickness of the coating layer varies with the diameter of the metal wire or characteristics desired. For example, when the metal wire is 100 µm in diameter, to have sufficient function as a barrier layer against leakage current, at the same time not to cause extreme shadow loss, the suitable thickness is between 1 µm and 30 µm. Another problem is, while forming of electrodes, metal wires touch the solar cell substrate to cause shunt. The solution to this problem is to form more than 2 of coating layers, and to harden completely the innermost layer of the coating layer while coating. In this way, metal wires are prevented from direct contact with the solar cell substrate during the compression process. The problems, such as migration etc., which occur when a photovoltaic element is used outdoors, can be solved by separating functions into layers; by preparing more than 2 layers of coating layers to share the functions such as current collecting, shunt prevention, migration prevention, electrode fixing, etc.

Fig. 2A shows the sectional plan of an electrode with conductive coating layer on. Fig. 2C shows the sectional plan of the part where the electrode is fixed on a photovoltaic element substrate through the coating layer. In Fig. 2A and Fig. 2C, 201 is the metal wire, 202 is the primary coating layer which is directly coated on the metal wire, 203 is the secondary coating layer which forms the outermost layer, 205 is the coating layer (the whole) composed of conductive adhesive, and 206 is the photovoltaic element substrate. Coating of conductive coating layers is desired to be made cocentrically. As the method to coat the conductive resin on the metal wire, the ordinary spreading method of insulating coating film, the method used for enameled wire, can be suitably used. Going into detail, the conductive resin is diluted with a solvent to obtain suitable viscosity, then coats the metal wire with a roll coater, etc. The coated wire is passed through the dice to form a desired thickness, and is put in a furnace for drying the solvent and heat curing.

### (Components of photovoltaic element)

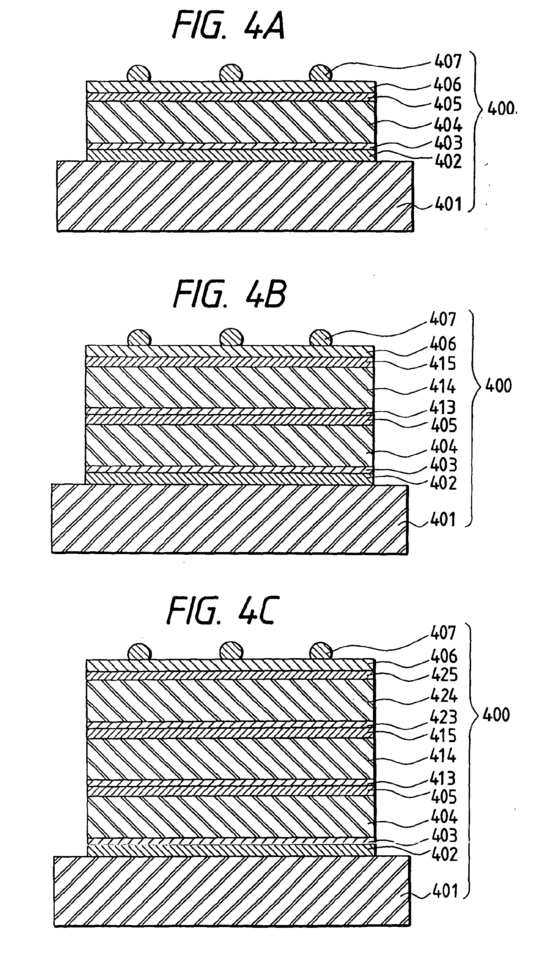

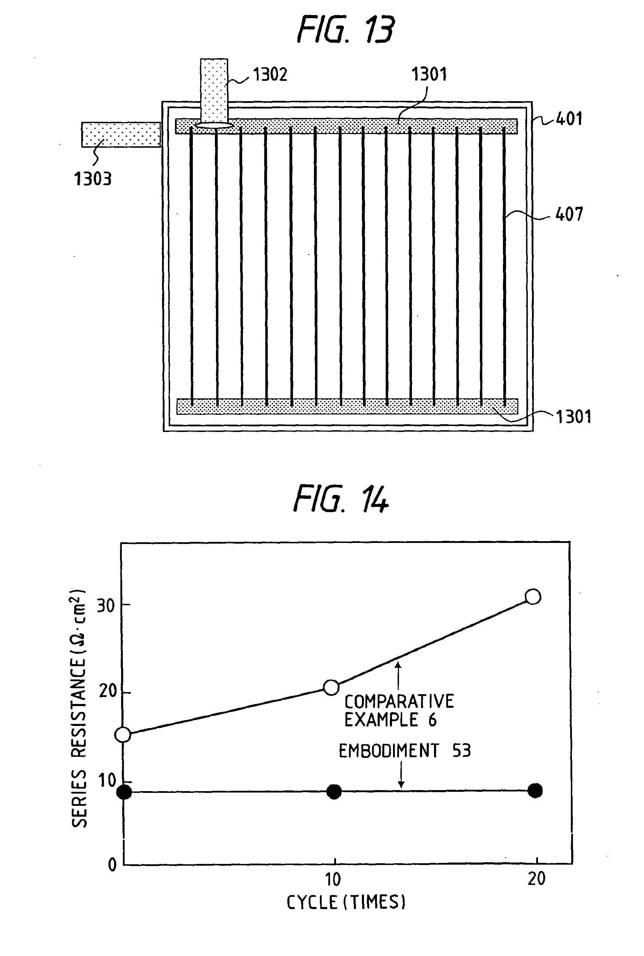

In the following part, the components of photovoltaic element will be explained according to the invention, using Fig. 4A, Fig. 4C, and Fig. 13. Fig. 4A shows an amorphous silicon solar cell which has single cell structure with the light incidence on the other side of the substrate. Fig. 4C shows an amorphous silicon solar cell which has a triple structure of the solar cell in Fig. 4A. Fig. 13 shows the solar cells when looked at from the side of light incoming side shown in Figs. 4A and 4C. Grid electrodes of about 30 cm long are seen formed.

Although no illustrations are shown, it goes without saying that the composition according to the invention's idea can be applied to amorphous silicon solar cells which are accumulated on a transparent insulated substrate, and also to monocrystalline and thin-film polycrystalline solar cells.

In Fig. 4A, 401 shows the subsidiary substrate, 402 shows the lower electrode, 403, 404, and 405 respectively show the semiconductor layer which form pin-junction, 406 shows the upper electrode of transparent conductive film, and 407 shows the grid electrode using collecting electrode.

In Fig. 4C, 403, 404, and 405 show the semiconductor layers which form the first pin-junction, 413, 414, and 415 show the semiconductor layers which form the second pin-junction, 423, 424, and 425 show the semiconductor layers which form the third pin-junction.

In Fig. 13, 1301 shows the metal tab, 1302 shows the output port of anode, and 1303 shows the output port of cathode.

### (Substrate)

The substrate 401 according to the invention is a membrane which mechanically supports semiconductor layers 403, 404 and 405 which are a thin film solar cell such as non-crystaline silicone. It is also used as an electrode in some cases. The substrate 401 has a required heat resistance to the heat temperature for forming film of semiconductor layers 403, 404 and 405. However, both the one having the electroconductive property and the one having an electro insulating property can be used. As electroconductive material, such metals as Fe, Ni, Cr, Al, Mo, Au, Nb, Ta, V, Ti, Pt, Pb and Ti are used; these alloys, for example, brass and stainless steel thin plate and its complex, carbon sheet and zinc plated steel plate are among those that can be used. As electro insulating material, film or sheet of heat resistant resin such as polyester, polyethylene, polycarbonate, cellulose acetate, polypropylene, polyvinylchloride, polyvinylidenechloride, polystyrene, polyamide, polyimide and epoxy resin are used. Or the compound with the resin and glass fiber, carbon fiber, boron fiber, metal fiber are among those also cited. And on the surface of the thin metallic plate and resin sheet, a coating treatment with foreign material metal thin film and/or insulating thin film of SiO₂, Si₃N₄, Al₂O₃, AlN, etc., is carried out by a sputtering, vapor deposition and plating method. Glass and ceramic are also cited.

### (Lower electrode)

According to the invention, the lower electrode 402 is one electrode to take out the electric power generated at semiconductor layers 403, 404, and 405. It is required to have such a work function as to form an ohmic contact to the semiconductor layer 403. As its materials, for example, Al, Ag, Pt, Au, Ni, Ti, Mo, W, Fe, V, Cr, Cu, stainless steel, brass, nichrome, SnO₂, In₂O₃, ZnO, ITO, etc. are used as simple metallic substances or as their alloys or as transparent conductive oxides (TCO), etc. Although the surface of the lower electrode 402 is desirable to be smooth, the surface can be textured to cause diffused reflection of light. When the substrate 401 is conductive, the lower electrode 402 is not necessarily to be prepared.

The methods to prepare the lower electrode are plating, deposition, spattering etc. As the methods to prepare the upper electrode, there are the ohmic-resistance heating deposition method, the electron beam heating deposition method, the spattering method, the spraying method etc. to choose the desired.

### (Semiconductor layer)

According to the invention, the named semiconductor layers are amorphous silicon, polycrystalline silicon, monocrystalline silicon, etc.. In an amorphous silicon solar cell, the semiconductor materials to compose i-layer 404 are; a-Si:H, a-Si:F, a-Si:H:F, a-SiGe:H, a-SiGe:F, a-SiGe:H:F, a-SiC:H, a-SiC:F, a-SiC:H:F, etc. The named are, what is called, IV group and the IV group's alloy-amorphous semiconductor. The semiconductor materials to compose p-layer 405 or n-layer 403 are obtained from the semiconductor materials for the i-layer 404 by doping valence electron control agent. As the materials for valence electron control agent to obtain p-type semiconductor, the compounds of elements in group III of the periodic table are used. Elements in group III are B, Al, Ga, and In. As the valence electron control agent to obtain n-type semiconductor, the compounds of elements in group V of the periodic table are used. The elements in group V are P, N, As, and Sb.

The methods to form films of amorphous silicon semiconductor layers can be chosen whatever desired from the well known methods such as the deposition method, the spattering method, the RF plasma CVD method, the microwave plasma CVD method, the ECR method, the thermal CVD method, the LPCVD method, etc. Industrially, the RF plasma CVD method is favorably used, in which the material gas is decomposed with RF plasma and accumulated on the substrate. However, the RF plasma CVD method has problems such as the low yield in the material gas decomposition (about 10 %) and the slow accumulating speed (about 0.1 nm/sec. to 1 nm/sec.). The microwave plasma CVD method is attracting attention as an improved method for these problems. As the reactor to do the film formation, well known devices, such as the Batch reactor or a continuous film formation device, etc., can be used whatever desired. The invented solar cell can also be used for, what is called, tandem cell or triple cell, in which more than two semiconductor splices are laminated in order to obtain better spectral sensitivity and higher voltage.

### (Upper electrode)

According to the invention, the upper electrode 406 is the electrode to take out electromotive force generated at the semiconductor layers 403, 404, and 405. It makes the pair to the lower electrode 402. The upper electrode 406 is necessary for semiconductors with high sheet resistivity, such as amorphous silicon. Because crystalline solar cells have low sheet resistivity, they do not necessarily need the upper electrode. The upper electrode 406 is positioned on the light incoming side and it needs to be transparent, and it is also called the transparent electrode. The upper electrode 406 is desirable to have more than 85 % of transmissivity for effective absorption of light from the sun and daylight fluorescent lamps etc. into semiconductor layers. Electrically, the upper electrode 406 is desirable to have a sheet resistivity value of less than 100 Ω/□ to let the electric current generated with light flow horizontally to the semiconductor layers. Materials with these characteristics are the metal oxides of SnO₂, In₂O₃, ZnO, CdO, CdSnO₄, ITO, etc.

### (Grid electrode)

The grid electrode 407 consists of the metal wire 201, as shown in Fig. 2A, and the conductive coating layer 205. The conductive coating layer 205 needs to have resistivity value which is low enough not to reduce the efficiency of photovoltaic element and at the same time high enough to prevent shunt. That is, it does not act as resistance to the electric current generated by solar cells, but works as resistance to prevent serious leakage when any defect is around. The suitable resistivity value for the conductive coating layer 205 depends on the design of the grid, and on the photovoltaic element's electric current value and the scale of defect at its operating point. The desirable resistivity value is 0.1 - 100 Ωcm. When shunt occurs in this range, the value becomes sufficient resistance, and at the same time, this value is almost negligible to the electric current generated at the photovoltaic element. The grid electrode 407 is positioned on the light incoming surface side of the photovoltaic element 400 (shown in Fig. 4A). As the grid's arrangement, the parallel arrangement with suitable intervals is recommendable. The invented collecting electrodes are particularly suitable for forming a solar cell with large area. For example, when solar cell of 30 cm² is built, all needed is to install the invented collecting electrodes of 30 cm long parallel on the semiconductor layer with prescribed intervals. Furthermore, because the electrode is composed to reduce the current leakage caused by shunt or leaks, it is suitable for amorphous silicon solar cells. However, such composition is, of course, applicable to other types of solar cells than amorphous silicon type; to the solar cell of monocrystalline, polycrystalline, or of other semiconductors than silicon, or of Shottky splicing type.

### (Tab)

According to the invention, the tab 501 is the collector which collects the flowing current at the grid electrode 407 to one end. As the materials for the collector, metals like Cu, Ag, Pt, and alloys of these metals are usable. The desirable shapes are sheets, tapes, or foils to be glued with adhesive agents.

### (The method to form the collecting electrode on the photovoltaic element)

According to the invention, as "the method to form the collecting electrode on the photovoltaic element", the following method is illustrated as how to build solar cells.

The collecting electrodes are desirable to be glued on the light incoming side of the semiconductor layer or on the surface of the transparent conductive film, using heat, pressure, or both.

The favorable heating temperature is to higher than the softening point of the outermost coating layer, which is to become the glueing layer, and of the high polymer which forms the coating layer. When the conductive resin's hardening agent is composed of block isocyanates, it is desirable to keep the temperature higher than the block isocyanate's dissociation temperature, then let the resin cause heat curing while glueing process.

The favorable pressure should be high enough to suitably transform the glueing layer, the outermost layer of the coating layer, but should be lower than the pressure which keeps the solar cell without damaging. Going into detail, for example, for a film-type solar cell, such as amorphous silicon, a pressure of 0.1 kg/cm² to 1.0 kg/cm² will be suitable.

As the glueing method, when the glueing layer, the outermost layer of the coating layer, is hot-melt-type, it is desirable to be glued to the solar cell by softening with heat. While glueing, a suitable pressure can be applied.

### (Encapsulation)

The solar cell made by the abovementioned method is modularized by well-known encapsulation in order to improve weather resistance and mechanical strength. As encapsulation material, adhesive layer is concerned, EVA (ethylene vinyl acetate) is favorably used from the point of adhesive property to solar cell, weather resistance and buffer effect. In order to improve further moisture resistance and anti scratching property, a fluorine resin is laminated as a surface protecting layer. For example, 4 fluoro ethylene copolymer TFE (Du Pont TEFLON), copolymer of 4 fluoroethylene and ethylene ETFE (Du Pont TEFZEL), polyvinyl fluoride (Du Pont TEDLER), polyvinyl fluoride (Du Pont TEDLER), polychlorofluoroethylene CTFEC Daikin Industries Neoflon) are cited. Weather resistance can also be improved by adding well-known UV absorber.

As the method for encapsulation, for example, it is desirable to use well known devices such as the vacuum laminater, for thermocompression bonding of the solar cell substrate and the resin film in a vacuum.

### (Embodiment)

The following is the detailed and embodied explanation of this invention's "the collecting electrode, the photovoltaic element with the collecting electrodes, and their building process". However, this invention shall not be limited by these embodiments.

Firstly, in Embodiments 1 - 40 and Examples for Comparisons 1 - 2, a detailed discussion is given on "the case when conductive adhesive is composed of conductive particles and high polymer".

Secondary, in Embodiments 41 - 46 and Examples for Comparisons 3 - 4, a detailed discussion is given on "the case when the coating layer is composed of at least more than 2 layers, and at least the conductive adhesive, which forms the outermost layer of the coating layers, is composed of not yet hardened but heat curing high polymer".

Furthermore, in Embodiments 47 - 55 and Examples for Comparisons 5 - 6, a detailed discussion is given on "the case when the conductive adhesive contains coupling agent".

Concerning Embodiments 1 - 40 and Examples for Comparisons 1 - 2, the following information is collected and shown in Tables 9 - 16; the formative conditions of the collecting electrode, the solar cell structure, and the characteristic evaluation results of solar cells.

### (Embodiment 1)

In this embodiment, an explanation is given on the case when a collecting electrode is composed of Cu wire, carbon black, and urethane.

As Fig. 1A shows, the collecting electrode 100 of this invention was formed as follows. As the metal wire 101, copper wire of 100 µm in diameter was used.

The carbon paste, to form conductive adhesive for the coating layer 102, was prepared as follows. First, a mixed solvent of ethyl acetate 2.5 g and IPA 2.5 g was placed in a shake bottle for dispersion. Next, 22.0 g of urethane resin, the main ingredient, was added into the shake bottle, and all was mixed thoroughly with the ball mill. The number average molecular weight of urethane resin was 3000. Then, 1.1 g of block isocyanate, as a hardening agent, and 10 g of glass beads, for dispersion, were added to the solution. Then, as conductive particles, 2.5 g of carbon black of 0.05 µm in average primary particle diameter was added to the solution.

The shake bottle containing the materials was placed in a paint shaker, of Toyo Seiki Co., for 10 hours for dispersion. Then glass beads for dispersion were removed from the prepared paste. The average particle diameter of the paste was measured to be about 1 µm. The results of using the beads mill instead of a paint shaker were almost the same.

The paste was hardened at 160°C for 30 minutes, the standard hardening condition of the hardening agent. Its volume resistivity was measured to be 0.6 Ωcm to prove being low enough.

The void ratio of the paste was measured by a mercury Polosimeter to be 0.01 ml/g. Then, carbon black was removed from the paste and only resin was hardened to form a sheet. Its gel ratio was measured to be approximately 100 %.

The coating layer 102 was formed as follows, using a vertical wire-coating machine 300 shown in Fig. 3.

First, the delivery reel 301 was set with a reel which is wound with metal wire 307. Next, the metal wire was stretched toward the take-up reel 310. Then, the paste was poured into the coater.

The coating speed was 40 m/min, and the residence time was 2 seconds. The drying furnace 306 was set at 120°C. The coating was done 5 times. The dice, the one for enamel coating, were used in a variety of diameters, from 110 µm to 200 µm in order. Under this condition, the paste was preserved, with solvent evaporated and in unhardened state. The thickness of the coating layer 102 was 20 µm on average. Variations in the film thickness after coating were within ±0.5 µm per 100 m.

As an embodiment of this invention, an amorphous solar cell 400 was built. It had the layer composition shown in Fig. 4C and pin-junction-type triple structure with grid electrodes of 30 cm long.

First, an SUS 430 BA substrate 401 was thoroughly degreased and washed, then was placed in a DC spattering device (not illustrated) to accumulate 450 nm of Ag followed by 1000 nm of ZnO. Thus the lower electrode 402 was formed. The substrate was taken out and placed in a microwave plasma CVD film formation device (not illustrated) to form in order of silicon layer as the n-layer 403, silicon-germanium layer as the i-layer 404, and silicon layer as the p-layer 405. Thus the bottom layer was formed. Then, in the same way, the middle layer was formed in order of silicon layer as the n-layer 413, silicon-germanium layer as the i-layer 414, and silicon layer as the p-layer 415. The top layer of the silicon layer was formed in order of the n-layer 423, the i-layer 424, and the p-layer. Thus, the semiconductor layer was accumulated. Then, it was placed in the spattering device (not illustrated) to form 70 nm of ITO film, the transparent conductive film 406, which also has low reflectance function. Then, the solar cell substrate 401 was trimmed into the size of 30 × 30 cm with an effective area of 900 cm² by removing unnecessary part of transparent conductive film, using etching paste, whose main ingredient is ferric chloride, and a printer on the market.

Then, out of the effective area, the anode 802 and the cathode 803, both of hard copper, were prepared. As the collecting electrode 805, the coated wire 100 was stretched between the both anode 802 at 6 mm intervals and to be within the effective area, then was fixed with an ultraviolet-ray hardening adhesive.

The fixed said coating wire 100 was bonded by thermocompression, using a heating device (not illustrated), to form the collecting electrode 804 on the cell surface of the solar cell substrate 401 and on the anode 802. Thus, a triple-cell of 30 × 30 cm, shown in Fig. 8A, was built. The heating condition was; at 200°C, for 45 seconds, and at the pressure of 1 kg/cm².

The encapsulation of this sample was done as follows. On the top and bottom of the solar cell substrate 801, plane glass and EVA were laminated, and fluorine-contained resin film ETFE (Tefzel of Du Pont) was laminated further on the top and bottom of it. Then, the substrate was placed in a vacuum laminater and laminated at 150°C for 60 minutes.

In the same method, 50 solar cell modules were built.

The initial characteristics of the obtained sample were measured as follows. First, the voltage/current characteristics were measured in the dark state. The shunt resistivity was measured at the slope near the home position to be 200 kΩcm² to 500 kΩcm², favorable results. Next, the solar cell characteristics were measured, using pseudo solar light source (hereafter called simulator) with quantity of light of 100 mW/cm² by the AM 1.5 global sunlight spectrum. The obtained conversion efficiency was 9.6 % + 0.02 %, showing favorable characteristics with little variations. The series resistivity was 32.0 Ωcm² on average, also a favorable value. The yield rate of normal I-V curve was favorable 94 %.

The reliability test was given to these samples in conformity with the Japanese Industrial Standards C 8917; the environmental testing method for crystalline solar cell modules, and the hygrothermal cycle test A - 2 provided by the endurance testing method.

The samples were placed in a thermo-hygrostat, which can control temperatures and humidity, and repeated 20 times of cycle tests varied between -40°C and +85°C (with relative humidity 85 %). Then, the samples, which completed the cycle test, were measured their solar cell characteristics in the same way as the initial characteristics were, using the simulator. Its conversion efficiency was lower 2 % on average than the initial value, showing no occurrence of meaningful deterioration.

The results of this embodiment show that a solar cell, with collecting electrodes of the metal wire coated with the invented conductive adhesive, has favorable characteristics and high reliability.

### (Example for Comparison)

In this example, as a conventional example, an explanation is given on the case when the collecting electrode consists of Cu wire with fluorine-contained resin paste containing carbon.

For comparison, the conventional collecting electrode 100 was built in the same way as in Embodiment 1, in Fig. 1A, with the following exceptions.

The paste, used for the coating layer 102 of the collecting electrode 100 in Fig. 1A, was a fluorine-contained resin paste (Electrodag +502 SS of Acheson Colloid), similar to the one mentioned in the U. S. Patent No. 4,260,429.

The wire was coated in the same way as in Embodiment 1. The thickness of the coating layer 102 was 20 µm on average, and the deflection of film thickness in 100 meter long was over ±1.0 µm after coating.

The paste was hardened at 120°C for 5 minutes, the standard hardening condition for the hardening agent. The volume resistivity was measured to be 0.1 Ωcm², a low enough value. The hole volume of this conductive adhesive was 0.05 ml/g. Then, like in Embodiment 1, 50 solar cell modules were built, using this wire as collection electrodes.

The initial characteristics of the obtained sample were measured in the similar method to Embodiment 1. First, the shunt resistivity was measured to be 4 kΩcm² - 300 kΩcm², showing a wide variation. Next, the conversion efficiency was obtained to be 9.0 % ±1.2 %, varying widely. The series resistivity of normal 1 - 1 V curve was obtained to be 32.1 Ωcm² on average, a favorable value. The initial yield rate of normal I - V curve was as low as 64 %.

The reliability test was done to this sample similarly to Embodiment 1. The tested sample was measured its solar cell characteristics with the simulator similarly to the initial characteristics. The result was on average 11 % lower than the initial conversion efficiency, showing the occurrence of meaningful deterioration. The series resistivity was measured to have risen to 62 Ωcm² on average. This indicated that the rise of the series resistivity caused the deterioration of the conversion efficiency.

It is supposed that the outside humidity entered into the device to raise the interfacial resistivity in the contacting part of the paste in the adhesive interface of coating layer and transparent conductive film surface.

This result showed that the solar cell using the invented collecting electrodes have a good initial yield rate and favorable reliability.

### (Embodiment 2)

In this example, an explanation is given on the case when the collecting electrode consists of Cu wire, ITO, and butyral.

In this case, the same process was used to build collecting electrodes as in Embodiment 1, except that , for the invented collecting electrode 100 according to the invention shown in Fig. 1A, butyral resin (Slec BL - S of Sekisui Chemical Co., Ltd.) was used as the main ingredient high polymer to form conductive adhesive, and that ITO powder (HYX of Sumitomo Metal Mining Co., Ltd.) of 0.05 µm in the average primary particle diameter was used as conductive particles.

The above-described paste was hardened at the temperature of 160 °C for thirty minutes which were the standard hardening condition of the above-described hardener and then was measured in its volume resistivity, and it was verified that its volume resistivity was low enough because the measured value was 1.2 Ω cm². Further, transmittance of light was measured using a spectroscope and its transmittance was satisfactory because the measured value was 90% per 400 nm. The volume of a hole of this conductive adhesive agent was 0.02 ml/g and the ratio of gel was 20%. The average molecular weight of polymeric resin was fifty thousand.

Wire was coated as the first embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.7% ± 0.05%, its shunt resistance was 250 to 300 kΩ cm², its series resistance was 32.5 Ω cm² on average. The yield rate of samples of which I-V curve was normal was satisfactory because it was 94%.

The reliability test of these samples was performed by the same method as that in the first embodiment. Next, the solar battery characteristics of the samples after the test was finished were measured using a simulator as in measurement of initial values, and its measured conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 3)

Referring to this embodiment, the case that a collecting electrode comprises Ag wire, urethane and SnO₂ will be described.

In this embodiment, a collecting electrode 100 according to the invention shown in Fig. 1A is produced as the first embodiment except that a metallic wire 101 is formed by silver, and SnO₂ powder manufactured by Mitsui Mining and Smelting Co., Ltd. of which average primary particle diameter is 0.2 µm is used as a conductive particle forming a coated layer 102.

The above-described paste was hardened at the temperature of 160 °C for thirty minutes which were the standard hardening condition of the above-described hardener and then, was measured in its volume resistivity, and it was verified that its volume resistivity was low enough because the measured value was 1.0 Ω cm². Wire was coated as the first embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.1% ± 0.06%, its shunt resistance was 250 to 400 kΩ cm², its series resistance was 32.9 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2.5% on average than the initial conversion efficiency, however, no significant deterioration occurred.

The result of this embodiment shows a solar battery using a collecting electrode according to the invention has excellent characteristics and high reliability.

### (Embodiment 4)

Referring to this embodiment, the case that a collecting electrode comprises Au wire, polyamide and In₂O₃ will be described.

In this embodiment, a collecting electrode 100 according to the invention shown in Fig. 1A is produced as the first embodiment except that a metallic wire 101 is formed by gold, polyamide resin manufactured by Mitsubishi Chemical Industries Ltd. is used as polymeric resin which mainly constitutes paste forming a coated layer 102, and In₂O₃ manufactured by Sumitomo Metal Mining Co., Ltd. of which average primary particle diameter is 0.05 µm is used as a conductive particle.

The above-described paste was hardened at the temperature of 160 °C for thirty minutes which were the standard hardening condition of the above-described hardener and then, was measured in its volume resistivity, and it was verified that its volume resistivity was low enough because the measured value was 1.5 Ω cm². The volume of a hole of this conductive adhesive was 0.04 l/g and average molecular weight of polymeric resin was ten thousand.

Wire was coated as the first embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.2% ± 0.01%, its shunt resistance was 400 to 500 kΩ cm², its series resistance was 32.3 Ω cm² on average. The yield rate of samples of which I-V curve was normal was satisfactory because it was 90%.

The reliability test of these samples was performed by the same method as that in the first embodiment. Next, the solar battery characteristics of the samples after the test was finished were measured using a simulator as in measurement of initial values, and the conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 5)

Referring to this embodiment, the case that a collecting electrode comprises Cu wire, silver clad, urethane and carbon black will be described.

In this embodiment, a collecting electrode 100 according to the invention shown in Fig. 1B is produced as the first embodiment except that a silver-clad copper wire 100 µm in diameter produced by forming a silver-clad metal layer 103 2 µm thick on a copper wire 101 to enhance adhesion and electrical connection with a conductive adhesive is used.

Paste for forming a conductive adhesive for a coated layer 102 is produced as follows:
First, mixed solution comprising ethyl acetate 2.5 g and IPA 2.5 g as a solvent is put in a shaker for dispersion. Next, urethane resin 22.0 g which is main material is added in the above-described shaker and is sufficiently stirred with a ball mill. Next, as a hardener, block isocyanate 1.1 g and glass beads for dispersion 10 g are added in the above-described solution. Next, carbon black 2.5 g of which average primary particle diameter is 0.05 µm as a conductive particle is added in the above-described solution.

The shaker in which the above-described materials were put is dispersed with a paint shaker manufactured by Toyo Precision Mechanical Equipment for ten hours. Then, the glass beads for dispersion are removed from produced paste. The average particle diameter of the paste was measured and the measured value was approximately 1 µm. The similar result was also obtained if a bead mill was used in place of a paint shaker.

The above-described paste was hardened at the temperature of 160 °C for thirty minutes which were the standard hardening condition of the above-described hardener and then, was measured in its volume resistivity, and it was verified that its volume resistivity was low enough because the measured value was 0.6 Ω cm².

Next, a coated layer 103 is formed using a vertical-type wire coating machine 400 shown in Fig. 3 as described below.

A layer 102 was coated on a silver-clad layer 103 as the first embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.7% ± 0.03%, its shunt resistance was 300 to 400 kΩ cm², its series resistance was 31.5 Ω cm² on average. The yield rate of samples of which I-V curve was normal was satisfactory because it was 90%.

The reliability test of these samples was performed by the same method as that in the first embodiment. Next, the solar battery characteristics of the samples after the test was finished were measured using a simulator as in measurement of initial values, and the conversion efficiency was lower 1.5% on average than the initial conversion efficiency, however, no significant deterioration occurred.

The result of this embodiment shows a solar battery using a collecting electrode according to the invention has excellent characteristics and high reliability.

### (Embodiment 6)

Referring to this embodiment, the case that a collecting electrode comprises Cu wire, silver clad, phenoxy and ZnO will be described.

In this embodiment, a collecting electrode 100 according to the invention shown in Fig. 1B is produced as the fifth embodiment except that phenoxy resin manufactured by PKHH Tomoe Industries is used as polymeric resin which mainly constitutes paste forming a coated layer 102 and ZnO powder manufactured by Mitsui Mining and Smelting Co. Ltd. of which average primary particle diameter is 0.1 µm is used as a conductive particle.

The above-described paste was hardened at the temperature of 160 °C for thirty minutes which were the standard hardening condition of the above-described hardener and then, was measured in its volume resistivity, and it was verified that its volume resistivity was low enough because the measured value was 1.3 Ω cm². The volume of a hole of this conductive adhesive was 0.01 ml/g and the ratio of gel was 100%. The average molecular weight of polymeric resin was twenty-five thousand.

Wire was coated as the fifth embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.6% ± 0.02%, its shunt resistance was 310 to 390 kΩ cm², its series resistance was 32.4 Ω cm² on average. The yield rate of samples of which I-V curve was normal was satisfactory because it was 94%.

The reliability test of these samples was performed by the same method as that in the first embodiment. Next, the solar battery characteristics of the samples after the test was finished were measured using a simulator as in measurement of initial values, and the conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 7)

Referring to this embodiment, the case that a collecting electrode comprises Cu wire, silver clad, phenoxy and ZnO + Al will be described.

In this embodiment, a collecting electrode 100 according to the invention shown in Fig. 1B is produced as the fifth embodiment except that ZnO powder produced by adding aluminum to ZnO as dopant so as to lower contact resistance of a conductive particle is used.

The above-described paste was hardened at the temperature of 160 °C for thirty minutes which were the standard hardening condition of the above-described hardener and then, was measured in its volume resistivity, and it was verified that its volume resistivity was low enough because the measured value was 0.9 Ω cm².

Wire was coated as the fifth embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.6% ± 0.09%, its shunt resistance was 400 to 500 kΩ cm², its series resistance was 31.5 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 8)

Referring to this embodiment, the case that a collecting electrode comprises Cu wire, silver plating, urethane and TiO₂ will be described.

In this embodiment, a collecting electrode 100 according to the invention shown in Fig. 1B is produced as the fifth embodiment except that a metallic layer 103 on a copper wire 101 is changed from silver clad according to the fifth embodiment to silver plating and TiO₂ manufactured by Ishihara Sangyo Kaisha of which average primary particle diameter is 0.2 µm is used as a conductive particle.

The above-described paste was hardened at the temperature of 160 °C for thirty minutes which were the standard hardening condition of the above-described hardener and then, was measured in its volume resistivity, and it was verified that its volume resistivity was low enough because the measured value was 1.1 Ω cm². Wire was coated as the fifth embodiment to form a collecting electrode 100.

Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.5% ± 0.01%, its shunt resistance was 400 to 500 kΩ cm², its series resistance was 31.6 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2.3% on average than the initial conversion efficiency, however, no significant deterioration occurred.

The result of this embodiment shows a solar battery using a collecting electrode according to the invention has excellent characteristics and high reliability.

### (Embodiment 9)

Referring to this embodiment, the case that a collecting electrode comprises Cu wire, tin plating, polyamide and graphite will be described.

In this embodiment, a collecting electrode 100 according to the invention shown in Fig. 1B is produced as the fifth embodiment except that a metallic layer 103 on a copper wire 101 is changed from silver clad according to the fifth embodiment to tin plating, and polyamide imide resin manufactured by Mitsubishi Chemical Industries Ltd. is used as polymeric resin which mainly constitutes paste and a conductive particle is changed to graphite manufactured by Tokai Carbon.

The above-described paste was hardened at the temperature of 180 °C for thirty minutes which were the standard hardening condition of the above-described hardener and then, was measured in its volume resistivity, and it was verified that its volume resistivity was low enough because the measured value was 2.0 Ω cm². The volume of a hole of this conductive adhesive was 0.01 ml/g and the average molecular weight of polymeric resin was twenty-five thousand.

Wire was coated as the fifth embodiment to form a collecting electrode 100. Fifty solar battery modules were produced using the collecting electrode 100 by the same method as that in the first embodiment.

The initial characteristics of the obtained sample were measured by the same method as that in the first embodiment and satisfactory characteristics could be obtained because its conversion efficiency was 9.3% ± 0.09%, its shunt resistance was 400 to 500 kΩ cm², its series resistance was 33.6 Ω cm² on average. The yield rate of samples of which I-V curve was normal was satisfactory because it was 94%.

The reliability test of these samples was performed by the same method as that in the first embodiment. Next, the solar battery characteristics of the samples after the test was finished were measured using a simulator as in measurement of initial values, and the conversion efficiency was lower 2.9% on average than the initial conversion efficiency, however, no significant deterioration occurred.

The result of this embodiment shows a solar battery using a collecting electrode according to the invention has excellent characteristics and high reliability.

### (Embodiment 10)

Referring to this embodiment, the case that a collecting electrode comprises Cu wire, silver paste, urethane and carbon black will be described.

In this embodiment, a collecting electrode 100 according to the invention shown in Fig. 1B is produced as the fifth embodiment except that a metallic layer 103 on a copper wire 101 is changed from silver clad according to the fifth embodiment to silver paste, 5007 manufactured by Du Pont.

For paste used for the above-described metallic layer 103, paste in which a silver particle is dispersed in epoxy resin is used.

The above-described paste was hardened at the temperature of 150 °C for thirty minutes which were the standard hardening condition of the above-described hardener and then, was measured in its volume resistivity, and it was verified that its volume resistivity was low enough because the measured value was 5 × 10⁻⁵ Ω cm².

Next, a metallic layer 302 comprising the above-described silver paste which is coated on a Cu wire sequentially from the innermost layer by the same method as that in the first embodiment is constituted as follows:
First, a reel on which a Cu wire 302 is wound is set on a delivery reel 301 and the above-described Cu wire is stretched to a take-up reel 310. Next, the above-described silver paste 5007 is injected into a coater.

The take-up speed of Cu wire shall be 40 m/min., the hardening time 2 sec., the temperature of a drying furnace 200 °C and the diameter of the used die for enamel coating 160 µm. The above-described conditions on which paste 5007 applied on wire is hardened are determined based upon the result of experiments. The thickness of formed metallic layer 103 was 5 µm on average and fluctuation of the thickness of film when wire 100 m long was coated was within ±0.2 µm.

Next, a carbon paste-coated layer 102 comprising urethane resin was formed by the same method as that in the fifth embodiment.

The thickness of the coated layer 102 was 20 µm on average and fluctuation of the thickness of film when a wire 100 m long was coated was within ±1 µm.

Next, fifty solar battery modules using this wire as a collecting electrode which were constituted as in the first embodiment and shown in Fig. 8A were produced.

The initial characteristics of the obtained sample were measured by the same method as that in the first embodiment. First, the shunt resistance was checked and a satisfactory value could be obtained because the measured value was 150 to 200 kΩ cm². Next, the characteristics of the above-described solar battery were measured, and it was verified that such solar battery had satisfactory characteristics and such characteristics varied little because its conversion efficiency was 9.2% ± 0.05% and its series resistance was 31.8 Ω cm² on average. The yield rate of samples of which I-V curve was normal was satisfactory because it was 88%.

The reliability test of these samples was performed by the same method as that in the first embodiment. Next, the solar battery characteristics of the samples after the test was finished were measured using a simulator as in measurement of initial values, and the conversion efficiency was lower 2.1% on average than the initial conversion efficiency, however, no significant deterioration occurred.

Next, a test in which low illuminance of light was irradiated to such solar battery module under the environment where the temperature was +85 °C and the relative humidity was 85% so as to check possibility of migration of silver because silver is used for a collecting electrode was continued for 100 hours.

Next, the shunt resistance of such sample after the above-described test was finished was measured by the same method as that in the first embodiment, as a result, the measured value was 130 to 160 kΩ cm², and no significant deterioration occurred.

The result of this embodiment shows a solar battery using a metallic wire on which a conductive adhesive is coated according to the invention as a collecting electrode has excellent characteristics and high reliability.

### (Embodiment 11)

In this embodiment, an amorphous solar battery 400 is produced according to the following procedure by the same method as that in the first embodiment except that it is constituted as a single type which is constituted only by a Si layer shown in Fig. 4A and radio-frequency (RF) plasma CVD is used for forming a semiconductor layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a RF plasma CVD film forming system not shown, and a silicon semiconductor layer is formed in the order of n layer 403, i-layer 404 and p-layer 405. Then, the substrate is put in a resistance heating deposition system not shown and In₂O₃ film is formed as transparent conductive film 506 provided with a function also with anti-reflection effect. Next, fifty solar battery modules were produced using the above-described collecting electrode 100 by the same method as that in the first embodiment. At this time, the above-described coated wire 100 was used at intervals of 5.5 mm.

The initial characteristics of the obtained sample were measured by the same method as that in the first embodiment and satisfactory characteristics could be obtained because its conversion efficiency was 5.2% ± 0.05%, its shunt resistance was 150 to 320 kΩ cm², its series resistance was 9.5 Ω cm² on average. The yield rate of samples of which I-V curve was normal was satisfactory because it was 90%.

The reliability test of these samples was performed by the same method as that in the first embodiment. Next, the solar battery characteristics of the samples after the test was finished were measured using a simulator as in measurement of initial values, and the conversion efficiency was lower 2.4% on average than the initial conversion efficiency, however, no significant deterioration occurred.

The result of this embodiment shows a solar battery using a collecting electrode according to the invention has excellent characteristics and high reliability.

### (Embodiment 12)

In this embodiment, an amorphous solar battery 400 is produced according to the following procedure by the same method as that in the first embodiment except that it is constituted as a double type which is constituted by two Si layers shown in Fig. 4B and RF plasma CVD is used for forming a semiconductor layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a RF plasma CVD film forming system not shown, and the bottom layer of a silicon layer is formed in the order of n layer 403, i-layer 404 and p-layer 405. Next, similarly, the top layer of a silicon layer is sequentially formed in the order of n layer 413, i-layer 414 and p-layer 415, and as a result, a silicon semiconductor layer is deposited. Then, the substrate is put in a resistance heating deposition system not shown and In₂O₃ film is formed as transparent conductive film 406 provided with a function also with anti-reflection effect.

Next, fifty solar battery modules were produced using the above-described collecting electrode 100 by the same method as that in the first embodiment. At this time, the above-described coated wire 100 was used at intervals of 5.5 mm.

The initial characteristics of the obtained sample were measured by the same method as that in the first embodiment and satisfactory characteristics could be obtained because its conversion efficiency was 7.5% ± 0.01%, its shunt resistance was 400 to 500 kΩ cm², its series resistance was 23.1 Ω cm² on average. The yield rate of samples of which I-V curve was normal was satisfactory because it was 94%.

The reliability test of these samples was performed by the same method as that in the first embodiment. Next, the solar battery characteristics of the samples after the test was finished were measured using a simulator as in measurement of initial values, and the conversion efficiency was lower 1.9% on average than the initial conversion efficiency, however, no significant deterioration occurred.

The result of this embodiment shows a solar battery using a collecting electrode according to the invention has excellent characteristics and high reliability.

### (Embodiment 13)

In this embodiment, an amorphous solar battery 400 is produced according to the following procedure by the same method as that in the first embodiment except that it is constituted as a double type which is constituted by Si and SiGe layers shown in Fig. 6, RF plasma CVD is used for forming a semiconductor layer, and a silicon germanium semiconductor layer is used for i-layer of the bottom layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a microwave plasma CVD film forming system not shown, and the bottom layer is formed in the order of a silicon layer for n layer 403, a silicon germanium layer for i-layer 404 and a silicon layer for p-layer 405. Next, similarly, the top layer of a silicon layer is sequentially formed in the order of n layer 413, i-layer 414 and p-layer 415, and as a result, a silicon semiconductor layer is deposited. Then, the substrate is put in a resistance heating deposition system not shown and In₂O₃ film is formed as transparent conductive film 406 provided with a function also with anti-reflection effect.

Next, fifty solar battery modules were produced using the above-described collecting electrode 100 by the same method as that in the first embodiment. At this time, the above-described coated wire 100 was used at intervals of 5.5 mm.

The initial characteristics of the obtained sample were measured by the same method as that in the first embodiment and satisfactory characteristics could be obtained because its conversion efficiency was 7.7% ± 0.02%, its shunt resistance was 400 to 500 kΩ cm², its series resistance was 20 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2.0% on average than the initial conversion efficiency, however, no significant deterioration occurred.

The result of this embodiment shows a solar battery using a collecting electrode according to the invention has excellent characteristics and high reliability.

### (Embodiment 14)

In this embodiment, an amorphous solar battery 400 is produced according to the following procedure by the same method as that in the first embodiment except that it is constituted as a triple type which is constituted by SiC, Si and SiGe layers shown in Fig. 4C, RF plasma CVD is used for forming a semiconductor layer, and a silicon germanium semiconductor layer is used for i-layer of the bottom layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a microwave plasma CVD film forming system not shown, and the bottom layer is formed in the order of a silicon layer for n layer 403, a silicon germanium layer for i-layer 404 and a silicon layer for p-layer 405. Next, similarly, the middle layer of a silicon layer is sequentially formed in the order of n layer 413, i-layer 414 and p-layer 415, further the top layer is formed in the order of a silicon layer for n layer 423, a silicon-C layer for i-layer 404 and a silicon layer for p-layer 405, and as a result, a semiconductor layer is deposited. Then, the substrate is put in a resistance heating deposition system not shown and In₂O₃ film is formed as transparent conductive film 406 provided with a function also with anti-reflection effect.

Next, fifty solar battery modules were produced using the above-described collecting electrode 100 by the same method as that in the first embodiment.

The initial characteristics of the obtained sample were measured by the same method as that in the first embodiment and satisfactory characteristics could be obtained because its conversion efficiency was 9.5% ± 0.06%, its shunt resistance was 260 to 330 kΩ cm², its series resistance was 33.7 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2.4% on average than the initial conversion efficiency, however, no significant deterioration occurred.

The result of this embodiment shows a solar battery using a collecting electrode according to the invention has excellent characteristics and high reliability.

### (Embodiment 15)

In this embodiment, a monocrystalline solar battery 500 is produced according to the following procedure by the same method as that in the first embodiment except that it is constituted by a monocrystalline solar battery (monocrystalline Si) shown in Fig. 5.

First, a silicon monocrystal of which valence electron is controlled by Czochralski process so that it is p type is produced, the monocrystal is sliced, and a silicon wafer 500 approximately 300 µm thick is produced. Further, a n⁺-type layer 501 is formed in a diffusion process by applying P₂O₅ on the above-described wafer. Next, silver paste is printed on the rear side of p-layer 500 by a screen printing machine not shown, heated and burnt, and as a result, the lower electrode 502 is formed. Next, the above-described collecting electrode 100 used in the first embodiment is formed on n⁺-type layer 501 on the side of light irradiated face by the above-described method. Then, SiO₂ film 504 is formed as anti-reflection film by a sputtering process. Next, fifty solar battery modules shown in Fig. 8B by the same method as that in the first embodiment were produced. At this time, the above-described coated wire 100 was used at intervals of 8.5 mm.

The initial characteristics of the obtained sample were measured by the same method as that in the first embodiment and satisfactory characteristics could be obtained because its conversion efficiency was 15.8% ± 0.09%, its shunt resistance was 500 to 760 kΩ cm², its series resistance was 2.8 Ω cm² on average. The yield rate of samples of which I-V curve was normal was satisfactory because it was 98%.

The reliability test of these samples was performed by the same method as that in the first embodiment. Next, the solar battery characteristics of the samples after the test was finished were measured using a simulator as in measurement of initial values, and the conversion efficiency was lower 1.9% on average than the initial conversion efficiency, however, no significant deterioration occurred.

The result of this embodiment shows a solar battery using a collecting electrode according to the invention has excellent characteristics and high reliability.

### (Embodiment 16)

In this embodiment, a polycrystalline solar battery 600 is produced according to the following procedure by the same method as that in the first embodiment except that it is constituted by a polycrystalline solar battery (polycrystalline Si) shown in Fig. 6.

First, a polycrystalline ingot is produced by a casting process, the polycrystal is sliced, and n⁺-type layer 601 is formed on the obtained polycrystalline silicon wafer 600 in a diffusion process by applying P₂O₅ on the above-described wafer. Next, silver paste is printed on the rear side of p-layer 600 by a screen printing machine not shown, heated and burnt, and as a result, the lower electrode 602 is formed. Next, the above-described collecting electrode 100 used in the first embodiment is formed on n⁺-type layer 601 on the side of light irradiated face by the above-described method. Then, SiO₂ film 604 is formed as anti-reflection film by a sputtering process. Next, fifty solar battery modules shown in Fig. 8B by the same method as that in the first embodiment were produced. At this time, the above-described coated wire 100 was used at intervals of 8 mm.

The initial characteristics of the obtained sample were measured by the same method as that in the first embodiment and satisfactory characteristics could be obtained because its conversion efficiency was 13.8% ± 0.01%, its shunt resistance was 450 to 650 kΩ cm², its series resistance was 2.6 Ω cm² on average. The yield rate of samples of which I-V curve was normal was satisfactory because it was 94%.

The reliability test of these samples was performed by the same method as that in the first embodiment. Next, the solar battery characteristics of the samples after the test was finished were measured using a simulator as in measurement of initial values, and the conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 17)

In this embodiment, a thin-film polycrystalline solar battery 600 is produced according to the following procedure by the same method as that in the first embodiment except that it is constituted by a thin-film polycrystalline solar battery (thin-film polycrystalline Si) shown in Fig. 7.

First, a metallic Si substrate 701 sufficiently degreased and cleaned is put in a microwave plasma CVD film forming system not shown so as to form n layer 702. Next, this substrate is put in a heating furnace not shown so as to polycrystallize n layer 702. Then, the substrate is put in a microwave plasma CVD film forming system not shown so as to form p-layer 703. Further, the substrate is put in a sputtering device not shown and ITO film is formed as transparent conductive film 704 provided with a function also with anti-reflection effect. Next, a collecting electrode 705 is formed on the above-described transparent conductive film 704 by the same method as that in the first embodiment and fifty solar battery modules shown in Fig. 8B were produced.

The initial characteristics of the obtained sample were measured by the same method as that in the first embodiment and satisfactory characteristics could be obtained because its conversion efficiency was 12.5% ± 0.01%, its shunt resistance was 400 to 510 kΩ cm², its series resistance was 20 Ω cm² on average. The yield rate of samples of which I-V curve was normal was satisfactory because it was 92%.

The reliability test of these samples was performed by the same method as that in the first embodiment. Next, the solar battery characteristics of the samples after the test was finished were measured using a simulator as in measurement of initial values, and the conversion efficiency was lower 2.1% on average than the initial conversion efficiency, however, no significant deterioration occurred.

The result of this embodiment shows a solar battery using a collecting electrode according to the invention has excellent characteristics and high reliability.

### (Embodiment 18)

This embodiment is different from the first embodiment in that resistivity of a conductive adhesive is varied within the range of 0.005 to 200 Ω cm. For a method for varying resistivity of a conductive adhesive, mixing ratio (in weight) of polymeric resin and a conductive particle in conductive coating material was varied to any of 5:95, 10:90, 20:80, 80:20, 90:10, 95:5.

This embodiment is similar to the first embodiment in other ways.

Ten triple cells shown in Fig. 4C were produced according to the same procedure as that in the first embodiment except that these conductive adhesives were used and similarly evaluated. Table 1 shows the result.

**[Table 1]**

| Resistivity (Ω cm) | 0.005 | 0.01 | 1 | 100 | 200 |
|---|---|---|---|---|---|
| Initial status Transformation efficiency(%) | 8.2 | 9.6 | 9.6 | 9.4 | 8.5 |
| Series resistance(Ω cm²) | 31.4 | 31.4 | 31.8 | 32.3 | 39.8 |
| Shunt resistance(kΩ cm²) | 4.9 | 25.9 | 250 | 320 | 350 |
| Status after confidence test | | | | | |
| Transformation efficiency(%) | 7.2 | 9.5 | 9.5 | 9.3 | 7.3 |
| Series resistance(Ω cm²) | 31.3 | 31.6 | 31.9 | 32.6 | 50.3 |
| Shunt resistance(kΩ cm²) | 2.3 | 25.9 | 251 | 325 | 350 |

Table 1 shows that initial shunting can be controlled by setting the resistivity of a coated layer 102 to 0.01 Ω cm or more and more stable conversion efficiency can be obtained. Table 1 also shows that series resistance can be reduced by setting the resistivity to 100 Ω cm or less and higher conversion efficiency can be obtained. Table 1 further shows that increase of series resistance and lowering of conversion efficiency after a reliability test can be reduced and a solar battery using a collecting electrode according to the invention has high reliability.

### (Embodiment 19)

This embodiment is different from the first embodiment in that the heating pressure-bonding temperature of a conductive adhesive is varied in the range of 50 to 300 °C. For temperature for heating and pressure-bonding a collecting electrode 100, measurement was performed at four different temperature of 100, 160, 200 and 250 °C. Used block isocyanate is similar to that in the first embodiment and its dissociative temperature is 150 °C.

In other ways this embodiment is similar to the first embodiment.

Ten triple cells shown in Fig. 4 were produced and similarly evaluated according to the same procedure as that in the first embodiment except that heating pressure-bonding temperature was set as their temperature. Table 2 shows the result.

**[Table 2]**

| Heating pressure-bonding temperature (°C) | 100 | 160 | 200 | 250 |
|---|---|---|---|---|
| Initial status Transformation efficiency(%) | 6.3 | 9.0 | 9.6 | 9.6 |
| Series resistance(Ω cm²) | 51.3 | 31.4 | 31.3 | 31.2 |
| Shunt resistance(kΩ cm²) | 57.3 | 253 | 352 | 390 |
| Status after confidence test | | | | |
| Transformation efficiency(%) | 3.1 | 8.7 | 9.6 | 9.6 |
| Series resistance(Ω cm²) | 121 | 36.5 | 31.3 | 31.2 |
| Shunt resistance(kΩ cm²) | 56.8 | 254 | 356 | 389 |

Table 2 shows that series resistance can be reduced by setting heating pressure-bonding temperature to the dissociative temperature or higher of coated layer resin and higher conversion efficiency can be obtained. The table 2 also shows increase of series resistance after a reliability test and lowering of conversion efficiency can be reduced and a solar battery using a collecting electrode according to the invention has high reliability.

### (Embodiment 20)

This embodiment is different from the first embodiment in that the heating pressure-bonding time of a conductive adhesive is varied in the range of 10 to 60 seconds. For heating pressure-bonding time of a collecting electrode 100, four different time of 10, 20, 45 and 60 seconds was set. To check the hardening factor of a conductive adhesive under such a condition, an amount eluted into a solvent before and after immersion was measured and as a result, the ratio of gel was 5%, 15%, 80% and 100% respectively. Used block isocyanate is similar to that in the first embodiment and its dissociative temperature is 150 °C.

In other ways this embodiment is similar to the first embodiment.

Ten triple cells shown in Figs 4A to 4C were produced and similarly evaluated according to the same procedure as that in the first embodiment except that for heating pressure-bonding temperature, the above-described temperature was set. Table 3 shows the result.

**[Table 3]**

| Heating contact bonding time(sec.) | 10 | 20 | 45 | 60 |
|---|---|---|---|---|
| Initial status Transformation efficiency(%) | 6.9 | 8.5 | 9.5 | 9.6 |
| Series resistance(Ω cm²) | 43.5 | 36.2 | 31.4 | 31.2 |
| Shunt resistance(kΩ cm²) | 25.1 | 96.3 | 265 | 312 |
| Status after confidence test | | | | |
| Transformation efficiency(%) | 5.2 | 8.0 | 9.5 | 9.6 |
| Series resistance(Ω cm²) | 58.3 | 40.2 | 31.5 | 31.3 |
| Shunt resistance(kΩ cm²) | 20.3 | 96.5 | 264 | 315 |

Table 3 shows that series resistance can be reduced and higher conversion efficiency can be obtained by adjusting heating pressure-bonding time and setting the ratio of gel of coated layer resin to 20% or more. The table 3 also shows increase of series resistance after a reliability test and lowering of conversion efficiency can be reduced and a solar battery using a collecting electrode according to the invention has high reliability.

### (Embodiment 21)

In this embodiment, the amount of a hardener applied to a conductive adhesive was measured. The ratio in weight of urethane resin mainly used for a coated layer of a collecting electrode 100 and block isocyanate used for a hardener was changed to 100:1, 50:1, 20:1 and 10:1. At this time, the ratio of gel of a conductive adhesive was 5%, 15%, 85% and 100% respectively. Used block isocyanate is similar to that in the first embodiment and its dissociative temperature is 150 °C.

In other ways this embodiment is similar to the first embodiment.

Ten triple cells shown in Figs. 4A to 4C were produced and evaluated according to the same procedure as that in the first embodiment. Table 4 shows the result.

**[Table 4]**

| Ratio of resin/hardener | 100:1 | 50:1 | 20:1 | 10:1 |
|---|---|---|---|---|
| Initial status Transformation efficiency(%) | 7.8 | 8.7 | 9.7 | 9.6 |
| Series resistance(Ω cm²) | 39.9 | 33.8 | 31.0 | 31.7 |
| Shunt resistance(kΩ cm²) | 15.3 | 165 | 369 | 374 |
| Status after confidence test | | | | |
| Transformation efficiency(%) | 6.1 | 8.4 | 9.7 | 9.6 |
| Series resistance(Ω cm²) | 51.2 | 38.9 | 31.1 | 31.9 |
| Shunt resistance(kΩ cm²) | 14.2 | 172 | 368 | 372 |

Table 4 shows that series resistance can be reduced and higher conversion efficiency can be obtained by adjusting an amount of a hardener and setting the ratio of gel of coated layer resin to 20% or more. Table 4 also shows that increase of series resistance and lowering of conversion efficiency after a reliability test can be reduced and the table 3 also shows increase of series resistance after a reliability test and lowering of conversion efficiency can be reduced and a solar battery using a collecting electrode according to the invention has high reliability.

### (Embodiment 22)

Referring to this embodiment, the case that a collecting electrode comprises Cu wire, carbon black, urethane will be described.

In this embodiment, a collecting electrode 200 according to the invention shown in Fig. 2A is produced according to the follow procedure.

For metallic wire 201, a copper wire 100 µm in diameter is used.

Carbon paste No. 1 for forming a conductive adhesive for the first layer 202 is produced according to the following procedure. First, mixed solution comprising BCA 2.5 g and xylene 2.5 g as a solvent is put in a shaker for dispersion. Next, urethane resin 22.0 g which is main material is added in the above-described shaker and is sufficiently stirred with a ball mill. Next, as a hardener, block isocyanate 1.1 g and glass beads for dispersion 10 g are added in the above-described solution.

Next, carbon black 2.5 g of which average primary particle diameter is 0.05 µm as a conductive particle is added in the above-described solution.

The shaker in which the above-described materials are put is dispersed with a paint shaker manufactured by Toyo Precision Mechanical Equipment for ten hours. Then, the glass beads for dispersion are removed from produced paste. The average particle diameter of the paste was measured and the measured value was approximately 1 µm. The similar result was also obtained if a bead mill was used in place of a paint shaker.

The above-described paste No. 1 was hardened at the temperature of 160 °C for thirty minutes which were the standard hardening condition of the above-described hardener and then, was measured in its volume resistivity, and it was verified that its volume resistivity was low enough because the measured value was 1.0 Ω cm². The volume of a hole of this conductive adhesive was 0.01 ml/g and the ratio of gel was 100%. The average molecular weight of polymeric resin was one thousand.

Next, carbon paste No. 2 for forming a conductive adhesive the second layer 203 is produced according to the following procedure. First, for a solvent, cyclohexanone 2.5 g is put in a shaker for dispersion.

Next, urethane resin 22.0 g which is main material and phenoxy resin 2.0 g are added in the above-described shaker and are sufficiently stirred with a ball mill. Next, as a hardener, block isocyanate 1.1 g and glass beads for dispersion 10 g are added in the above-described solution. Next, carbon black 2.5 g of which average primary particle diameter is 0.05 µm as a conductive particle is added in the above-described solution. This is dispersed by the same method as that in the case of paste No. 1.

The above-described paste No. 2 was hardened at the temperature of 160 °C for thirty minutes which were the standard hardening condition of the above-described hardener, then the volume resistivity of it was measured, and it was verified that it was low enough because the measured value was 0.5 Ω cm.

Next, the first layer 202 and the second layer 203 are sequentially formed in the order described above using a vertical type of wire coater 300 shown in Fig. 3 as follows:
First, a reel on which a metallic wire 307 is wound is set on a delivery reel 301 and the above-described metallic wire is stretched to a take-up reel 310. Next, the above-described paste No. 1 is injected into a coater.

The take-up speed of metallic wire was 40 m/min., the residence time was 2 sec., the temperature of a drying furnace 306 was 350 °C and the metallic wire was coated five times. A die for enamel coating 110 to 200 µm in diameter was sequentially used. Paste No. 1 was sufficiently hardened on the above-described conditions, and adhesion and resistance to a solvent of paste were satisfactory. The thickness of the first layer 202 was 5 µm on average and fluctuation of the thickness of film when wire 100 m long was coated was within ±1 µm.

Next, the second layer 203 comprising paste No. 2 is formed by the same method as described above except the described below.

A reel 310 on which the wire on which the above-described first layer 202 was coated is wound is set on a delivery reel 301 and the above-described wire is stretched to a take-up reel 310. Next, the above-described carbon paste No. 2 is injected into a coater.

The take-up speed of the wire was 40 m/min., the drying time was 2 sec., the temperature of a drying furnace 306 was 120 °C and the wire was coated five times. A die for enamel coating 150 to 200 µm in diameter was used. Paste No. 2 applied on the above-described wire was in a condition not hardened yet in which its solvent was volatilized. The thickness of the second layer 203 was 20 µm on average and fluctuation of the thickness of film when the wire 100 m long was coated was within ±0.5 µm.

Next, in an embodiment according to the invention, a pin-junction triple amorphous solar battery 400 with constitution of layers shown in Figs. 4A to 4C provided with a grid electrode 30 cm in grid length is produced.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a microwave plasma CVD film forming system not shown, and the bottom layer is formed in the order of a silicon layer for n layer 403, a silicon germanium layer for i-layer 404 and a silicon layer for p-layer 405. Next, similarly, the middle layer is sequentially formed in the order of a silicon layer for n layer 413, a silicon germanium layer for i-layer 414 and a silicon layer for p-layer 415, further the top layer of a silicon layer is formed in the order of n layer 423, i-layer 424 and p-layer, and as a result, a semiconductor layer is deposited. Then, the semiconductor layer is put in a resistance heating deposition system not shown and ITO film is formed as transparent conductive film 506 provided with a function also with anti-reflection effect. Next, unnecessary transparent conductive film is removed using etching paste which mainly comprises ferric chloride and a printing machine on the market so that the solar battery substrate 401 is 30 × 30 cm in size and effective area of the cell is 900 cm².

Next, hard copper positive electrode 802 and negative electrode 803 are provided outside the effective area, as a collecting electrode 804 the above-described coated wire 100 is stretched between positive electrodes 802 at intervals of 7 mm so that the wire is contained in the effective area and is fixed using an ultraviolet hardening adhesive.

Next, the above-described collecting electrode 804 is heated and crimped using a heater not shown so as to stick the collecting electrode on the cell face of the solar battery substrate 401 and as a result, a triple cell 30 × 30 in size shown in Fig. 8A is produced. The collecting electrode is heated at the temperature of 200 °C for 45 seconds under pressure of 1 kg/cm².

Next, this sample is encapsulated according to the following procedure. Kroehnkite glass and EVA are laminated on the upper and rear surfaces of the solar battery substrate 801, further fluororesin film ETFE is laminated on the upper and rear surfaces, the substrate is put in a vacuum laminater and is left at the temperature of 150 °C for an hour for lamination.

Fifty solar battery modules were produced by the same method.

The initial characteristics of the obtained sample were measured according to the following procedure. First, volt-ampere characteristic of the sample in an off state was measured, its shunt resistance on an inclination in the vicinity of the origin was 200 to 500 kΩ cm² and it was a satisfactory value. Next, the solar battery characteristics were measured using a pseudo solar light source (hereinafter called a simulator) with a solar spectrum of AM 1.5 global and quantity of light of 100 mW/cm², and its conversion efficiency was satisfactory and there was little dispersion because the measured value was 9.6% ± 0.02%. Its series resistance was 32.0 Ω cm² on average and satisfactory. The yield rate of samples of which I-V curve was normal was 98% and satisfactory.

The reliability test of these samples was performed by the same method as that in the first embodiment. Next, the solar battery characteristics of the samples after the test was finished were measured using a simulator as in measurement of initial values, and the conversion efficiency was lower 2% on average than the initial conversion efficiency, however, no significant deterioration occurred.

Further, to check moisture resistance and a leakage factor of these samples, a reliability test was performed as follows: First, a sample was put in a constant temperature and humidity oven with a window through which light could be transmitted which could control temperature and humidity, and was left at the temperature of +85 °C and relative humidity of 85%. When the temperature and humidity in it was sufficiently balanced, quantity of light of 100 mW/cm² with a solar spectrum of AM 1.5 global was irradiated by a simulator installed outside the window.

Next, the solar battery characteristics of a sample after a reliability test was finished were measured using a simulator as in measurement of initial values and its conversion efficiency was lower 2% on average than its initial conversion efficiency, however, no significant deterioration occurred.

The result of this embodiment shows a solar battery using a metallic wire on which a conductive adhesive according to the invention is coated as a collecting electrode has excellent characteristics and high reliability.

### (Comparative Embodiment 2)

Referring to this comparative embodiment, the case that a collecting electrode comprises Cu wire, Ag and polyester will be described.

For comparison, paste 5007 including a silver particle manufactured by Du Pont was coated on wire to form a collecting electrode 100. The volume of a hole of this conductive adhesive was 0.1 ml/g. Fifty solar battery modules were produced using the collecting electrode 100 by the same method as that in the first embodiment.

The initial characteristics of the obtained sample were measured, its conversion efficiency was 7.5% ± 1.8%, fluctuation of the values was large. Its shunt resistance was 1.8 kΩ cm² on average and fluctuation of the values was large. Its series resistance was 32.0 Ω cm² on average. The yield rate of samples of which I-V curve was normal was low because it was 54%.

Samples of which shunt resistance were normal were selected of these samples and a reliability test of moisture resistance and leakage was performed by the same method as that in the twenty-second embodiment. Next, the solar battery characteristics of a sample after the test was finished were measured using a simulator as in measurement of initial values, its conversion efficiency was lower 20% than its initial conversion efficiency and its shunt resistance was smaller than a half of its initial shunt resistance value.

### (Embodiment 23)

Referring to this embodiment, the case that a collecting electrode comprises Cu wire, carbon black and epoxy, and carbon black and butyral will be described.

This embodiment is similar to the twenty-second embodiment except that epoxy resin manufactured by Epicoat Petrochemical Shell Epoxy is used as polymeric resin which mainly constitutes paste No. 1 for forming a conductive adhesive for a collecting electrode 200 shown in Fig. 2A according to the invention, and butyryl resin manufactured by Eslec BL-S Sekisui Chemical is used as polymeric resin which mainly constitutes paste No. 2.

The volume of a hole of this paste No. 1 was 0.01 ml/g and the ratio of gel was 100%. The average molecular weight of polymeric resin was one thousand.

The above-described paste No. 1 was hardened at the temperature of 160 °C for thirty minutes which were the standard hardening condition of the above-described hardener, then its volume resistivity was measured, and it was verified that its volume resistivity was low enough because the measured value was 2.1 Ω cm.

Wire was coated as in the twenty-second embodiment to form a collecting electrode 200. Fifty solar battery modules were produced using the collecting electrode 200 by the same method as that in the twenty-second embodiment.

The initial characteristics of the obtained sample were measured by the same method as that in the first embodiment, its conversion efficiency was 9.4% ± 0.06%, its shunt resistance was 400 to 500 kΩ cm², its series resistance was 32.2 Ω cm² on average, and satisfactory characteristics could be obtained. The yield rate of samples of which I-V curve was normal was 96% and satisfactory. A reliability test of these samples was performed as in the twenty-second embodiment. Next, the solar battery characteristics of a sample after the test was finished were measured using a simulator as in measurement of initial values, and its conversion efficiency was lower 2.6% on average than its initial conversion efficiency, however, no significant deterioration occurred.

The result of this embodiment shows a solar battery using a collecting electrode according to the invention has satisfactory characteristics and high reliability.

### (Embodiment 24)

Referring to this embodiment, the case that a collecting electrode comprises Ag wire, carbon black and urethane, and ITO and urethane will be described.

This embodiment is similar to the twenty-second embodiment except that a silver wire is used as a metallic wire 201 for a collecting electrode 200 shown in Fig. 2A according to the invention, and ITO power manufactured by HYX Sumitomo Metal Mining of which average primary particle diameter is 0.05 µm is used as a conductive particle of paste No. 2 for forming a conductive adhesive.

The above-described paste No. 2 was hardened at the temperature of 160 °C for thirty minutes which were the standard hardening condition of the above-described hardener, then its volume resistivity was measured, and it was verified that its volume resistivity was low enough because the measured value was 1.0 Ω cm.

Wire was coated as in the twenty-second embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.5% ± 0.07%, its shunt resistance was 300 to 500 kΩ cm², its series resistance was 32.5 Ω cm² on average, and satisfactory characteristics could be obtained. The yield rate of samples of which I-V curve was normal was 94% and satisfactory.

A reliability test of these samples was performed as in the twenty-second embodiment. Next, the solar battery characteristics of a sample after the test was finished were measured using a simulator as in measurement of initial values, and its conversion efficiency was lower 2.3% on average than its initial conversion efficiency, however, no significant deterioration occurred.

The result of this embodiment shows a solar battery using a collecting electrode according to the invention has satisfactory characteristics and high reliability.

### (Embodiment 25)

Referring to this embodiment, the case that a collecting electrode comprises Ag wire, graphite and urethane, and SnO₂ and urethane will be described.

This embodiment is similar to the twenty-second embodiment except that a gold wire is used as a metallic wire 201 for a collecting electrode 200 shown in Fig. 2A according to the invention, graphite power manufactured by Tokai Carbon of which average primary particle diameter is 0.05 µm is used as a conductive particle of paste No.1 for forming a conductive adhesive, and SnO₂ power manufactured by Mitsui Mining and Smelting Co., Ltd. of which average primary particle diameter is 0.2 µm is used as a conductive particle of paste No. 2.

The above-described paste No. 1 was hardened at the temperature of 180 °C for thirty minutes which were the standard hardening condition of the above-described hardener, then its volume resistivity was measured, and it was verified that its volume resistivity was low enough because the measured value was 1.8 Ω cm.

The above-described paste No. 2 was hardened at the temperature of 160 °C for thirty minutes which were the standard hardening condition of the above-described hardener, then its volume resistivity was measured, and it was verified that its volume resistivity was low enough because the measured value was 1.4 Ω cm.

Wire was coated as in the first embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.3% ± 0.01%, its shunt resistance was 230 to 420 kΩ cm², its series resistance was 33.0 Ω cm² on average, and satisfactory characteristics could be obtained. The yield rate of samples of which I-V curve was normal was 96% and satisfactory.

A reliability test of these samples was performed as in the twenty-second embodiment. Next, the solar battery characteristics of a sample after the test was finished were measured using a simulator as in measurement of initial values, and its conversion efficiency was lower 2.1% on average than its initial conversion efficiency, however, no significant deterioration occurred.

The result of this embodiment shows a solar battery using a collecting electrode according to the invention has satisfactory characteristics and high reliability.

### (Embodiment 26)

Referring to this embodiment, the case that a collecting electrode comprises Cu wire, silver clad, carbon black and urethane will be described.

This embodiment is similar to the twenty-second embodiment except that a silver clad copper wire 100 µm in diameter produced by forming a silver clad metallic layer 203 having the thickness of 2 µm on a copper wire 201 is used for a collecting electrode 200 according to the invention shown in Fig. 2A so as to enhance adhesion to a conductive adhesive and conductivity. Wire was coated as in the first embodiment to form a collecting electrode 200. Further, fifty solar battery modules were produced using the collecting electrode 100 by the same method as that in the twenty-second embodiment.

The initial characteristics of the obtained sample were measured by the same method as that in the twenty-second embodiment, its conversion efficiency was 9.7% ± 0.02%, its shunt resistance was 400 to 500 kΩ cm², its series resistance was 31.8 Ω cm² on average, and satisfactory characteristics could be obtained. The yield rate of samples of which I-V curve was normal was 98% and satisfactory.

A reliability test of these samples was performed as in the twenty-second embodiment. Next, the solar battery characteristics of a sample after the test was finished were measured using a simulator as in measurement of initial values, and its conversion efficiency was lower 2% on average than its initial conversion efficiency, however, no significant deterioration occurred.

The result of this embodiment shows a solar battery using a collecting electrode according to the invention has satisfactory characteristics and high reliability.

### (Embodiment 27)

Referring to this embodiment, the case that a collecting electrode comprises Cu wire, silver clad, ZnO and urethane, and In₂O₃ and urethane will be described.

This embodiment is similar to the twenty-second embodiment except that for a collecting electrode 200 according to the invention shown in Fig. 2A, a silver clad copper wire is used, ZnO power manufactured by Mitsui Mining and Smelting Co., Ltd. of which average primary particle diameter is 0.1 µm is used as a conductive particle of paste No. 1 for forming a conductive adhesive, and In₂O₃ powder manufactured by Sumitomo Metal Mining Co., Ltd. of which average primary particle diameter is 0.05 µm is used as a conductive particle of paste No. 2.

The above-described paste No. 1 was hardened at the temperature of 160 °C for thirty minutes which were the standard hardening condition of the above-described hardener, then its volume resistivity was measured, and it was verified that its volume resistivity was low enough because the measured value was 1.4 Ω cm.

The above-described paste No. 2 was hardened at the temperature of 160 °C for thirty minutes which were the standard hardening condition of the above-described hardener, then its volume resistivity was measured, and it was verified that its volume resistivity was low enough because the measured value was 0.7 Ω cm.

Wire was coated as in the twenty-second embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.6% ± 0.03%, its shunt resistance was 320 to 390 kΩ cm², its series resistance was 32.1 Ω cm² on average, and satisfactory characteristics could be obtained. The yield rate of samples of which I-V curve was normal was 96% and satisfactory.

A reliability test of these samples was performed as in the twenty-second embodiment. Next, the solar battery characteristics of a sample after the test was finished were measured using a simulator as in measurement of initial values, and its conversion efficiency was lower 2% on average than its initial conversion efficiency, however, no significant deterioration occurred.

The result of this embodiment shows a solar battery using a collecting electrode according to the invention has satisfactory characteristics and high reliability.

### (Embodiment 28)

Referring to this embodiment, the case that a collecting electrode comprises Cu wire, silver plating, carbon black and phenol, and carbon black and polyamide will be described.

This embodiment is similar to the twenty-second embodiment except that for a collecting electrode 200 according to the invention shown in Fig. 2A, a silver-plated wire 100 µm in diameter produced by plating silver clad with silver is used as a metallic layer 203, phenol resin manufactured by Dainippon and Chemicals, Inc. is used as main material for polymeric resin of paste No. 1 for forming a conductive adhesive, and polyamide resin manufactured by Mitsubishi Kasei Corporation is used as main material for polymeric resin of paste No. 2. The volume of a hole of this paste No. 1 was 0.01 ml/g and the ratio of gel was 100%. The average molecular weight of polymeric resin was one thousand.

The above-described paste No. 1 was hardened at the temperature of 160 °C for thirty minutes which were the standard hardening condition of the above-described hardener, then its volume resistivity was measured, and it was verified that its volume resistivity was low enough because the measured value was 1.5 Ω cm.

The above-described paste No. 2 was hardened at the temperature of 160 °C for thirty minutes which were the standard hardening condition of the above-described hardener, then its volume resistivity was measured, and it was verified that its volume resistivity was low enough because the measured value was 0.8 Ω cm.

Wire was coated as in the first embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.3% ± 0.01%, its shunt resistance was 400 to 500 kΩ cm², its series resistance was 32.7 Ω cm² on average, and satisfactory characteristics could be obtained. The yield rate of samples of which I-V curve was normal was 96% and satisfactory.

A reliability test of these samples was performed as in the twenty-second embodiment. Next, the solar battery characteristics of a sample after the test was finished were measured using a simulator as in measurement of initial values, and its conversion efficiency was lower 2.8% on average than its initial conversion efficiency, however, no significant deterioration occurred.

The result of this embodiment shows a solar battery using a collecting electrode according to the invention has satisfactory characteristics and high reliability.

### (Embodiment 29)

Referring to this embodiment, the case that a collecting electrode comprises Cu wire, tin plating, ZnO₂ +Al, carbon black and urethane, and TiO₂ and urethane will be described.

This embodiment is similar to the twenty-second embodiment except that for a collecting electrode 200 according to the invention shown in Fig. 2A, a tin-plated copper wire 100 µm in diameter produced by plating silver clad with tin is used as a metallic layer 203, ZnO₂ powder of which primary particle diameter is 0.05 µm produced by adding aluminum to ZnO₂ as dopant so as to reduce contact resistance is used as a conductive particle of paste No. 1 for forming a conductive adhesive, and TiO₂ powder of which average primary particle diameter is 0.05 µm is used as a conductive particle of paste No. 2. The volume of a hole of this paste No. 1 was 0.01 ml/g and the ratio of gel was 100%. The average molecular weight of polymeric resin was one thousand.

The above-described paste No. 1 was hardened at the temperature of 160 °C for thirty minutes which were the standard hardening condition of the above-described hardener, then its volume resistivity was measured, and it was verified that its volume resistivity was low enough because the measured value was 0.9 Ω cm.

The above-described paste No. 2 was hardened at the temperature of 160 °C for thirty minutes which were the standard hardening condition of the above-described hardener, then its volume resistivity was measured, and it was verified that its volume resistivity was low enough because the measured value was 1.5 Ω cm.

Wire was coated as in the first embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.4% ± 0.01%, its shunt resistance was 360 to 430 kΩ cm², its series resistance was 32.6 Ω cm² on average, and satisfactory characteristics could be obtained. The yield rate of samples of which I-V curve was normal was 94% and satisfactory.

A reliability test of these samples was performed as in the twenty-second embodiment. Next, the solar battery characteristics of a sample after the test was finished were measured using a simulator as in measurement of initial values, and its conversion efficiency was lower 2.1% on average than its initial conversion efficiency, however, no significant deterioration occurred.

The result of this embodiment shows a solar battery using a collecting electrode according to the invention has satisfactory characteristics and high reliability.

### (Embodiment 30)

Referring to this embodiment, the case that a collecting electrode comprises Cu wire, gold plating, carbon black and phenoxy, and carbon black and polyamide will be described.

This embodiment is similar to the twenty-second embodiment except that for a collecting electrode 200 according to the invention shown in Fig. 2A, a gold-plated copper wire 100 µm in diameter produced by plating silver clad with gold is used as a metallic layer 203, phenoxy resin manufactured by Tomoe Industries is used as main material for a polymeric resin of paste No. 1 for forming a conductive adhesive, and polyamide imide resin manufactured by Mitsubishi Kasei Corporation is used as a main material for polymeric resin of paste No. 2.

The above-described paste No. 1 was hardened at the temperature of 160 °C for thirty minutes which were the standard hardening condition of the above-described hardener, then its volume resistivity was measured, and it was verified that its volume resistivity was low enough because the measured value was 1.0 Ω cm.

The above-described paste No. 2 was hardened at the temperature of 180 °C for thirty minutes which were the standard hardening condition of the above-described hardener, then its volume resistivity was measured, and it was verified that its volume resistivity was low enough because the measured value was 2.0 Ω cm.

Wire was coated as in the first embodiment to form a collecting electrode 200. Fifty solar battery modules were produced using the collecting electrode 200 by the same method as that in the twenty-second embodiment.

The initial characteristics of the obtained sample were measured by the same method as that in the twenty-second embodiment, its conversion efficiency was 9.5% ± 0.05%, its shunt resistance was 240 to 350 kΩ cm², its series resistance was 34.1 Ω cm² on average, and satisfactory characteristics could be obtained. The yield rate of samples of which I-V curve was normal was 96% and satisfactory.

A reliability test of these samples was performed as in the twenty-second embodiment. Next, the solar battery characteristics of a sample after the test was finished were measured using a simulator as in measurement of initial values, and its conversion efficiency was lower 3.0% on average than its initial conversion efficiency, however, no significant deterioration occurred.

The result of this embodiment shows a solar battery using a collecting electrode according to the invention has satisfactory characteristics and high reliability.

### (Embodiment 31)

Referring to this embodiment, the case that a collecting electrode comprises Cu wire, silver paste, and urethane and carbon black will be described.

This embodiment is similar to the twenty-sixth embodiment except that in a collecting electrode 200 according to the invention shown in Fig. 2A, material for a metallic layer 203 on a copper wire 201 is changed from silver clad according to the twenty-sixth embodiment to silver paste 5007 manufactured by Du Pont. Paste used for the above-described metallic layer 205 is produced by dispersing silver particles in epoxy resin. A metallic layer 203 is coated as in the tenth embodiment. Next, the first layer 202 and the second layer 203 are coated in the order described above to form a collecting electrode. Fifty solar battery modules are produced using the collecting electrode 200 by the same method as that in the twenty-sixth embodiment.

The initial characteristics of the obtained sample were measured by the same method as that in the twenty-second embodiment, its conversion efficiency was 9.5% ± 0.08%, its shunt resistance was 190 to 300 kΩ cm², its series resistance was 32.0 Ω cm² on average, and satisfactory characteristics could be obtained. The yield rate of samples of which I-V curve was normal was 94% and satisfactory.

A reliability test of these samples was performed as in the twenty-second embodiment. Next, the solar battery characteristics of a sample after the test was finished were measured using a simulator as in measurement of initial values, and its conversion efficiency was lower 2.4% on average than its initial conversion efficiency, however, no significant deterioration occurred.

The result of this embodiment shows a solar battery using a collecting electrode according to the invention has satisfactory characteristics and high reliability.

### (Embodiment 32)

In this embodiment, a single-type amorphous solar battery 400 constituted only by a Si layer shown in Fig. 4A is produced according to the following procedure by the same method as that in twenty-sixth embodiment except that radio-frequency (RF) plasma CVD is used for forming a semiconductor layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a RF plasma CVD film forming system not shown, and a silicon semiconductor layer is formed in the order of n layer 403, i-layer 404 and p-layer 405. Then, the substrate is put in the sputtering device not shown and In₂O₃ film is formed as transparent conductive film 406 provided with a function also with anti-reflection effect. Next, fifty solar battery modules were produced using the above-described collecting electrode 100 by the same method as that in the twenty-sixth embodiment. At this time, the above-described coated wire 200 was used at intervals of 5.5 mm. The initial characteristics of the obtained sample were measured by the same method as that in the twenty-second embodiment, its conversion efficiency was 5.2% ± 0.05%, its shunt resistance was 150 to 320 kΩ cm², its series resistance was 9.5 Ω cm² on average, and satisfactory characteristics could be obtained. The yield rate of samples of which I-V curve was normal was 92% and satisfactory.

A reliability test of these samples was performed by the same method as that in the twenty-second embodiment. Next, the solar battery characteristics of the samples after the test was finished were measured using a simulator as in measurement of initial values, and the conversion efficiency was lower 2.4% on average than the initial conversion efficiency, however, no significant deterioration occurred.

The result of this embodiment shows a solar battery using a collecting electrode according to the invention has excellent characteristics and high reliability.

### (Embodiment 33)

In this embodiment, a double-type amorphous solar battery 400 constituted by a Si layer and a Si layer shown in Fig. 4A is produced according to the following procedure by the same method as that in twenty-sixth embodiment except that radio-frequency (RF) plasma CVD is used for forming a semiconductor layer.

First, SUS430BA substrate 401 sufficiently degreased and cleaned is put in a DC sputtering device not shown, Ag is deposited until the film is 400 nm thick, then ZnO is deposited until the film is 400 nm thick so as to form the lower electrode 402. The substrate is taken out of the sputtering device and is put in a RF plasma CVD film forming system not shown, and the bottom layer of a silicon layer is formed in the order of n layer 403, i-layer 404 and p-layer 405. Next, similarly the top layer of a silicon layer is sequentially formed in the order of n layer 413, i-layer 414 and p-layer 415 so as to deposit a silicon semiconductor layer. Then, the substrate is put in a resistance heating deposition system not shown and In₂O₃ film is formed as transparent conductive film 406 provided with a function also with anti-reflection effect.

Next, fifty solar battery modules were produced using the above-described collecting electrode 100 by the same method as that in the first embodiment. At this time, the above-described coated wire 200 was used at intervals of 6 mm.

The initial characteristics of the obtained sample were measured by the same method as that in the twenty-second embodiment, its conversion efficiency was 7.5% ± 0.08%, its shunt resistance was 400 to 500 kΩ cm², its series resistance was 23.1 Ω cm² on average, and satisfactory characteristics could be obtained. The yield rate of samples of which I-V curve was normal was 96% and satisfactory.

A reliability test of these samples was performed by the same method as that in the twenty-second embodiment. Next, the solar battery characteristics of the samples after the test was finished were measured using a simulator as in measurement of initial values, and the conversion efficiency was lower 1.9% on average than the initial conversion efficiency, however, no significant deterioration occurred.

The result of this embodiment shows a solar battery using a collecting electrode according to the invention has excellent characteristics and high reliability.

### (Embodiment 34)

In this embodiment, a monocrystalline solar battery 500 is produced according to the following procedure by the same method as that in the twenty-sixth embodiment except that it is constituted by a monocrystalline solar battery (monocrystalline Si) shown in Fig. 5.

First, a silicon monocrystal of which valence electron is controlled by CZ process so that it is p type is produced, the monocrystal is sliced, and a silicon wafer 500 approximately 300 µm thick is produced. Further, a n⁺-type layer 501 is formed in a diffusion process by applying P₂O₅ on the above-described wafer. Next, silver paste is printed on the rear side of p-layer 500 by a screen printing machine not shown, heated and burnt, and as a result, the lower electrode 502 is formed. Next, the above-described collecting electrode 100 used in the first embodiment is formed on n⁺-type layer 501 on the side of light irradiated face by the above-described method. Then, SiO₂ film 504 is formed as anti-reflection film by a sputtering process. Next, fifty solar battery modules by the same method as that in the twenty-sixth embodiment were produced. At this time, the above-described coated wire 200 was used at intervals of 8.5 mm.

The initial characteristics of the obtained sample were measured by the same method as that in the twenty-second embodiment, its conversion efficiency was 15.8% ± 0.01%, its shunt resistance was 500 to 760 kΩ cm², its series resistance was 2.8 Ω cm² on average, and satisfactory characteristics could be obtained. The yield rate of samples of which I-V curve was normal was 98% and satisfactory.

A reliability test of these samples was performed by the same method as that in the twenty-second embodiment. Next, the solar battery characteristics of the samples after the test was finished were measured using a simulator as in measurement of initial values, and the conversion efficiency was lower 1.9% on average than the initial conversion efficiency, however, no significant deterioration occurred.

The result of this embodiment shows a solar battery using a collecting electrode according to the invention has excellent characteristics and high reliability.

### (Embodiment 35)

In this embodiment, a polycrystalline solar battery 600 is produced according to the following procedure by the same method as that in the twenty-sixth embodiment except that it is constituted by a polycrystalline solar battery (polycrystalline Si) shown in Fig. 6.

First, a polycrystalline ingot is produced by a casting process, the polycrystal is sliced, and n⁺-type layer 601 is formed on the obtained polycrystalline silicon wafer 600 in a diffusion process by applying P₂O₅ on the above-described wafer. Next, silver paste is printed on the rear side of p-layer 600 by a screen printing machine not shown, heated and burnt, and as a result, the lower electrode 602 is formed. Next, the above-described collecting electrode 200 used in the twenty-sixth embodiment is formed on n⁺-type layer 601 on the side of light irradiated face by the above-described method. Then, SiO₂ film 604 is formed as anti-reflection film by a sputtering process. Next, fifty solar battery modules were produced by the same method as that in the first embodiment. At this time, the above-described coated wire 200 was used at intervals of 8.0 mm.

The initial characteristics of the obtained sample were measured by the same method as that in the twenty-second embodiment, its conversion efficiency was 13.8% ± 0.05%, its shunt resistance was 450 to 650 kΩ cm², its series resistance was 2.6 Ω cm² on average, and satisfactory characteristics could be obtained. The yield rate of samples of which I-V curve was normal was 96% and satisfactory.

A reliability test of these samples was performed by the same method as that in the twenty-second embodiment. Next, the solar battery characteristics of the samples after the test was finished were measured using a simulator as in measurement of initial values, and the conversion efficiency was lower 2% on average than the initial conversion efficiency, however, no significant deterioration occurred.

The result of this embodiment shows a solar battery using a collecting electrode according to the invention has excellent characteristics and high reliability.

### (Embodiment 36,)

In this embodiment, a thin film polycrystalline solar battery 700 is produced according to the following procedure by the same method as that in twenty-sixth embodiment except that a solar battery is constituted by a thin film polycrystalline solar battery (thin film polycrystalline Si) shown in Fig. 7.

First, a metallic Si substrate 701 sufficiently degreased and cleaned is put in a microwave plasma CVD film forming system not shown to form n layer 702. Next, the substrate is put in a heating furnace not shown and polycrystalline n layer 702. Next, the substrate is put in a microwave plasma CVD film forming system not shown to form p-layer 703. Further, it is put in a sputtering device not shown and ITO film is formed as transparent conductive film 704 provided with a function also with anti-reflection effect. Next, a grid 705 is formed on the above-described transparent conductive film 704 by the same method as that in the twenty-sixth embodiment, and fifty solar battery modules are produced. The yield rate of samples of which I-V curve was normal was 94% and satisfactory.

The initial characteristics of the obtained sample were measured by the same method as that in the twenty-second embodiment, its conversion efficiency was 15.5% ± 0.01%, its shunt resistance was 400 to 510 kΩ cm², its series resistance was 4.5 Ω cm² on average, and satisfactory characteristics could be obtained. The yield rate of samples of which I-V curve was normal was 94% and satisfactory.

A reliability test of these samples was performed by the same method as that in the twenty-second embodiment. Next, the solar battery characteristics of the samples after the test was finished were measured using a simulator as in measurement of initial values, and the conversion efficiency was lower 2.1% on average than the initial conversion efficiency, however, no significant deterioration occurred.

The result of this embodiment shows a solar battery using a collecting electrode according to the invention has excellent characteristics and high reliability.

### (Embodiment 37)

This embodiment is different from the twenty-sixth embodiment in that resistivity of a conductive adhesive is varied within the range of 0.005 to 200 Ω cm. For a method for varying resistivity of a conductive adhesive, mixing ratio (in weight) of polymeric resin and a conductive particle in conductive coating material was varied to any of 5:95, 10:90, 20:80, 80:20, 90:10, 95:5.

This embodiment is similar to the twenty-sixth embodiment in other ways.

Ten triple cells shown in Fig. 4C were produced according to the same procedure as that in the twenty-sixth embodiment except that these conductive adhesives were used and similarly evaluated. Table 5 shows the result.

**[Table 5]**

| Resistivity (Ω cm) | 0.005 | 0.01 | 1 | 100 | 200 |
|---|---|---|---|---|---|
| Initial status Transformation efficiency(%) | 8.2 | 9.6 | 9.6 | 9.4 | 8.5 |
| Series resistance(Ω cm²) | 31.4 | 31.4 | 31.8 | 32.3 | 39.8 |
| Shunt resistance(kΩ cm²) | 4.9 | 25.9 | 250 | 320 | 350 |
| Status after confidence test | | | | | |
| Transformation efficiency(%) | 7.2 | 9.5 | 9.5 | 9.3 | 7.3 |
| Series resistance(Ω cm²) | 31.3 | 31.6 | 31.9 | 32.6 | 50.3 |
| Shunt resistance(kΩ cm²) | 2.3 | 25.9 | 251 | 325 | 350 |

Table 5 shows that initial shunting can be controlled by setting the resistivity of a coated layer 203 to 0.01 Ω cm or more and more stable conversion efficiency can be obtained. Table 5 also shows that series resistance can be reduced by setting the resistivity to 100 Ω cm or less and higher conversion efficiency can be obtained. Table 5 further shows that increase of series resistance and lowering of conversion efficiency after a reliability test can be reduced and a solar battery using a collecting electrode according to the invention has high reliability.

### (Embodiment 38)

This embodiment is different from the first embodiment in that the heating pressure-bonding temperature of a conductive adhesive is varied in the range of 50 to 300 °C. For temperature for heating and pressure-bonding a collecting electrode 200, measurement was performed at four different temperature of 100, 160, 200 and 250 °C. Used block isocyanate is similar to that in the first embodiment and its dissociative temperature is 150 °C.

In other ways this embodiment is similar to the twenty-sixth embodiment.

Ten triple cells shown in Figs. 4A to 4C were produced and similarly evaluated according to the same procedure as that in the twenty-sixth embodiment except that heating pressure-bonding temperature was set as their temperature. Table 6 shows the result.

**[Table 6]**

| Heating pressure-bonding temperature (°C) | 100 | 150 | 200 | 250 |
|---|---|---|---|---|
| Initial status Transformation efficiency(%) | 7.3 | 9.0 | 9.6 | 9.6 |
| Series resistance(Ω cm²) | 41.3 | 31.4 | 31.3 | 31.2 |
| Shunt resistance(kΩ cm²) | 57.3 | 253 | 352 | 390 |
| Status after confidence test | | | | |
| Transformation efficiency(%) | 6.1 | 8.7 | 9.6 | 9.6 |
| Series resistance(Ω cm²) | 53.3 | 36.5 | 31.3 | 31.2 |
| Shunt resistance(kΩ cm²) | 56.8 | 254 | 356 | 389 |

Table 6 shows that series resistance can be reduced by setting heating pressure-bonding temperature to the dissociative temperature or higher of coated layer resin and higher conversion efficiency can be obtained. The table 6 also shows increase of series resistance and lowering of conversion efficiency after a reliability test can be reduced and a solar battery using a collecting electrode according to the invention has high reliability.

### (Embodiment 39)

This embodiment is different from the twenty-sixth embodiment in that the heating pressure-bonding time of a conductive adhesive is varied in the range of 10 to 60 seconds. For heating pressure-bonding time of a collecting electrode 200, four different time of 10, 20, 45 and 60 seconds was set. To check the hardening factor of a conductive adhesive under such a condition, an amount eluted into a solvent before and after immersion was measured and as a result, the ratio of gel was 5%, 15%, 80% and 100% respectively. Used block isocyanate is similar to that in the first embodiment and its dissociative temperature is 150 °C.

In other ways this embodiment is similar to the twenty-sixth embodiment.

Except that the temperatures for heating pressure-bonding are these temperatures, ten pieces of a triple cell in Fig. 7 are made in the same procedure as for Embodiment 26 and the same evaluation is performed. The result is shown in Table 7.

**[Table 7]**

| Heating contact bonding time(sec.) | 10 | 30 | 45 | 60 |
|---|---|---|---|---|
| Initial status Transformation efficiency(%) | 6.9 | 8.5 | 9.5 | 9.6 |
| Series resistance(Ω cm²) | 43.5 | 36.2 | 31.4 | 31.2 |
| Shunt resistance(kΩ cm²) | 25.1 | 96.3 | 265 | .312 |
| Status after confidence test | | | | |
| Transformation efficiency(%) | 5.2 | 8.0 | 9.5 | 9.6 |
| Series resistance(Ω cm²) | 58.3 | 40.2 | 31.5 | 31.3 |
| Shunt resistance(kΩ cm²) | 20.3 | 96.5 | 264 | 315 |

As apparent from Table 7, higher transformation efficiency can be obtained due to reduction of the series resistance caused by the heating pressure-bonding temperature higher than the dissociation temperature of coating-layer resin. In addition, it is also clear that higher reliability is secured because of less increase of the series resistance and less decrease of the transformation efficiency after the confidence test.

### (Embodiment 40)

In this embodiment, the amount of a curing agent for conductive bonding material is examined. In other words, a variety of ratio is applied to the weight ratio of urethane resin used as chief agent for a coat layer of the current collector electrode 200 to blocked isocyanate used as a curing agent, such as 100:1, 50:1, 20:1, and 10:1. The gel separation percentage of the conductive bonding material is 5, 15, 85, and 100 % under the above conditions. Dissociation temperature of the actually-used blocked isocyanate is 150 °C in the same way as for Embodiment 1.

Other conditions are the same as for Embodiment 26.

Ten pieces of triple cell shown in Figs. 4A to 4C are made and the same evaluation as for Embodiment 26 is performed. The evaluation result is shown in Table 8.

**[Table 8]**

| Resin-curing agent ratio | 100:1 | 50:1 | 20:1 | 10:1 |
|---|---|---|---|---|
| Initial status Transformation efficiency(%) | 7.8 | 9.2 | 9.7 | 9.6 |
| Series resistance(Ω cm²) | 39.9 | 33.8 | 31.0 | 31.7 |
| Shunt resistance(kΩ cm²) | 19.3 | 185 | 389 | 394 |
| Status after confidence test | | | | |
| Transformation efficiency(%) | 6.1 | 8.4 | 9.7 | 9.6 |
| Series resistance(Ω cm²) | 51.2 | 38.9 | 31.1 | 31.9 |
| Shunt resistance(kΩ cm²) | 14.9 | 177 | 378 | 382 |

As apparent from Table 8, higher transformation efficiency can be obtained since the series resistance is decreased by the heating pressure-bonding temperature higher than the dissociation temperature of the blocked isocyanate which is a curing agent contained in the conductive bonding material. In addition, it is also clear that higher reliability is secured because of less increase of the series resistance and less decrease of the transformation efficiency after the confidence test.

**TABLE 9**

| | Embodiment 1 | Comparison 1 | Embodiment 2 | Embodiment 3 | Embodiment 4 |
|---|---|---|---|---|---|
| Wire material | Copper | Copper | Copper | Silver | Gold |
| Wire surface | None | None | None | None | None |
| First layer filler | None | None | None | None | None |
| First layer resin | None | None | None | None | None |
| First layer crosslinking density | None | None | None | None | None |
| First layer curring agent | None | None | None | None | None |
| First layer solvent | None | None | None | None | None |
| First layer film gauge (µm) | None | None | None | None | None |
| First layer specific resistance (Ω cm) | None | None | None | None | None |
| Second layer filler | Carbon | Carbon | ITO | SnO₂ | In₂O₃ |
| Second layer resin | Urethane | Fluorine | Butyral | Urethane | Polyamide |
| Second layer curing agent | B.I | | B.I | B.I | B.I |
| Second layer solvent | Ethyl acetate IPA | Ethyl acetate IPA | Ethyl acetate IPA | Ethyl acetate IPA | Ethyl acetate IPA |
| Second layer film gauge | 20 | 20 | 20 | 20 | 20 |
| Second layer specific resistance | 0.6 | 0.1 | 1.2 | 5.0 | 1.5 |
| Temperature /time during bonding | 200/45s | 200/20M | 200/45s | 200/45s | 200/45s |
| Substrate | SUS | SUS | SUS | SUS | SUS |
| Type of solar battery | Si/SiGe/ SiGe | Si/SiGe/ SiGe | Si/SiGe/ SiGe | Si/SiGe/ SiGe | Si/SiGe/ SiGe |
| Type of confidence test | HF | HF | HF | HF | HF |
| Initial yield | 94 | 64 | 94 | 92 | 90 |
| Efficiency before test (%) | 9.6±0.02 | 9.0±1.2 | 9.7±0.05 | 9.1±0.06 | 9.2±0.01 |
| Efficiency after test | -2% | -11% | -2% | -2.5% | -2% |
| Rs before test (Ω cm²) | 32.0 | 32.1 | 32.5 | 32.9 | 32.3 |
| Rs after test (k Ω cm²) | No change | 62 | No change | No change | No change |
| RshDk before test | 200-300 | 4-300 | 200-300 | 250-400 | 400-500 |
| RshDk after test | No change | No change | No change | No change | No change |

**TABLE 10**

| | Embodiment 5 | Embodiment 6 | Embodiment 7 | Embodiment 8 | Embodiment 9 | Embodiment 10 |
|---|---|---|---|---|---|---|
| Wire material | Copper | Copper | Copper | Copper | Copper | Copper |
| Wire surface | Silver cladding | Silver cladding | Silver cladding | Silver plating | Tin plating | Silver pasting |
| First layer filler | None | None | None | None | None | None |
| First layer resin | None | None | None | None | None | None |
| First layer crosslinking density | None | None | None | None | None | None |
| First layer curing agent | None | None | None | None | None | None |
| First layer solvent | None | None | None | None | None | None |
| First layer film gauge (µm) | None | None | None | None | None | None |
| First layer specific resistance (Ω cm) | None | None | None | None | None | None |
| Second layer filler | Carbon | ZnO₂ | ZnO₂ +AI | TiO₂ | Graphite | Carbon |
| Second layer resin | Urethane | Butyral | Phenoxy | Urethane | Polyamide- | Urethane |
| Second layer curing agent | B.I | B.I | B.I | B.I | B.I | B.I |
| Second layer solvent | Ethyl acetate IPA | Ethyl acetate IPA | Ethyl acetate IPA | Ethyl acetate IPA | Ethyl acetate IPA | Ethyl acetate IPA |
| Second layer film gauge | 20 | 20 | 20 | 20 | 20 | 20 |
| Second layer specific resistance | 0.6 | 1.3 | 0.9 | 1.1 | 2.0 | 0.6 |
| Temperature /time during bonding | 200/45s | 200/45s | 200/45s | 200/45s | 200/45s | 200/45s |
| Substrate | SUS | SUS | SUS | SUS | SUS | SUS |
| Type of solar battery | Si/SiGe/ SiGe | Si/SiGe/ SiGe | Si/SiGe/ SiGe | Si/SiGe/ SiGe | Si/SiGe/ SiGe | Si/SiGe/ SiGe |
| Type of confidence test | HF | HF | HF | HF | HF | HF |
| Initial yield | 96 | 94 | 92 | 92 | 94 | 88 |
| Efficiency before test | 9.7±0.03 | 9.6±0.02 | 9.6±0.08 | 9.5±0.01 | 9.3±0.09 | 9.2±0.08 |
| Efficiency after test (%) | -1.5% | -2% | -2% | -2.3% | -2.9% | -2.1% |
| Rs before test (Ω cm²) | 31.4 | 31.7 | 31.5 | 31.6 | 33.6 | 31.8 |
| Rs after test (k Ω cm²) | No change | No change | No change | No change | No change | No change |
| RshDk before test | 300-400 | 310-390 | 400-500 | 320-380 | 400-500 | 150-200 |
| RshDk after test | No change | No change | No change | No change | No change | No change |

**TABLE 11**

| | Embodiment 1 | Embodiment 11 | Embodiment 12 | Embodiment 13 | Embodiment 14 | Embodiment 15 |
|---|---|---|---|---|---|---|
| Wire material | Copper | Copper | Copper | Copper | Copper | Copper |
| Wire surface | None | None | None | None | None | None |
| First layer filler | None | None | None | None | None | None |
| First layer resin | None | None | None | None | None | None |
| First layer crosslinking density | None | None | None | None | None | None |
| First layer curing agent | None | None | None | None | None | None |
| First layer solvent | None | None | None | None | None | None |
| First layer film gauge (µm) | None | None | None | None | None | None |
| First layer specific resistance (Ω cm) | None | None | None | None | None | None |
| Second layer filler | Carbon | Carbon | Carbon | Carbon | Carbon | Carbon |
| Second layer resin | Urethane | Urethane | Urethane | Urethane | Urethane | Urethane |
| Second layer curing agent | B.I | B.I | B.I | B.I | B.I | B.I |
| Second layer solvent | Ethyl acetate IPA | Ethyl acetate IPA | Ethyl acetate IPA | Ethyl acetate IPA | Ethyl acetate IPA | Ethyl acetate IPA |
| Second layer film gauge | 20 | 20 | 20 | 20 | 20 | 20 |
| Second layer specific resistance | 0.6 | 0.6 | 0.6 | 0.6 | 0.6 | 0.6 |
| Temperature /time during bonding | 200/45s | 200/45s | 200/45s | 200/45s | 200/45s | 200/45s |
| Substrate | SUS | SUS | SUS | SUS | SUS | Wafer |
| Type of solar battery | Si/SiGe/ SiGe | Si single | Si/Si | Si/SiGe | SiC/Si/ SiGe | Single-crystal Si |
| Type of confidence test | HF | HF | HF | HF | HF | HF |
| Initial yield | 94 | 90 | 94 | 92 | 92 | 98 |
| Efficiency before test (%) | 9.6 | 5.2±0.05 | 7.5±0.01 | 7.7±0.02 | 9.5±0.06 | 15.8 |
| Efficiency after test | -2% | -2.4% | -1.9% | -2.3% | -2.4% | -1.9% |
| Rs before test (Ω cm²) | 32.0 | 9.5 | 23.1 | 21.1 | 33.7 | 2.8 |
| Rs after test (Ω cm²) | No change | No change | No change | No change | No change | No change |
| RshDk before test | 200-300 | 150-320 | 400-500 | 250-310 | 260-330 | 500-760 |
| RshDk after test | No change | No change | No change | No change | No change | No change |

**TABLE 12**

| | Embodiment 16 | Embodiment 17 | Embodiment 18 | Embodiment 19 | Embodiment 20 | Embodiment 21 |
|---|---|---|---|---|---|---|
| Wire material | Copper | Copper | Copper | Copper | Copper | Copper |
| Wire surface | None | None | None | None | None | None |
| First layer filler | None | None | None | None | None | None |
| First layer resin | None | None | None | None | None | None |
| First layer crosslinking density | None | None | None | None | None | None |
| First layer curing agent | None | None | None | None | None | None |
| First layer solvent | None | None | None | None | None | None |
| First layer film gauge (µm) | None | None | None | None | None | None |
| First layer specific resistance (Ω cm) | None | None | None | None | None | None |
| Second layer filler | Carbon | Carbon | Carbon | Carbon | Carbon | Carbon |
| Second layer resin | Urethane | Urethane | Urethane | Urethane | Urethane | Urethane |
| Second layer curing agent | B.I | B.I | B.I | B.I | B.I | B.I |
| Second layer solvent | Ethyl acetate IPA | Ethyl acetate IPA | Ethyl acetate IPA | Ethyl acetate IPA | Ethyl acetate IPA | Ethyl acetate IPA |
| Second layer film gauge | 20 | 20 | 20 | 20 | 20 | 20 |
| Second layer specific resistance | 0.6 | 0.6 | 0.005-200 | 0.6 | 0.6 | 0.6 |
| Temperature /time during bonding | 200/45s | 200/45s | 200/45s | Temperature range | Time range | 200/45s |
| Substrate | Wafer | Metal Si | SUS | SUS | SUS | SUS |
| Type of solar battery | Polycrystalline Si | Thin-film polycrystal | Si/SiGe/ SiGe | Si/SiGe/ SiGe | Si/SiGe/ SiGe | Si/SiGe/ SiGe |
| Type of confidence test | HF | HF | HF | HF | HF | HF |
| Initial yield | 96 | 92 | - | - | - | - |
| Efficiency before test | 13.8% | 12.5% | - | - | - | - |
| Efficiency after test (%) | -2% | -2.1% | - | - | - | - |
| Rs before test (Ω cm²) | 2.6 | 4.5 | - | - | - | - |
| Rs after test (Ω cm²) | No change | No change | - | - | - | - |
| RshDK before test | 450-650 | 400-510 | - | - | - | - |
| RshDk after test | No change | No change | - | - | - | - |

**TABLE 13**

| | Embodiment 22 | Comparison 2 | Embodiment 23 | Embodiment 24 | Embodiment 25 |
|---|---|---|---|---|---|
| Wire material | Copper | Copper | Copper | Silver | Gold |
| Wire surface | None | None | None | None | None |
| First layer filler | Carbon | None | Carbon | Carbon | Graphite |
| First layer resin | Urethane | None | Epoxy | Urethane | Urethane |
| First layer curing agent | B.I | None | B.I | B.I | B.I |
| First layer solvent | BCA. xylene | None | BCA. xylene | BCA. xylene | BCA. xylene |
| First layer film gauge (µm) | 5 | None | 5 | 5 | 5 |
| First layer specific resistance (Ω cm) | 1.0 | None | 2.1 | 1.0 | 1.8 |
| Second layer filler | Carbon | Silver | Carbon | ITO | SnO₂ |
| Second layer resin | Urethane | Polyester | Urethane | Urethane | Urethane |
| Second layer curring agent | B.I | | B.I | B.I | B.I |
| Second layer solvent | Cyclohexanone | Carbitol | Cyclohexanone | Cyclohexanone | Cyclohexanone |
| Second layer film gauge | 20 | 20 | 20 | 20 | 20 |
| Second layer specific resistance | 0.5 | 0.5 | 0.5 | 1.0 | 1.4 |
| Temperature /time during bonding | 200/45s | 150/30m | 200/45s | 200/45s | 200/45s |
| Substrate | SUS | SUS | SUS | SUS | SUS |
| Type of solar battery | Si/SiGe/ SiGe | Si/SiGe/ SiGe | Si/SiGe/ SiGe | Si/SiGe/ SiGe | Si/SiGe/ SiGe |
| Type of confidence test | HF/HHL | HHL | HF/HHL | HF/HHL | HF/HHL |
| Initial yield | 98 | 54 | 96 | 94 | 96 |
| Efficiency before test (%) | 9.6±0.02 | 7.5±1.8 | 9.4±0.06 | 9.5±0.07 | 9.3±0.01 |
| Efficiency after test (%) | -2% | -20% | -2.6% | -2.3% | -2.1% |
| Rs before test (Ω cm²) | 32.0 | 32.0 | 32.2 | 32.5 | 33.0 |
| Rs after test (Ω cm²) | No change | No change | No change | No change | No change |
| RshDk before test | 200-500 | 1.8 | 400-500 | 300-500 | 230-420 |
| RshDk after test | No change | 0.8 | No change | No change | No change |

**TABLE 14**

| | Embodiment 26 | Embodiment 27 | Embodiment 28 | Embodiment 29 | Embodiment 30 | Embodiment 31 |
|---|---|---|---|---|---|---|
| Wire material | Copper | Copper | Copper | Copper | Copper | Copper |
| Wire surface | Silver cladding | Silver cladding | Silver plating | Tin plating | Gold plating | Silver pasting |
| First layer filler | Carbon | ZnO | Carbon | ZnO₂ +Al | Carbon | Carbon |
| First layer resin | Urethane | Urethane | Phenol | Urethane | Phenoxy | Urethane |
| First layer curing agent | B.I | B.I | B.I | B.I | B.I | B.I |
| First layer solvent | BCA. xylene | BCA. xylene | BCA. xylene | BCA. xylene | BCA. xylene | BCA. xylene |
| First layer film gauge (µm) | 5 | 5 | 5 | 5 | 5 | 5 |
| First layer specific resistance (Ω cm) | 1.0 | 1.4 | 1.5 | 0.9 | 1.0 | 1.0 |
| Second layer filler | Carbon | In₂O₃ | Carbon | TiO₂ | Carbon | Carbon |
| Second layer resin | Urethane | Urethane | Polyamide | Urethane | Polyamideimide | Urethane |
| Second layer curing agent | B.I | B.I | B.I | B.I | B.I | B.I |
| Second layer solvent | Cyclohexanone | Cyclohexanone | Cyclohexanone | Cyclohexanone | Cyclohexanone | Cyclohexanone |
| Second layer film gauge | 20 | 20 | 20 | 20 | 20 | 20 |
| Second layer specific resistance | 0.5 | 0.7 | 0.8 | 1.5 | 2.0 | 0.5 |
| Temperature /time during bonding | 200/45s | 200/45s | 200/45S | 200/45s | 200/45s | 200/45s |
| Substrate | SUS | SUS | SUS | SUS | SUS | SUS |
| Type of solar battery | Si/SiGe/ SiGe | Si/SiGe/ SiGe | Si/SiGe/ SiGe | Si/SiGe/ SiGe | Si/SiGe/ SiGe | Si/SiGe/ SiGe |
| Type of confidence test | HF/HHL | HF/HHL | HF/HHL | HF/HHL | HF/HHL | HF/HHL |
| Initial yield | 98 | 96 | 96 | 94 | 96 | 94 |
| Efficiency before test (%) | 9.7±0.02 | 9.6±0.01 | 9.3±0.01 | 9.4±0.01 | 9.5±0.05 | 9.4±0.08 |
| Efficiency after test (%) | -2% | -2.2% | -2.8% | -2.1% | -3.0% | -2.4% |
| Rs before test (Ω cm²) | 31.8 | 32.1 | 32.7 | 32.6 | 34.1 | 32.0 |
| Rs after test (Ω cm²) | No change | No change | No change | No change | No change | No change |
| RshDk before test | 400-500 | 320-390 | 400-500 | 360-430 | 240-350 | 190-300 |
| RshDk after test after | No change | No change | No change | No change | No change | No change |

**TABLE 15**

| | Embodiment 26 | Embodiment 32 | Embodiment 33 | Embodiment 34 | Embodiment 35 |
|---|---|---|---|---|---|
| Wire material | Copper | Copper | Copper | Copper | Copper |
| Wire surface | Silver clading | Silver clading | Silver clading | Silver clading | Silver clading |
| First layer filler layer | Carbon | Carbon | Carbon | Carbon | Carbon |
| First layer resin | Urethane | Urethane | Urethane | Urethane | Urethane |
| First layer curing agent | B.I | B.I | B.I | B.I | B.I |
| First layer solvent | Ethyl acetate IPA | Ethyl acetate IPA | Ethyl acetate IPA | Ethyl acetate IPA | Ethyl acetate IPA |
| First layer film gauge (µm) | 5 | 5 | 5 | 5 | 5 |
| First layer specific resistance (Ω cm) | 1.0 | 1.0 | 1.0 | 1.0 | 1.0 |
| Second layer filler | Carbon | Carbon | Carbon | Carbon | carbon |
| Second layer resin | Urethane | Urethane | Urethane | Urethane | Urethane |
| Second layer curing agent | B.I | B.I | B.I | B.I | B.I |
| Second layer solvent | Cyclohexanone | Cyclohexanone | Cyclohexanone | Cyclohexanone | Cyclohexanone |
| Second layer film gauge | 20 | 20 | 20 | 20 | 20 |
| Second layer specific resistance | 0.5 | 0.5 | 0.5 | 0.5 | 0.5 |
| Temperature /time during bonding | 200/45s | 200/45s | 200/45s | 200/45s | 200/45s |
| Substrate | SUS | SUS | SUS | SUS | SUS |
| Type of solar battery | Si/SiGe/ SiGe | Si single | Si/Si | Singlecrystal Si | Polycrystalline Si |
| Type of confidence test | HF/HHL | HF/HHL | HF/HHL | HF/HHL | HF/HHL |
| Initial yield | 98 | 92 | 96 | 98 | 96 |
| Efficiency before test (%) | 9.7±0.02 | 5.2±0.05 | 7.5±0.08 | 15.8±0.01 | 13.8±0.05 |
| Efficiency after test (%) | -2% | -2.4% | -1.9% | -1.9% | -2% |
| Rs before test (Ω cm²) | 31.8 | 9.5 | 23.1 | 2.8 | 2.6 |
| Rs after test (Ω cm ) | No change | No change | No change | No change | No change |
| RshDk before test | 400-500 | 150-320 | 400-500 | 500-760 | 450-650 |
| RshDk after test | No change | No change | No change | No change | No change |

**TABLE 16**

| | Embodiment 36 | Embodiment 37 | Embodiment 38 | Embodiment 39 | Embodiment 40 |
|---|---|---|---|---|---|
| Wire material | Copper | Copper | Copper | Copper | Copper |
| Wire surface | Silver cladding | Silver cladding | Silver cladding | Silver cladding | Silver cladding |
| First layer filler | Carbon | Carbon | Carbon | Carbon | Carbon |
| First layer resin | Urethane | Urethane | Urethane | Urethane | Urethane |
| First layer curing agent | B.I | B.I | B.I | B.I | B.I |
| First layer solvent | Ethyl acetate IPA | Ethyl acetate IPA | Ethyl acetate IPA | Ethyl acetate IPA | Ethyl acetate IPA |
| First layer film gauge (µm) | 5 | 5 | 5 | 5 | 5 |
| First layer specific resistance (Ω cm) | 1.0 | 1.0 | 1.0 | 1.0 | 1.0 |
| Second layer filler | Carbon | Carbon | Carbon | Carbon | Carbon |
| Second layer resin | Urethane | Urethane | Urethane | Urethane | Urethane |
| Second layer curing agent | B.I | B.I | B.I | B.I | B.I |
| Second layer solvent | Cyclohexanone | Cyclohexanone | Cyclohexanone | Cyclohexanone | Cyclohexanone |
| Second layer film gauge | 20 | 20 | 20 | 20 | 20 |
| Second layer specific resistance | 0.5 | 0.005-200 | - | - | Amount of curing agent |
| Temperature /time during bonding | 200/45s | 200/45s | Temperature range | Time range | 200/45s |
| Substrate | SUS | SUS | SUS | SUS | SUS |
| Type of solar battery | Thin-film polycrystal | Si/SiGe/ SiGe | Si/SiGe/ SiGe | Si/SiGe/ SiGe | Si/SiGe/ SiGe |
| Type of confidence test | HF/HHL | HF/HHL | HF/HHL | HF/HHL | HF/HHL |
| Initial yield | 94 | - | - | - | - |
| Efficiency before test (%) | 12.5±0.01 | - | - | - | - |
| Efficiency after test (%) | -2.1% | - | - | - | - |
| Rs before test (Ω cm²) | 4.5 | - | - | - | - |
| Rs after test (Ω cm²) | No change | - | - | - | - |
| RshDk before test | 400-510 | - | - | - | - |
| RshDk after test | No change | - | - | - | - |

### (Embodiment 41)

In this embodiment, a photovoltaic element is made, having current collector electrodes to which heat-hardening conductive bonding material is applied, and its performance is confirmed in the procedure described below.

The following describes a method of preparing paste No. 4 for forming the heat-hardening conductive bonding material constituting the coat layer of the current collector electrodes.
(1) Mixed solvent containing 17.4 g of butyl carbitol acetate and 11.6 g of methyl ethyl ketone were taken into a shaker for dispersion as solvent.
(2) Butyral resin BL-S manufactured by Sekisui Chemical Co., Ltd. used as chief agent of binder was added by 8.9 g to the solvent in the shaker and it was stirred with a ball mill until it was sufficiently dissolved.
(3) As a curing agent, 1.40 g of blocked isocyanate B-815N manufactured by Takeda Chemical Industries, Ltd. and 15 g of glass beads for dispersion were added to said solvent.
(4) As conductive grains, 5.3 g of Conductex 975 beads manufactured by Colombian Carbon, Ltd. were added to said solvent and it was placed statically until the conductive grains were settled out sufficiently in said solvent.
(5) Dispersion was made for the shaker containing the above materials for 12 hours by using a paint shaker manufactured by Toyo Seiki Seisakuzyo, Ltd. The time was obtained through an experiment for finding a lapse of time in which volume resistivity of the paste No. 4 was decreased to the lowest level.
(6) Afterwards, glass beads for dispersion were removed from the paste No. 4. The paste No. 4 was cured under the standard curing conditions on said curing agent, 160 °C of the temperature and 30 min. of the time and its volume resistivity was measured. As a result of the measurement, 0.8 Ωcm was obtained, by which it could be confirmed that the resistivity was sufficiently low.
(7) By using a longitudinal type of a wire coater 300 shown in Fig. 3, silver-cladded copper wire having a diameter of 100 µm was coated with the paste No. 4. For a die 605 for enamel coating used for wire coating, was used a PVF die manufactured by Osaka Diamond, Ltd. As for a drying oven 606, two IR ovens SS-09 (infrared ovens) manufactured by Sakaguchi Dennetsu, Ltd. were placed in a longitudinal direction and assembled at the position opposite to each other so as to be used. An atmospheric temperature in the drying oven was set to a desired level by an operation with a temperature controller 311. In pulling up the Cu wire, a servo motor (not shown) was used for controlling a pulling-up speed. An orientation roll driving gear 309 were placed in a side of a wire roller reel. Additionally, an LS-3100/3034 film-thickness measuring apparatus 307 manufactured by Keyence, Ltd. was placed at an outlet of the drying oven to measure a thickness of the coat of the conductive bonding material and then it was measured.

The following describes conditions on forming said paste No. 4 as a first coat layer 202.

The wire rolling speed is 8.9 mm/s, the curing time is 60 sec., the temperature in the drying oven is 280 °C, and a bore diameter of the die used for enamel coating is 180 µm. The conditions were obtained through an experiment for finding a status in which curing reaction of the paste No. 4 progressed enough without any falling off of the paste No. 4. Concretely, it was confirmed by ultrasonic cleaning of the coated wire for 30 sec. with methyl ethyl ketone to check that any conductive bonding material made of the paste No. 4 would not fall off. The conductive bonding material made of the paste No. 4 applied to the silver-cladded copper wire existed in a cured status with progressed crosslinking. The thickness of the first coat layer 202 was 11 µm at an average and a deflection of the thickness of the coat was within a range of ±1 µm as a result of the coating in 100 m length.

The following describes forming conditions on a second coat layer 203 to which said heat-hardening conductive bonding material (paste No. 4) is applied and a method of fabricating the current collector electrodes used for the photovoltaic element of the present invention.

The wire rolling speed is 8.9 mm/s, the drying time is 60 sec., the temperature in the drying oven is 120 °C, and a bore diameter of the die used for enamel coating is 200 µm. The conditions were obtained through an experiment for finding a status in which the temperature was lower than the dissociation temperature of blocked isocyanate without any tack of the conductive bonding material No. 1 applied to said wire but with sufficient adhesion to the wire. The conductive bonding material made of the paste No. 4 applied to said wire existed in a thermoplastic status with the solvent volatilized. The thickness of a coat layer 303 is 8 µm at an average and a deflection of the thickness of the coat was within a range of ±1.5 µm as a result of the coating in 100 m length.

The following describes a process of fabricating ten photovoltaic element modules.
(1) Fig. 10 illustrates a photovoltaic element module having current collector electrodes 1004 created in said method. A substrate 1001 which was used had a pin-typed double cell coated with CVD on an SUS substrate combined with a minus electrode. In addition, a transparent conductive coat made of In₂O₃ was formed as a plus electrode in the incident side of light.
(2) The substrate 1001 has an effective area of 30 x 30 cm. Patterns are printed on the substrate by using etching paste containing ferric chloride as chief ingredient, a commercial printer, and a printing plate for etching and undesired portions of transparent conductive coat were removed.
(3) Next, a plus electrode 1002 of hard copper and a minus electrode 1003 were set outside the effective area, and said current collector electrodes 1004 were expanded between the both plus electrodes 202 so that they were within the effective area at 7-mm intervals and they were fixed temporarily with ultraviolet curing adhesive outside the plus electrode, in other words, outside the effective area.
(4) Afterwards, said current collector electrodes 1004 were contact-bonded with heating on a cell surface of the substrate 1001. It was performed under the conditions of 1 kg/cm² pressure and heating conditions based on a profile such as increasing the temperature up to 200 °C in 60 min. in a ramp state and then cooling them in 20 min. The heating conditions were obtained through an experiment with measuring adhesivity of the current collector electrodes to the cell surface of the photovoltaic elements and observing a sectional configuration of the current collector electrodes which were bonded.

Although the plus electrode is kept in conduction with the current collector electrodes in said heating pressure-bonding process, dotting with silver paste or soldering can be performed to enhance the confidence. The heating pressure-bonding is performed with a device having a capability of simultaneous heating and pressurizing for a vacuum laminator.

Ten photovoltaic element modules were fabricated in the above process.

The following describes a result of investigating initial characteristics of the obtained samples (in other words, the above photovoltaic element modules).
(1) Voltage-current characteristics in a dark state of said samples were measured. The shunt resistance was examined on the basis of an inclination around the origin. As a result of the examination, favorable values, 200 kΩcm² to 500 kΩcm² were obtained.
(2) By using a simulated sun light source (hereinafter "simulator") having 100 mW/cm² quantity of light in the AM1.5 global sun light spectrum, characteristics of the solar battery for said samples were examined with measurement. Characteristics of measured transformation efficiency 7.9±0.02 % were favorable and relatively uniform.

Next, encapsulation of said samples was performed in the following procedure. Clean glass and EVA were cladded on the both sides of the substrate 1001, then further fluoroplastic film ETFE was laminated on the both sides of it, and it was put into a vacuum laminator for lamination with keeping its temperature 150 °C for 60 min.

A confidence test was performed for the samples after the lamination. The test was based on the temperature and relative humidity cycle test A-2 defined in an environmental test method and an endurance test method of crystal-system solar battery modules of Japan Industrial Standard C8917.

A cycle test was repeated 20 times by putting the samples into a constant temperature and humidity bath whose inside temperature and humidity were controllable to change the temperature from -40 °C to +85 °C (relative humidity: 85 %). Afterwards, when characteristics of the solar battery were examined for the samples after the completion of the test by using the simulator in the same manner as for the initial state, a decrease of 2 % at an average was obtained in comparison with the initial transformation efficiency without any significant deterioration.

As a result of this embodiment, it has been understood that the photovoltaic element of the present invention has favorable characteristics and secures higher reliability.

### (Comparison 3)

This example differs from Embodiment 41 in that thermoplastic conductive bonding material is used instead of the heat-hardening conductive bonding material used in Embodiment 41. Current collector electrodes and samples were made by using thermoplastic conductive bonding material 107-25 manufactured by CMI, Ltd. for a first coat layer 202 shown in Fig. 2A.

The first coat layer 202 was formed on the conditions below by using said conductive bonding material 107-25 to make the current collector electrodes.

The wire rolling speed is 8.9 mm/s, the drying time is 60 sec., the temperature in the drying oven is 120 °C, and a bore diameter of the die used for enamel coating is 180 µm. The thickness of a coat layer 202 is 8 µm at an average and a deflection of the thickness of the coat was within a range of ±1.5 µm as a result of the coating in 100 m length.

The second coat layer 203 was formed on the same conditions by using conductive bonding material made of the paste No. 4 which was the same as for Embodiment 1.

Next, as the same manner as for Embodiment 41, said current collector electrodes 1004 were contact-bonded with heating on the cell surface of the substrate 1001. It was performed under the conditions of 1 kg/cm² pressure and heating conditions based on a profile such as increasing the temperature up to 150 °C in 40 min. in a ramp state and then cooling them in 20 min.

In addition, ten photovoltaic element modules were fabricated in the same manner as for Embodiment 1.

As a result of encapsulation of these samples in the same manner as for Embodiment 41 for measurement of initial characteristics, were obtained transformation efficiency 7.8 % at an average and series resistance 27 Ωcm².

As the same manner as for Embodiment 41, a cycle test was repeated 20 times by putting the samples into the constant temperature and humidity bath whose inside temperature and humidity were controllable to change the temperature from -40 °C to +85 °C (relative humidity: 85 %). Afterwards, when characteristics of the solar battery were examined for the samples after the completion of the test by using the simulator in the same manner as for the initial state. A decrease of 10 % at an average was obtained in comparison with the initial transformation efficiency, which was a significant deterioration.

The deterioration is caused by an increase of the series resistance, such as, for example, an increase of an interface resistance between metal wire and thermoplastic bonding material due to a change of humidity and an increase of volume resistivity due to deterioration of the conductive bonding material.

### (Embodiment 42)

In this embodiment, were examined effects of coating of the moisture barrier paint for ten samples fabricated in the same manner as for Embodiment 41 being placed in a state before encapsulation.

Other characteristics are the same as for

### (Embodiment 41)

When initial characteristics of the samples were measured in the same manner as for Embodiment 41, characteristics of measured transformation efficiency 7.9±0.02 % and series resistance 24 Ωcm² were favorable and relatively uniform.

Said samples were hardened by drying on temperature conditions of increasing the temperature from 80 °C to 190 °C in a ramp state in a hot-air drying oven after they were coated by hard coat material, Fine Hard manufactured by Toa Nenryo Kogyo K.K. with a spray.

When characteristics of the samples after the hard coating were gauged by using said simulator, the transformation efficiency 7.8 % and series resistance 28 Ωcm² were obtained without any significant deterioration.

### (Comparison 4)

In this embodiment, were examined effects of coating of the moisture barrier paint for ten samples fabricated in the same manner as for Comparison 3 being placed in a state before encapsulation.

Other characteristics are the same as for Embodiment 41.

When initial characteristics of the samples were measured in the same manner as for Embodiment 41, characteristics of measured transformation efficiency 7.9±0.02 % and series resistance 24 Ωcm² were favorable and relatively uniform.

In the same manner as for Embodiment 42, said samples were hardened by drying on temperature conditions of increasing the temperature from 80 °C to 190 °C in a ramp state in a hot-air drying oven after they were coated by hard coat material, Fine Hard manufactured by Toa Nenryo Kogyo K.K. with a spray.

When characteristics of the samples after the hard coating were gauged by using said simulator, the transformation efficiency 5.5 % and series resistance 60 Ωcm² were obtained, which was a significant deterioration.

The deterioration may be caused by an increase of the volume resistivity due to peeling of the conductive bonding material on the electrode metal caused by the hard coat solvent soaking inside the electrodes and deterioration of the thermoplastic conductive bonding material caused by heating in a hardening process of the coat material.

### (Embodiment 43)

This embodiment differs from Embodiment 41 in that a mixture of carbon black and urethane resin is used for a binder of the conductive bonding material instead of the Butyral resin of Embodiment 41 to make current collector electrodes and samples.

The following describes a method of making paste No. 5 for forming a single-liquid typed heat-hardening conductive bonding material constituting a coat layer of the current collector electrodes.
(1) Mixed solvent containing 17.0 g of butyl carbitol acetate and 11.6 g of methyl ethyl ketone were taken into a shaker for dispersion as solvent.
(2) Urethane resin 5120 manufactured by Nippon Polyurethane, Ltd. used as a chief agent of binder was added by 8.9 g to the solvent in the shaker, then it was stirred with a ball mill until it was sufficiently dissolved.
(3) As a curing agent, 1.4 g of blocked isocyanate 2515 manufactured by Nippon Polyurethane, Ltd. and 15 g of glass beads for dispersion were added to said solvent.
(4) As conductive grains, 5.3 g of Conductex 975 beads manufactured by Colombian Carbon, Ltd. were added to said solvent and it was placed statically until the conductive grains were settled out sufficiently in said solvent.
(5) Dispersion was made for the shaker containing the above materials for 12 hours by using a paint shaker.
(6) Afterwards, glass beads for dispersion were removed from the paste No. 5.
(7) The paste No. 5 was cured under the standard curing conditions on said curing agent, 180 °C of the temperature and 30 min. of the time and its volume resistivity was measured. As a result of the measurement, 5.1 Ωcm was obtained, by which it could be confirmed that the resistivity was sufficiently low. The following describes conditions on forming said paste No. 5 as the first coat layer 202 by using a wire coater 300.

The wire rolling speed is 8.9 mm/s, the curing time is 60 sec., the temperature in the drying oven is 280 °C, and a bore diameter of the die used for enamel coating is 180 µm. The thickness of the first coat layer 202 was 11 µm at an average and a deflection of the thickness of the coat was within a range of ±1 µm as a result of the coating in 100 m length.

In addition, the following describes conditions on forming conductive bonding material made of said paste No. 5 as the second coat layer 203 by using the wire coater 300.

The wire rolling speed is 8.9 mm/s, the drying time is 60 sec., the temperature in the drying oven is 120 °C, and a bore diameter of the die used for enamel coating is 200 µm. The conditions were obtained through an experiment for finding a status in which the temperature was lower than the dissociation level of blocked isocyanate without any tack of the paste No. 5 applied to said wire. The conductive bonding material made of the paste No. 5 applied to said wire existed in a thermoplastic status with the solvent volatilized. The thickness of the coat layer 203 is 8 µm at an average and a deflection of the thickness of the coat was within a range of ±1.5 µm as a result of the coating in 100 m length.

Next, ten photovoltaic element modules were fabricated in the same manner as for Embodiments 41 and 42.

As a result of measuring initial characteristics of the samples attained in this embodiment in the same manner as for Embodiment 1, transformation efficiency was 7.8 % at an average and the series resistance was 25 Ωcm².

Subsequently, was performed the same temperature and humidity cycle test as for Embodiment 41, and deterioration rate 1.5 % was obtained at an average in comparison with the initial transformation efficiency without any significant deterioration.

As a result of this embodiment, it has been understood that the photovoltaic element of the present invention has favorable characteristics and secures higher reliability.

### (Embodiment 44)

This embodiment differs from Embodiment 41 in that titanium oxide is used for a filler of the conductive bonding material used for the first coat layer 202 instead of the Conductex 975 beads of Embodiment 41 to make current collector electrodes and samples. The second coat layer 203 was formed on the same conditions by using conductive bonding material made of the paste No. 4 same as for Embodiment 41.

The following describes a method of preparing paste No. 6 for forming the conductive bonding material constituting the coat layer of the current collector electrodes.
(1) Mixed solvent containing 17.4 g of butyl carbitol acetate and 11.6 g of methyl ethyl ketone were taken into a shaker for dispersion as solvent.
(2) Butyral resin BL-S manufactured by Sekisui Chemical Co., Ltd. used as chief agent of binder was added by 8.9 g to the solvent in the shaker and it was stirred with a ball mill until it is fully dissolved.
(3) As a curing agent, 1.4 g of blocked isocyanate B-815N manufactured by Takeda Chemical Industries, Ltd. and 15 g of glass beads for dispersion were added to said solvent.
(4) As conductive grains, 5.3 g of titanium oxide powder FT-1000 manufactured by Ishihara Sangyo, Ltd. was added to said solvent and it was placed statically until the conductive grains were settled out sufficiently in said solvent.
(5) Dispersion was made for the shaker containing the above materials for 10 hours by using a paint shaker manufactured by Toyo Seiki Seisakujyo, Ltd.
(6) Afterwards, glass beads for dispersion were removed from the paste No. 6. The paste No. 6 was cured under the standard curing conditions on said curing agent, 160 °C of the temperature and 30 min. of the time and its volume resistivity was measured. As a result of the measurement, 8 Ωcm was obtained, by which it could be confirmed that the resistivity was sufficiently low.
(7) Subsequently, current collector electrodes were made by forming the first coat layer 202 with conductive bonding material made of the paste No. 6 on the same conditions as for Embodiment 41.

Next, ten photovoltaic element modules were fabricated in the same manner as for Embodiment 41.

As a result of measuring initial characteristics of the samples obtained in this embodiment in the same manner as for Embodiment 41, the transformation efficiency was 7.7 % and the series resistance was 27 Ωcm².

Subsequently, was performed the same temperature and humidity cycle test as for Embodiment 41, and deterioration rate 3 % was obtained at an average in comparison with the initial transformation efficiency without any significant deterioration.

As a result of this embodiment, it has been understood that the photovoltaic element of the present invention has favorable characteristics and secures higher reliability.

### (Embodiment 45)

In this embodiment, it was examined what effects could be obtained with changing the volume resistivity of the conductive bonding material by mixing pigment in a binder of the conductive bonding material, phenoxy resin, at a variety of the amount ratio. As said pigment amount ratio, six types of percentages, 20 wt%, 25 wt%, 30 wt%, 35 wt%, 40 wt%, and 45 wt% were used to make paste Nos. 7-1 to 7-6 for forming heat-hardening conductive bonding material.

The following describes a method of preparing paste Nos. 7-1 to 7-6.
(1) As solvent, cyclohexanone was taken into a shaker for dispersion.
(2) Phenoxy resin PKHH manufactured by Union Carbide, Ltd. used as a chief agent of binder was added to the solvent in the shaker, then it was stirred with a ball mill until it was fully dissolved.
(3) As a dispersion agent, butyral resin BL-S manufactured by Sekisui Chemical Co. Ltd. was added, and it was stirred with a ball mill.
(4) As a curing agent, blocked isocyanate B-815N manufactured by Takeda Chemical Industries, Ltd. and glass beads for dispersion were added to said solvent.
(5) As conductive grains, Conductex 975 beads manufactured by Colombian Carbon, Ltd. were added to said solvent, and it was placed statically until the filler was settled out sufficiently in said solvent.
(6) Dispersion was made for the shaker containing the above materials for 10 hours by using a paint shaker.
(7) Afterwards, glass beads for dispersion were removed from the paste Nos. 7-1 to 7-6. The paste Nos. 7-1 to 7-6 was cured under the standard curing conditions on said curing agent, 160 °C of the temperature and 30 min. of the time and its volume resistivity was measured. As a result of the measurement, the values in Table 17 were obtained.

**[Table 17]**

| Pigment ratio (wt%) | Volume resistivity (Ω cm) | Initial transformattion efficiency (%) | Material (g) | | | | |
|---|---|---|---|---|---|---|---|
| | | | Carbon | Phenoxy resin | Curing agent | Solvent | Bead |
| 20 | 892.10 | 4.00 | 3.00 | 10.80 | 1.20 | 17.40 | 15.00 |
| 25 | 10.68 | 7.52 | 3.75 | 10.13 | 1.13 | 17.40 | 15.00 |
| 30 | 2.19 | 7.60 | 4.50 | 9.45 | 1.05 | 17.40 | 15.00 |
| 35 | 0.63 | 7.70 | 5.25 | 8.78 | 0.98 | 17.40 | 15.00 |
| 40 | 0.28 | 7.85 | 6.00 | 8.10 | 0.90 | 17.40 | 15.00 |
| 45 | 0.36 | 7.81 | 6.75 | 7.43 | 0.83 | 17.40 | 15.00 |

The following describes conditions on forming conductive bonding material with said paste No. 7-1 to 7-6 as the first coat layer 202 by using the wire coater 300.

The wire rolling speed is 8.9 mm/s, the curing time is 60 sec., the temperature in the drying oven is 280 °C, and a bore diameter of the die used for enamel coating is 180 µm. The thickness of the first coat layer 302 was 11 µm at an average and a deflection of the thickness of the coat was within a range of ±1 µm as a result of the coating in 100 m length.

In addition, current collector electrodes were fabricated with the conductive bonding material made of said paste No. 4 used as the second coat layer 203 by using the wire coater 300.

Subsequently, five photovoltaic element modules were fabricated in the same manner as for Embodiment 41, each.

Transformation efficiency of the samples was measured in the same manner as for Embodiment 41 and averaged, then the values in Fig. 12 were attained.

As a result of this embodiment, it has been understood that the photovoltaic element of the present invention has favorable initial characteristics of the conductive bonding material having volume resistivity 0.1 to 100 Ωcm.

### (Embodiment 46)

In this embodiment, it was examined what effect of an ion barrier could be obtained by changing porosity of the conductive bonding material. To confirm the ion barrier effect, triple-layered current collector electrodes and photovoltaic element modules were fabricated in the following procedure by using conductive bonding material LS-708 containing silver filler manufactured by Asahi Kagaku, Ltd. as a first coat layer.
(1) Metal wire used for this embodiment is copper wire having a 100 µm diameter. The wire rolling speed is 8.9 mm/s, the drying time is 60 sec., the temperature in the drying oven is 250 °C, and a bore diameter of the die used for enamel coating is 180 µm. The thickness of the first coat layer 202 is 8 µm at an average and a deflection of the thickness of the coat was within a range of ±1.5 µm as a result of the coating in 100 m length.
(2) The second coat layer 203 was formed on the same conditions by using conductive bonding material made of the paste Nos. 7-1 to 7-6 which was the same as for Embodiment 45. As a result of measuring porosity of the conductive bonding material made of the paste Nos. 7-1 to 7-6 by using an AUTO-PORE9200 manufactured by Micromeritics, Ltd., the values in Table 18 were obtained.
(3) The third coat layer 204 was formed on the same conditions by using conductive bonding material made of the same paste No. 4 as for Embodiment 41, and triple-layered current collector electrodes 1004 were made.
(4) Subsequently, in the same manner as for Embodiment 41, said current collector electrodes 1004 were contact-bonded with heating on the cell surface of the substrate 1001. Then, encapsulation was performed in the same manner as for Embodiment 41 and initial characteristics were measured and averaged, which caused the result of values in Table 2.
(5) Next, in the same manner as for Embodiment 41, a unique test was performed for 100 hours by putting the samples into the constant temperature and humidity bath whose inside temperature and humidity are controllable to keep its temperature at +85 °C and relative humidity at 85 % and by applying 1 V of forward bias voltage. As a result of the test, the values in Table 18 were obtained as leakage current and shunt resistance after the lapse of 100 hours.

**[Table 18]**

| Pigment ratio (wt%) | Volume resistivity (Ω cm) | Porosity (ml/g) | Leakage current (mA) | | Shunt resistance (kΩ cm²) | |
|---|---|---|---|---|---|---|
| | | | Initially | After test | Initially | After test |
| 20 | 892.10 | 4.00 | 5.0 | 5.0 | 100.0 | 120.0 |
| 25 | 10.68 | 7.52 | 10.0 | 11.0 | 83.0 | 90.0 |
| 30 | 2.19 | 7.60 | 11.0 | 10.0 | 98.0 | 101.0 |
| 35 | 0.63 | 7.70 | 9.0 | 9.0 | 90.0 | 115.0 |
| 40 | 0.28 | 7.85 | 10.0 | 800.0 | 100.0 | 5.0 |
| 45 | 0.36 | 7.81 | 11.0 | 810.0 | 80.0 | 4.0 |

As for samples having 0.03 ml/g or greater porosity, leakage current 800 mA was obtained after the lapse of 100 hours and its level has gradually increased immediately after starting the test. It has turned out that a shunt has occurred because of 5 kΩcm² or less shunt resistance. It can be considered that a short circuit has occurred due to migration since silver in the conductive bonding material used for the first coat layer was ionized due to the forward bias application under the conditions of higher temperature and higher humidity, therefore, it was found that the ion barrier effect of the second coat layer has been decreased.

As a result of this embodiment, it was determined that the photovoltaic element of the present invention secures a favorable ion barrier effect within a range of 0.02 ml/g or less porosity of the conductive bonding material.

### (Embodiment 47)

In this embodiment, it was examined what current collector electrodes should be, having a coat layer made of conductive bonding material containing a coupling agent.

As shown in Fig. 2A, current collector electrodes 200 of the invention were formed as described below. As for metal wire 201, was used copper wire having 100 µm diameter cladded with silver on its surface. In this embodiment, double-layered coating as shown in Fig. 2A was applied.

The following describes a method of preparing paste No. 8 for forming conductive bonding material constituting a coat layer 202 for coating the metal wire 201 directly.
(1) As solvent, methyl carbitol was taken into a shaker for dispersion.
(2) Urethane resin (made by Nippon Polyurethane Co, Ltd.) used as a chief agent and Butyral resin (made by Sekisui Chemical Co, Ltd.) for enhancement of dispersion were added to the solvent, and it was stirred enough with a ball mill.
(3) Blocked isocyanate (made by Takeda Chemical Industries, Ltd.) used as a curing agent and γ-mercaptopropyltrimethoxysilane (made by Toray Silicon, Ltd.) used as a silane coupling agent were added to said solvent.
(4) Carbon black (made by Colombian Carbon, Ltd.) having 0.05 µm of an average primary grain diameter was added to said solvent as conductive grains. In this composition, it has 67 wt% of resin and 33 wt% of conductive grains in weight ratio.
(5) Dispersion was made for the shaker containing the above materials for 10 hours by using a paint shaker made by Toyo Seiki Seisakujyo, Ltd..
(6) Glass beads for dispersion were removed from the paste No. 8. As a result of measuring an average grain diameter of the paste No. 8 in a laser diffraction method, approx. 0.8 µm was obtained, which proves favorable dispersion. The same result was obtained when a beads mill was used instead of the paint shaker.
(7) To check characteristics of conductivity of said paste No. 8, it was cured under the standard curing conditions on said curing agent, 160 °C of the temperature and 30 min. of the time and its volume resistivity was measured. As a result of the measurement, 0.5 Ωcm of the volume resistivity was obtained and it was confirmed that the resistivity is sufficiently low.
   The following describes a method of preparing paste No. 9 for forming conductive bonding material constituting the coat layer 203 being in contact with a substrate of the photovoltaic element.
(8) As solvent, cyclohexanone was taken into a shaker.
(9) Were added urethane resin (made by Nippon Polyurethane, Ltd.) used as a chief agent and Phenoxy resin (made by Tomoe Kogyo, Ltd.) for removing the tack effect at rolling the coated wire on a bobbin to the solvent, and it was stirred enough with a ball mill. Then, blocked isocyanate (made by Takeda Chemical Industries, Ltd.) used as a curing agent and γ-mercaptopropyltrimetoxysilane (made by Toray Silicon, Ltd.) used as a silane coupling agent were added to said solvent.
(10) Carbon black (made by Colombian Carbon, Ltd.) having 0.05 µm of an average primary grain diameter was added to said solvent as conductive grains. In this composition, it has 65 wt% of resin and 35 wt% of conductive grains in weight ratio.
(11) The above materials were dispersed in the same manner as for the paste No. 8 to make the paste No. 9. The paste has approx. 1.0 µm of an average grain diameter.
(12) To check characteristics of conductivity of said paste No. 9, it was cured under the standard curing conditions on said curing agent, 160 °C of the temperature and 30 min. of the time and its volume resistivity was measured. As a result of the measurement, 0.4 Ωcm of the volume resistivity was obtained and it was confirmed that the resistivity is sufficiently low.

The following describes a method of forming the coat layer 202 made of the paste No. 8 and the coat layer 203 made of the paste No. 9 by using the wire coater 300 in Fig. 3.

First of all, a bobbin having a metal wire around its delivery reel was set, and said metal wire was extended in the direction of a bobbin for rolling. Then, said paste No. 8 was injected into the coater.

The coating was repeated five times under the conditions of 40 m/min. of the coating speed, 2 sec.. of the detention time, and 350 °C of the temperature in the drying oven. Dices for enamel coating each having 110 µm to 200 µm diameter were used sequentially. Under these conditions, the paste No. 8 was cured enough to have favorable adhesion and solvent resistance. The thickness of the coat layer 202 made of the paste No. 8 is 5 µm at an average and a deflection of the thickness of the coat was within a range of ±0.5 µm as a result of the coating in 100 m length.

Subsequently, the paste No. 9 was applied. The coating was repeated five times under the conditions of 40 m/min. of the wire rolling speed, 2 sec.. of the drying time, and 120 °C of the temperature in a drying oven 306. Dices for enamel coating each having a 150 µm to 200 µm bore diameter were used. Although the paste No. 9 applied to said wire existed in an uncured state with the solvent volatilized, any tack properties were not observed. The thickness of the coat layer 203 made of the paste No. 9 is 20 µm at an average and a deflection of the thickness of the coat was within a range of ±1.0 µm as a result of the coating in 100 m length.

The electrodes made in the above procedures were examined with adhesion tests for two classes of adhesion between the metal wire 201 and the coat layer 202 made of the paste No. 8 and adhesion between a substrate of the photovoltaic element and a substrate of a metal tab and the coat layer 203 made of the paste No. 9.

First of all, to examine the adhesion between the metal wire 201 and the coat layer 202 made of the paste No. 8, the coat layer 202 and the coat layer 203 were set on the metal wire 201 as electrodes 200 to make sample 1 which was cured in a drying oven (not shown) under the conditions of the 160 °C temperature and the 30 min. time. As a result of stretching the electrode 200 rapidly on the basis of an adhesion test of JIS3003 and checking the adhesion with observing broken section, favorable adhesion was confirmed without any abnormal cracks nor peeling.

Next, to check the adhesion between the substrate of the photovoltaic element and the substrate of the metal tab and the coat layer 203 made of the paste No. 9, sample 2 was made by contact-bonding the electrodes 200 with heating on an amorphous solar battery substrate with ITO cladded as a transparent conductive coating and a copper tab substrate with silver cladded on its surface. As a result of stretching the electrodes 200 perpendicularly to each substrate direction on the basis of the adhesion test of JIS3003 and checking the adhesion with measuring its tension, favorable adhesion was confirmed with 0.15 kgfN or greater tension.

In addition, to check reliability of said electrodes 200, said sample 1 and sample 2 were left in an environmental tester whose temperature was 85 °C and relative humidity was 85 % for 1,000 hours (high-temperature and high-humidity test). As a result of the same adhesion test after the high-temperature and high-humidity test, any changes did not occur in their characteristics.

The above description proves that the electrodes according to this invention have uniform width of lines and secures superior adhesive properties. In addition, they endure a hostile environment such as high-temperature and high-humidity for a long time without any cracks nor peeling and it is confirmed that they also secures higher reliability.

### (Comparison 5)

This example differs from Embodiment 47 in that a coupling agent is not mixed at compounding of paste. Others are the same as for Embodiment 47 in forming electrodes.

As a result of checking adhesion of the created electrodes in the same manner as for Embodiment 47, some cracks were partially observed as for adhesion between the metal wire 201 and the coat layer 202 made of the paste No. 8. Adhesion between the substrate of the photovoltaic element and the coat layer 203 made of the paste No. 9 and between the substrate of the metal tab and the coat layer 203 made of the paste No. 9 was relatively low to 0.09 kgfN and 0.03 kgfN, respectively.

Furthermore, an adhesion test was performed after a high-temperature and high-humidity test in the same manner as for Embodiment 47, and cracks and a lot of peeling were observed as for the adhesion between the metal wire 201 and the coat layer 202 made of the paste No. 8. Additionally, the adhesion between the substrate of the photovoltaic element and the coat layer 203 made of the paste No. 9 and between the substrate of the metal tab and the coat layer 203 made of the paste No. 9 was decreased to 0.04 kgfN and almost zero, respectively.

### (Embodiment 48)

This embodiment differs from Embodiment 47 in that a titanate-series coupling agent, isopropyl tri-isostearoyl titanate (made by Ajinomoto Co., Inc.) is used as a coupling agent for compounding of the paste No. 8. Others are the same as for Embodiment 47 in forming electrodes.

As a result of performing adhesion tests in the same manner as for Embodiment 47, favorable adhesion could be obtained without any abnormal cracks nor peeling as for the adhesion between the metal wire 201 and the coat layer 202 made of the paste No. 8. In addition, as for the adhesion between the substrate of the photovoltaic element and the coat layer 203 made of the paste No. 9 and between the substrate of the metal tab and the coat layer 203 made of the paste No. 9, favorable adhesion was confirmed; 0.15 kgfN and 0.14 kgfN, respectively.

Additionally, adhesion tests were performed after a high-temperature and high-humidity test in the same manner as for Embodiment 47, and any changes did not occur in their characteristics.

### (Embodiment 49)

This embodiment differs from Embodiment 47 in that an aluminum-series coupling agent, acetoalkoxy aluminum di-isopropylate (made by Ajinomoto Co., Inc.) is used as a coupling agent for compounding of the paste No. 8. Others are the same as for Embodiment 47 in forming electrodes.

As a result of performing adhesion tests in the same manner as for Embodiment 47, favorable adhesion could be obtained without any abnormal cracks nor peeling as for the adhesion between the metal wire 201 and the coat layer 202 made of the paste No. 8. In addition, as for the adhesion between the substrate of the photovoltaic element and the coat layer 203 made of the paste No. 9 and between the substrate of the metal tab and the coat layer 203 made of the paste No. 9, favorable adhesion was confirmed; 0.15 kgfN and 0.14 kgfN, respectively.

Additionally, adhesion tests were performed after a high-temperature and high-humidity test in the same manner as for Embodiment 47, and any changes did not occur in their characteristics.

### (Embodiment 50)

This embodiment differs from Embodiment 47 in that epoxy resin (made by Yuka Shell Epoxy, Ltd) is used as a chief agent of polymer resin for compounding of the paste No. 8, and a silane agent, γ-glycidoxypropyltrimethoxysilane (made by Toray Silicon, Ltd.) is used as a coupling agent. Others are the same as for Embodiment 47 in forming electrodes.

As a result of performing adhesion tests in the same manner as for Embodiment 47, favorable adhesion could be obtained without any abnormal cracks nor peeling as for the adhesion between the metal wire 201 and the coat layer 202 made of the paste No. 8. In addition, as for the adhesion between the substrate of the photovoltaic element and the coat layer 203 made of the paste No. 9 and between the substrate of the metal tab and the coat layer 203 made of the paste No. 9, favorable adhesion was confirmed; 0.15 kgfN in both.

Additionally, adhesion tests were performed after a high-temperature and high-humidity test in the same manner as for Embodiment 47, and any changes did not occur in their characteristics.

### (Embodiment 51)

This embodiment differs from Embodiment 47 in that phenol resin (made by Dainippon Ink & Chemicals, Inc.) is used as a chief agent of polymer resin for compounding of the paste No. 8, and a silane agent, γ-(2-aminoethyl) aminopropyltrimetoxysilane (made by Toray Silicone, Ltd.) is used as a coupling agent. Others are the same as for Embodiment 47 in forming electrodes.

As a result of performing adhesion tests in the same manner as for Embodiment 47, favorable adhesion could be obtained without any abnormal cracks nor peeling as for the adhesion between the metal wire 201 and the coat layer 202 made of the paste No. 8. In addition, as for the adhesion between the substrate of the photovoltaic element and the coat layer 203 made of the paste No. 9 and between the substrate of the metal tab and the coat layer 203 made of the paste No. 9, favorable adhesion was confirmed; 0.15 kgfN in both.

Additionally, adhesion tests were performed after a high-temperature and high-humidity test in the same manner as for Embodiment 47, and any changes did not occur in their characteristics.

### (Embodiment 52)

This embodiment differs from Embodiment 47 in that polyimide (made by Nippon Polyimide, Ltd.) is used as a chief agent of polymer resin for compounding of the paste No. 8, and a silane agent, γ-anilinopropyltrimethoxysilane (made by Toray Silicone, Ltd.) is used as a coupling agent. Others are the same as for Embodiment 47 in forming electrodes.

As a result of performing adhesion tests in the same manner as for Embodiment 47, favorable adhesion could be obtained without any abnormal cracks nor peeling as for the adhesion between the metal wire 201 and the coat layer 202 made of the paste No. 8. In addition, as for the adhesion between the substrate of the photovoltaic element and the coat layer 203 made of the paste No. 9 and between the substrate of the metal tab and the coat layer 203 made of the paste No. 9, favorable adhesion was confirmed; 0.15 kgfN in both.

Additionally, adhesion tests were performed after a high-temperature and high-humidity test in the same manner as for Embodiment 47, and any changes did not occur in their characteristics.

### (Embodiment 53)

In this embodiment, an amorphous solar battery 400 was fabricated in a pin-junction-typed single structure with grids whose grid length was 30 cm in a layer structure shown in Fig. 4A.

The following describes a method of the fabrication according to the fabrication procedure.
(1) After putting sufficiently degreased and cleaned substrate 401 made by SUS430BA into a DC sputtering device (not shown) and depositing Ag up to 400 nm, a lower electrode 402 was formed by depositing ZnO up to 400 nm.
(2) After taking out the substrate was taken out, it was put into an RF plasma CVD film generator (not shown), then deposition is made for an amorphous silicone semiconductor layer in an order of n layer 403, i-layer 404, and p-layer 405.
(3) It was put into a metallizing apparatus of a resistance heating system (not shown) and an ITO film was generated as a transparent conducting film 406 having also a function of anti-reflection effect (film generation temperature: 450 °C, film thickness: 70 nm).
(4) By using the same paste No. 8 and No. 9 as for Embodiment 47, electrodes 200 having a coat layer made of conductive bonding material was made.
(5) The electrodes 200 were arranged on the substrate 401 having a copper-foiled tab 501 cladded with silver on its surface by using a wiring machine (not shown), with providing an adhesive portion which was 5 mm wide outside an effective area of the solar battery, then they were temporarily fixed with adhesive at their both ends.
(6) By using a heat contact-bonding machine (not shown), they were fixed on the substrate through the paste No. 9 applied to the wire to form a grid electrode 307.
(7) As shown in Fig. 13, an anode drain section 1302 and a cathode drain section 1303 were connected with soldering to generate a single cell 30 cm square.
(8) Encapsulation was made for an amorphous solar battery in which the above electrodes were formed as described below. The amorphous solar battery 1300 was cladded with EVA on its both sides, then further with fluoroplastic film ETFE (ethylene tetrafluoroethylene) (Du Pont product name, "Tefzel"), and it was put into a vacuum laminator for vacuum lamination with increasing the temperature and keeping 150 °C for 45 min.

Generation of the samples of this embodiment was completed in the above (1) to (8) process.

The initial characteristics for the generated samples were measured as described below. By using a simulated sun light source (hereinafter "simulator") having 100 mW/cm² quantity of light in the AM1.5 global sun light spectrum, characteristics of the solar battery were examined with measurement. Characteristics of measured transformation efficiency 6.7 %, shunt resistance (dark state) 50 kΩcm², and series resistance 9.5 Ωcm² were favorable.

A confidence test for these samples was performed on the basis of the temperature and relative humidity cycle test A-2 defined in an environmental test method and an endurance test method of crystal-system solar battery modules of Japan Industrial Standard C8917. First of all, a cycle test was repeated 20 times by putting the samples into a constant temperature and humidity bath whose inside humidity was controllable and changing the temperature from -40 °C to +85 °C (relative humidity: 85 %). Afterwards, when characteristics of the solar battery were examined every after the completion of ten times repetition of the test by using the simulator in the same manner as for the measurement of the initial characteristics, a decrease of 3.2 % was observed in comparison with the initial transformation efficiency and a decrease of 10 % for the shunt resistance (dark state) after the completion of 20 times repetition of the test, therefore, any significant deterioration was not found in both. In addition, the series resistance was measured and an increase of only approx. 2.4 % was observed in the samples of this embodiment as shown in Fig. 14, and a phenomenon such as peeling in the electrode section was not found.

As a result of this embodiment, it has been understood that the solar battery according to the invention has favorable characteristics and secures higher reliability.

### (Comparison 6)

In this example, the electrodes were formed in the same manner as for Embodiment 1 except that a coupling agent was not mixed at compounding of paste. Then, by using these electrodes, an amorphous solar battery was made in the same manner as for Embodiment 53. Additionally, samples were made with performing encapsulation of said amorphous solar battery in the same manner as for Embodiment 53.

As a result of measuring the initial characteristics of the samples in the same manner as for Embodiment 53, the initial transformation efficiency was 5.8 % and the series resistance was 15.5 Ωcm², therefore, the series resistance was higher in comparison with Embodiment 53.

Subsequently, a confidence test was performed for these samples in the same manner as for Embodiment 53. As a result of measuring the transformation efficiency of the samples after completion of a temperature and humidity cycle test, a decrease of 17% was observed in comparison with the initial value after 20 times repetition of the test, which indicated a significant deterioration.

When the series resistance of these samples was measured, a change on standing was observed as shown in Fig. 14 and it increased up to approx. twice as high as the initial state after 20 times repetition of the test. Accordingly, it was found that adhesion between the electrodes was decreased.

### (Embodiment 54)

This embodiment differs from Embodiment 53 in that a solar battery has a structure shown in Fig. 4C as a triple-typed amorphous solar battery 400 and that a microwave CVD method is used for generating a semiconductor layer.

The following describes a method of the generation according to the generation procedure.
(1) A lower electrode 402 comprising Ag and ZnO was formed on an SUS substrate 401.
(2) It was put into a microwave plasma CVD film generator (not shown), and a bottom layer was formed in an order of n layer 403, i-layer 404, and p-layer 405. Then, in the same manner, a semiconductor layer was generated by forming a middle layer in an order of n layer 413, i-layer 414, and p-layer 415 and a top layer in an order of n layer 423, i-layer 424, and p-layer 425 sequentially.
(3) An ITO film was generated as a transparent conducting film 406 having also a function of anti-reflection effect (film generation temperature: 450 °C, film thickness: 70 nm) in the same manner as for Embodiment 53.
(4) By using the same paste No. 8 and No. 9 as for Embodiment 47, electrodes 200 having a coat layer made of conductive bonding material was generated.
(5) The electrodes 200 were arranged on the substrate 401 having a copper-foiled tab 501 cladded with silver on its surface by using a wiring machine (not shown), with providing an adhesive portion which was 5 mm wide outside an effective area of the solar battery, then they were temporarily fixed with adhesive at their both ends.
(6) By using a heat contact-bonding machine (not shown), they were fixed on the substrate through the paste No. 9 applied to the wire to form a grid electrode 307.
(7) As shown in Fig. 13, an anode drain section 1302 and a cathode drain section 1303 were connected with soldering to generate a single cell 30 cm square.
(8) Encapsulation was made for an amorphous solar battery in which the above electrodes were formed in the same manner as for Embodiment 53.

Generation of the samples of this embodiment was completed in the above (1) to (8) process.

The initial characteristics for the generated samples were measured in the same manner as for Embodiment 53. Characteristics of measured initial transformation efficiency 8.3 %, shunt resistance (dark state) 42 kΩcm², and series resistance 33.0 Ωcm² were favorable.

In addition, a confidence test for these samples was performed in the same manner as for Embodiment 53. As a result, an increase of 2.7 % was observed as for the series resistance in comparison with the initial value after 20 times repetition of the test and a decrease of only 1.8 % as for the transformation efficiency in comparison with the initial value, therefore, any significant deterioration was not found in both.

As a result of this embodiment, it has been understood that the solar battery according to the invention has favorable characteristics and secures higher reliability.

### (Embodiment 55)

In this embodiment, to check a long-term preservation stability of electrodes, the electrodes in Embodiment 47 were rolled in a bobbin-like configuration and they had been kept in an environment at a room temperature for 100 days. Afterwards, adhesion of the electrodes 200 was checked in the same manner as for Embodiment 47, and favorable adhesive characteristics were confirmed like Embodiment 47.

### [Advantage of the Invention]

As described in detail above, according to the invention, reliable current collector electrodes having excellent adhesion and long-term preservation characteristics are obtained.

In addition, by using the current collector electrodes, photovoltaic elements having higher initial characteristics and superior long-term reliability are obtained.

Furthermore, since an yield on production is improved, a method of generating photovoltaic elements having favorable reliability characteristics is obtained.

A photovoltaic element having a high release voltage is provided by inhibiting the injection of carrier to p-type semiconductor located at the upmost surface of the generation layer from the upper electrode.

The photovoltaic element according to the present invention, in which an n-type semiconductor which is supposed to be represented by "n", an i-type semiconductor which is supposed to be represented by "i", and p-type semiconductor which is supposed to be represented by "p", are laminated in this order on to a substrate to form a structure comprising a nip junction, and a generation layer containing at least one of the structure is provided; that the upper electrode is placed on the p-layer located at the upmost surface of the generation layer to form the photovoltaic element, is characteristic in that the p-layer positioned at the upmost surface of the generation layer is composed of a first p-layer containing crystal that is connected with the i-layer and a second p-layer comprising amorphous that is connected with the upper electrode.

## Claims

1. A coated wire for a collector electrode, comprising a metal wire with a coating layer comprising a conductive adhesive, the coated wire being bonded via the coating layer to a photovoltaic element, wherein the coating layer is formed of at least two layers, said coating layer preventing metal ions of said metal wire from migrating to a surface of the coated wire.

2. The coated wire according to claim 1, wherein the conductive adhesive comprises conductive particles and a polymer resin.

3. The coated wire according to claim 2 or 3, wherein the conductive adhesive comprises a coupling agent, conductive particles and a polymer resin.

4. The coated wire according to claim 3, wherein the coupling agent is at least one selected from the group consisting of silane derivative coupling agent, titanate derivative coupling agents and aluminum derivative coupling agents.

5. The coated wire according to claim 2, wherein the conductive adhesive constituting an inner coating layer other than an outermost coating layer comprises a polymer resin having a number average molecular weight of 500 to 50,000.

6. The coated wire according to claim 2, wherein the conductive adhesive constituting at least an inner coating layer other than an outermost coating layer comprises a polymer resin having a gel fraction of 20 to 100%.

7. The coated wire according to claim 2, wherein the conductive adhesive constituting at least an outermost coating layer comprises a thermosetting polymer resin not hardened.

8. The coated wire according to claim 2, wherein the polymer resin is at least one selected from the group consisting of urethane, phenoxy, epoxy, butyral, phenol, polyimide, polyamide and polyamideimide.

9. A photovoltaic element comprising: a semiconductor layer having at least one pin junction or pn junction, and a collector electrode provided at a light incident side of the semiconductor layer, wherein the collector electrode is formed of a coated wire for a collector electrode according to any one of claims 2 to 8.

10. The photovoltaic element according to claim 9, further comprising a transparent electrode at a light incident side of the semiconductor layer, and the coated wire for the collector electrode is provided as the collector electrode on the transparent electrode.

11. The photovoltaic element according to claim 9, wherein the coated wire for a collector electrode is provided as the collector electrode so that the conductive adhesive of the coated wire for a collector electrode according to any one of claims 27 to 33 contacts the transparent electrode on the semiconductor layer of the photovoltaic element.

12. A method for producing a photovoltaic element provided with a collector electrode at a light incident side, which comprises bonding a coated wire for a collector electrode according to any one of claims 2 to 8 to a light incident surface of the photovoltaic element by heating or pressure or both of heating and pressure.

13. The method according to claim 12, wherein a temperature of the heating applied to the coated wire for the collector electrode is not lower than the dissociation temperature of a block isocyanate contained in said conductive adhesive of said coated wire.

14. The method according to claim 12 or 13, wherein the coated wire comprising a thermosetting polymer resin not hardened is heated so that a gel fraction of said thermosetting polymer resin for constituting the coating layer becomes 20 to 100%.

15. The method according to claim 12, wherein the coated wire for the collector electrode is bonded at a softening temperature of at least the outermost coating layer among coating layers.
